(19) Europäisches Patentamt
European Patent Office
Office européen des brevets

(11) EP 2 366 751 A2

(12) EUROPEAN PATENT APPLICATION

(43) Date of publication:
21.09.2011 Bulletin 2011/38

(51) Int Cl.:
*C09J 179/08* (2006.01) *G03F 7/038* (2006.01)
*H01L 21/58* (2006.01)

(21) Application number: **11165788.8**

(22) Date of filing: **30.07.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **27.08.2008 JP 2008218048**
**10.04.2009 JP 2009095695**
**23.04.2009 JP 2009105509**
**19.03.2009 JP 2009068049**

(62) Document number(s) of the earlier application(s) in accordance with Art. 76 EPC:
**09809741.3 / 2 319 893**

(71) Applicant: **Hitachi Chemical Co., Ltd.**
**Tokyo 163-0449 (JP)**

(72) Inventors:
- **Mitsukura, Kazuyuki**
  **Ibaraki 300-4247 (JP)**
- **Kawamori, Takashi**
  **Ibaraki 300-4247 (JP)**
- **Masuko, Takashi**
  **Ibaraki 300-4247 (JP)**
- **Katogi, Shigeki**
  **Ibaraki 300-4247 (JP)**

(74) Representative: **von Kreisler Selting Werner**
**Deichmannhaus am Dom**
**Bahnhofsvorplatz 1**
**50667 Köln (DE)**

Remarks:
This application was filed on 12-05-2011 as a divisional application to the application mentioned under INID code 62.

(54) **Photosensitive adhesive composition, and film adhesive, adhesive sheet, adhesive pattern, semiconductor wafer with adhesive layer and semiconductor device using the photosensitive adhesive composition**

(57) There is provided a photosensitive adhesive composition having a lowest melt viscosity at 20°C to 200°C after pattern formation of 30,000 Pa·s or lower.

EP 2 366 751 A2

## Description

Technical Field

The present invention relates to a photosensitive adhesive composition, and a film adhesive, an adhesive sheet, an adhesive pattern, a semiconductor wafer with an adhesive layer and a semiconductor device using the photosensitive adhesive composition.

Background Art

For adhesives used for fabrication of semiconductor packages, a photosensitive function is demanded in addition to adhesivity. As photosensitive adhesive compositions having a photosensitive function, those having a polyimide resin precursor (polyamic acid) as a base are conventionally known (Patent Literatures 1 to 3).

Citation List

Patent Literature

Patent Literature 1: Japanese Patent Application Laid-Open Publication No. 2000-290501
Patent Literature 2: Japanese Patent Application Laid-Open Publication No. 2001-329233
Patent Literature 3: Japanese Patent Application Laid-Open Publication No. 11-24257

Summary of Invention

Technical Problem

However, conventional photosensitive adhesive compositions are not always sufficient in terms of connection reliability. Studies by the present inventors have revealed that in conventional photosensitive adhesive compositions, if pattern formability is given priority, a sufficient adhesive area cannot be obtained in thermocompression bonding after the pattern formation.
Then, the present invention has an object to provide photosensitive adhesive compositions having thermocompression bondability capable of improving connection reliability, and film adhesives, adhesive sheets, adhesive patterns, semiconductor wafers with an adhesive layer and semiconductor devices using the photosensitive adhesive compositions.

Solution to Problem

As a result of exhaustive studies to solve the above-mentioned problems, the present inventors have found that use of a lowest melt viscosity in a specific temperature range after pattern formation as an index when a photosensitive adhesive composition is designed can provide the photosensitive adhesive composition excellent in thermocompression bondability at low temperatures and allowing good connection of semiconductor wafers and the like, and this finding has led to the completion of the present invention.
That is, a first photosensitive adhesive composition of the present invention has a lowest melt viscosity at 20°C to 200°C after pattern formation of 30,000 Pea or lower. The first photosensitive adhesive composition, by having the specific lowest melt viscosity, exhibits an excellent thermocompression bondability at low temperatures (hereinafter, also referred to as "low-temperature thermocompression bondability") after pattern formation to be thereby capable of improving connection reliability of semiconductor packages. Further thereby, the low-temperature thermocompression bondability and other preferable characteristics both are easily satisfied simultaneously.
The first photosensitive adhesive composition preferably comprises (A) an alkali-soluble resin, (B) a thermosetting resin, (C) a radiation-polymerizable compound, and (D) a photoinitiator. Thereby, the photosensitive adhesive composition is made excellent in any terms of not only the low-temperature thermocompression bondability but the pastability at low temperatures (hereinafter, referred to as "low-temperature pastability") in the case of being formed into a form of film, the adhesivity under heating (hereinafter, referred to as "high-temperature adhesivity") in the case of being made a cured product, and the precision of a pattern (hereinafter, referred to as "pattern formability") in the case where an adhesive pattern is formed by exposure and alkali development.
In the first photosensitive adhesive composition, the average functional group equivalent weight of (C) the

radiation-polymerizable compound is preferably 230 g/eq or more. Thereby, while the pattern formability is maintained, the crosslinking density in photosetting can be reduced, and warpage of an adherend after curing can be made small (hereinafter, referred to as "low-warpage property" or "low-stress property". In the present description, "the average functional group equivalent weight" means an average value (g/eq) of radiation-polymerizable group equivalent weights of all of (C) components (radiation-polymerizable compounds) which a photosensitive adhesive composition contains. For example, in the case where a photosensitive adhesive composition contains y (g) of a (C) component having a radiation-polymerizable group equivalent weight of Y (g/eq) and z (g) of a (C) component having a radiation-polymerizable group equivalent weight of Z (g/eq), "the average functional group equivalent weight" is determined by the following expression.

Expression

$$\text{Average functional group equivalent weight (g/eq)} = (Y \times y + Z \times z)/(y + z)$$

In the first photosensitive resin composition, (C) a radiation-polymerizable compound preferably contains a (meth)acrylate having a urethane bond and/or an isocyanuric ring. Thereby, the pattern formability and the high-temperature adhesivity can be improved.

In the first photosensitive resin composition, (C) a radiation-polymerizable compound preferably contains a monofunctional (meth)acrylate. Thereby, while the pattern formability is maintained, the crosslinking density in photosetting can be reduced, and the low-temperature thermocompression bondability, the low stress property and the adhesivity after photosetting can be improved.

The 5%-weight loss temperature of the monofunctional (meth)acrylate is preferably 150°C or higher. Thereby, the amount of outgas in thermosetting and in the thermal history after curing can be reduced, and the heat resistance reliability can be improved. In the present description, "the 5%-mass loss temperature" indicates a temperature at a time when the mass decreases by 5% when the mass loss is measured using a Thermo Gravimetry/Differential Thermal Analyzer (TG/DTA6300, made by SII Nano Technology Inc.) at a temperature-rise rate of 10°C/min in a nitrogen flow (400 ml/min).

The monofunctional (meth)acrylate is preferably a monofunctional (meth)acrylate having an epoxy group. Thereby, the high-temperature adhesivity and the heat resistance reliability can be more improved.

A second photosensitive adhesive composition according to the present invention comprises (A) an alkali-soluble resin, (B) a thermosetting resin, (C) a radiation-polymerizable compound, and (D) a photoinitiator, and the average functional group equivalent weight of (C) the radiation-polymerizable compound is 230 g/eq or more.

In conventional photosensitive adhesive compositions, the low-temperature thermocompression bondability and the high-temperature adhesivity are not sufficient, and it is difficult to simultaneously satisfy both the low-temperature pastability and the pattern formability. Further, the thermal stress is liable to occur, and an improvement also in the low stress property has been desired.

By contrast, the second photosensitive adhesive composition, by containing the above-mentioned components, makes the composition excellent in all terms of the low-temperature thermocompression bondability, the low-temperature pastability, the high-temperature adhesivity and the pattern formability. Making the average functional group equivalent weight of the (C) component in the range described above can make the composition excellent also in the low stress property.

In the second photosensitive resin composition, (C) a radiation-polymerizable compound preferably contains a (meth)acrylate having a urethane bond and/or an isocyanuric ring. Thereby, the pattern formability and the high-temperature adhesivity are more improved.

A third photosensitive adhesive composition according to the present invention comprises (A) a thermoplastic resin, (B) a thermosetting resin, (C) a radiation-polymerizable compound, and (D) a photoinitiator, and (C) the radiation-polymerizable compound contains a compound having an ethylenically unsaturated group and an epoxy group.

In conventional photosensitive adhesive compositions, the low-temperature thermocompression bondability and the high-temperature adhesivity are not sufficient, and it is difficult to simultaneously satisfy both the low-temperature pastability and the pattern formability.

By contrast, the third photosensitive adhesive composition, by containing the above-mentioned components, makes the composition excellent in all terms of the low-temperature thermocompression bondability, the low-temperature pastability, the high-temperature adhesivity and the pattern formability. The third photosensitive adhesive composition, by making the (C) component contain a compound having an ethylenically unsaturated group and an epoxy group, makes the composition excellent in the low-temperature thermocompression bondability and the high-temperature adhesivity while maintaining the pattern formability.

That the photosensitive adhesive compositions according to the present invention have these characteristics

is conceivably, for example, for the following reasons. If a compound having an ethylenically unsaturated group and an epoxy group is incorporated to a network of radiation-polymerizable compounds after light irradiation, the apparent crosslinking density is reduced and the thermocompression bondability is improved. Further if the epoxy group is reacted with a thermosetting group or a curing agent, particularly with a carboxyl group or a phenolic hydroxyl group on a polymer side chain, entanglement between molecular chains becomes much, so a tougher network is formed than in a system in which a radiation-polymerizable compound and a thermosetting resin only are formulated and each crosslinking reaction independently proceeds. Consequently, the photosensitive adhesive compositions according to the present invention make the compositions sufficiently excellent in all of above-mentioned characteristics.

In the third photosensitive adhesive composition, (A) the thermoplastic resin is preferably an alkali-soluble resin. Thereby, the pattern formability is improved.

In the third photosensitive adhesive composition, the 5%-weight loss temperatures of the ethylenically unsaturated group and the epoxy group are preferably 150°C or higher. Thereby, the amount of outgas in thermosetting and in the thermal history after curing can be reduced, and the heat resistance reliability can be improved.

In the third photosensitive adhesive composition, the compound having an ethylenically unsaturated group and an epoxy group is preferably a monofunctional (meth)acrylate having an epoxy group. Thereby, the crosslinking density in photosetting can be reduced, and the low-temperature thermocompression bondability can be more improved.

In the first to third photosensitive adhesive compositions according to the present invention, (B) the thermosetting resin preferably contains an epoxy resin. Thereby, the high-temperature adhesivity and the heat resistance reliability are improved.

Tg (glass transition temperature) of (A) the alkali-soluble resin is preferably 150°C or lower. Thereby, the low-temperature pastability, the low-temperature thermocompression bondability, the pattern formability and the low stress property are improved.

(A) The alkali-soluble resin is preferably a thermoplastic resin having a carboxyl group and/or a hydroxyl group from the viewpoint of the pattern formability.

(A) The alkali-soluble resin is preferably a polyimide resin. Thereby, the film formability, the pattern formability, the heat resistance and the adhesivity are improved.

The first and third photosensitive adhesive compositions according to the present invention preferably further comprise (E) a thermal radical generating agent. Thereby, since a heat treatment after adhering can decrease an unreacted radiation-polymerizable compound, generation of outgas from packages in assembling heating and after assembling can be made sufficiently low, and additionally, cured products can be made uniformly of a high elasticity. Thereby, cured products can be obtained which have a high heat resistance, a low moisture permeability and a low moisture absorptivity, and the high-temperature adhesivity and the moisture resistance reliability are improved. The compositions, since the reaction hardly proceeds by coating drying in the pattern formation or in the formation into a film form, make sufficient the low-temperature thermocompression bondability after the pattern formation and the low-temperature pastability in the formation into a film form.

(E) The thermal radical generating agent is preferably an organic peroxide. Use of an organic peroxide having a high half-life temperature, a high radical production efficiency and a high solubility to a solvent, as a thermal radical generating agent, can further decrease an unreacted radiation-polymerizable compound in the photosensitive adhesive composition. Since the organic peroxide dissolves homogeneously, a good pattern can be obtained after development.

The present invention further provides film adhesives, adhesive sheets, adhesive patterns, semiconductor wafers with an adhesive layer or semiconductor devices using the first to third photosensitive adhesive compositions described above.

The film adhesive according to the present invention is obtained by forming the photosensitive adhesive composition described above into a film form. The adhesive sheet according to the present invention has a base material, and an adhesive layer composed of the film adhesive formed on the base material.

The adhesive pattern according to the present invention is obtained by exposing an adhesive layer laminated on an adherend and composed of the film adhesive through a photomask and subjecting the adhesive layer after the exposure to a development treatment with an alkali developing solution. The adhesive pattern according to the present invention may be one obtained by subjecting an adhesive layer laminated on an adherend and composed of the film adhesive directly to a pattern drawing exposure using a direct drawing exposure technology, and subjecting the adhesive layer after the exposure to a development treatment with an alkali aqueous solution. Since the pattern formability of the photosensitive adhesive composition is good, the adhesive pattern according to the present invention becomes highly fine. The adhesive pattern according to the present invention is also excellent in the low-temperature thermocompression bondability and the low stress property.

The semiconductor wafer with an adhesive layer according to the present invention has a semiconductor wafer, and an adhesive layer laminated on the semiconductor wafer and composed of the film adhesive.

The semiconductor device according to the present invention has a structure in which semiconductor elements and/or a semiconductor element and a support member for mounting a semiconductor element are adhered using the

photosensitive adhesive composition. The support member for mounting a semiconductor element may be a transparent substrate. The semiconductor device according to the present invention is excellent in reliability and can sufficiently meet simplification of a production process by using the photosensitive adhesive composition according to the present invention.

Advantageous Effects of Invention

The present invention can provide photosensitive adhesive compositions having thermocompression bondability capable of improving connection reliability, and film adhesives, adhesive sheets, adhesive patterns, semiconductor wafers with an adhesive layer and semiconductor devices using the photosensitive adhesive compositions.

Brief Description of Drawings

Figure 1 is an end view showing one embodiment of the film adhesive according to the present invention.
Figure 2 is an end view showing one embodiment of the adhesive sheet according to the present invention.
Figure 3 is an end view showing one embodiment of the adhesive sheet according to the present invention.
Figure 4 is an end view showing one embodiment of the adhesive sheet according to the present invention.
Figure 5 is a top view showing one embodiment of the semiconductor wafer with an adhesive layer according to the present invention.
Figure 6 is an end view taken along the line IV-IV of Figure 5.
Figure 7 is a top view showing one embodiment of the adhesive pattern according to the present invention.
Figure 8 is an end view taken along the line V-V of Figure 7.
Figure 9 is a top view showing one embodiment of the adhesive pattern according to the present invention.
Figure 10 is an end view taken along the line VI-VI of Figure 9.
Figure 11 is an end view showing one embodiment of the semiconductor device according to the present invention.
Figure 12 is an end view showing one embodiment of the semiconductor device according to the present invention.
Figure 13 is an end view showing one embodiment of a manufacturing method of the semiconductor device according to the present invention.
Figure 14 is an end view showing one embodiment of the manufacturing method of the semiconductor device according to the present invention.
Figure 15 is a plan view showing one embodiment of the manufacturing method of the semiconductor device according to the present invention.
Figure 16 is an end view showing one embodiment of the manufacturing method of the semiconductor device according to the present invention.
Figure 17 is an end view showing one embodiment of the manufacturing method of the semiconductor device according to the present invention.
Figure 18 is an end view showing one embodiment of the manufacturing method of the semiconductor device according to the present invention.
Figure 19 is an end view showing one embodiment of a manufacturing method of the semiconductor device according to the present invention.
Figure 20 is an end view showing one embodiment of the semiconductor device according to the present invention.
Figure 21 is an end view showing one embodiment of a manufacturing method of the semiconductor device according to the present invention.
Figure 22 is an end view showing one embodiment of the manufacturing method of the semiconductor device according to the present invention.
Figure 23 is an end view showing one embodiment of the manufacturing method of the semiconductor device according to the present invention.
Figure 24 is an end view showing one embodiment of the manufacturing method of the semiconductor device according to the present invention.
Figure 25 is an end view showing one embodiment of the manufacturing method of the semiconductor device according to the present invention.
Figure 26 is an end view showing one embodiment of the semiconductor device according to the present invention.
Figure 27 is an end view showing one embodiment of a manufacturing method of the semiconductor device according to the present invention.
Figure 28 is an end view showing one embodiment of the manufacturing method of the semiconductor device according to the present invention.

Figure 29 is an end view showing one embodiment of the manufacturing method of the semiconductor device according to the present invention.

Figure 30 is an end view showing one embodiment of the manufacturing method of the semiconductor device according to the present invention.

Figure 31 is a plan view showing one embodiment of the manufacturing method of the semiconductor device according to the present invention.

Figure 32 is an end view showing one embodiment of the manufacturing method of the semiconductor device according to the present invention.

Figure 33 is a plan view showing one embodiment of the manufacturing method of the semiconductor device according to the present invention.

Figure 34 is an end view showing an example of a CMOS sensor using the semiconductor device shown in Figure 26 as a solid-state image pick-up element.

Description of Embodiments

Hereinafter, embodiments according to the present invention will be described in detail with reference to drawings as required. However, the present invention is not limited to the following embodiments. In drawings, the same symbol is given to the same constituent, and duplicate description is omitted. The positional relation such as right and left and up and down is based on the positional relation indicated in the drawings unless otherwise specified, and the size ratio of the drawings is not limited to ratios indicated in the drawings. "(Meth)acrylic acid" referred to as in the present description means "acrylic acid" and "methacrylic acid" corresponding to acrylic acid; and "(meth)acrylate" means "acrylate" and "methacrylate" corresponding to the acrylate.

A photosensitive adhesive composition (hereinafter, referred to as "the first photosensitive adhesive composition") according to a first embodiment of the present invention is a photosensitive adhesive composition having a lowest melt viscosity at 20°C to 200°C after pattern formation of 30,000 Pa·s or lower.

In the present description, "the lowest melt viscosity" indicates a lowest value of the melt viscosity at 20°C to 200°C for which a sample irradiated with a light amount of 1,000 mJ/cm$^2$ is measured using a viscoelasticity measuring instrument ARES (made by Rheometrics Scientific F.E. Ltd.). The measuring plates are parallel plates of 8 mm in diameter; and the measuring conditions are set as follows: the temperature rise is 5°C/min; the measuring temperature is -50°C to 300°C; and the frequency is 1 Hz.

The lowest melt viscosity is preferably 20,000 Pa·s or lower, and more preferably 18,000 Pa·s or lower, and especially preferably 15,000 Pa·s or lower. The first photosensitive adhesive composition, by having a lowest melt viscosity in the range described above, can secure a sufficient low-temperature thermocompression bondability while controlling pattern deformation, and can impart a good close adhesivity to a substrate having irregularities and the like. The lower limit of the lowest melt viscosity is not especially set, but is desirably 100 Pa·s or higher in terms of handleability and the like.

The first photosensitive adhesive composition preferably comprises (A) an alkali-soluble resin, (B) a thermosetting resin, (C) a radiation-polymerizable compound, and (D) a photoinitiator. Thereby, the photosensitive adhesive composition makes the composition excellent in terms of not only the low-temperature thermocompression bondability but the low-temperature pastability, the high-temperature adhesivity, and the pattern formability.

In the first photosensitive adhesive composition, the average functional group equivalent weight of (C) the radiation-polymerizable compound is preferably 230 g/eq or more, more preferably 245 g/eq or more, and still more preferably 270 g/eq or more. Selection of a radiation-polymerizable compound having such a high functional group equivalent weight, and setting the average functional group equivalent weight of the (C) component in the range described above can make the stress lower and the warpage lower and can improve the low-temperature thermocompression bondability, and can make the lowest melt viscosity after the pattern formation 30,000 Pa·s or lower. The upper limit of the average functional group equivalent weight is not especially set, but the average functional group equivalent weight is preferably 1,000 g/eq or less from the viewpoint of the heat resistance reliability, the adhesivity and the moisture resistance reliability after development.

(C) The radiation-polymerizable compound contained in the first photosensitive adhesive composition includes compounds having an unsaturated hydrocarbon group; and the unsaturated hydrocarbon group includes a vinyl group, an allyl group, a propargyl group, a butenyl group, an ethynyl group, a phenylethynyl group, a maleimide group, a nadiimido group and a (meth)acrylic group, and is preferably a (meth)acrylic group from the viewpoint of the reactivity. (Meth)acrylates having a (meth)acrylic group are not limited, but include diethylene glycol diacrylate, triethylene glycol diacrylate, tetraethylene glycol diacrylate, diethylene glycol dimethacrylate, triethylene glycol dimethacrylate, tetraethylene glycol dimethacrylate, trimethylolpropane diacrylate, trimethylolpropane triacrylate, trimethylolpropane dimethacrylate, trimethylolpropane trimethacrylate, 1,4-butanediol diacrylate, 1,6-hexanediol diacrylate, 1,4-butanediol dimethacrylate, 1,6-hexanediol dimethacrylate, pentaerythritol triacrylate, pentaerythritol tetraacrylate, pentaerythritol trimethacrylate, pentaerythritol tetramethacrylate, dipentaerythritol hexaacrylate, dipentaerythritol hexamethacrylate, styrene, divinylbenzene, 4-vinyltoluene, 4-vinylpyridine, N-vinylpyrrolidone, 2-hydroxyethyl acrylate, 2-hydroxyethyl methacrylate, 1,3-acryloyloxy-2-hydroxypropane, 1,2-methacryloyloxy-2-hydroxypropane, methylenebisacrylamide, N,N-dimethylacrylamide, N-methylolacrylamide, triacrylate of tris(β-hydroxyethyl)isocyanurate, compounds represented by the formula (18) shown below, urethane acrylate, urethane methacrylate, urea acrylate and multiple branching acrylates such as hyperbranch acrylates. Resins are further included which are obtained by modifying side chains and/or terminals of polyimide resins, polyamide polyurethane resins, polyamideimide resins, polyetherimide resins, polyurethane resins, polyurethaneimide resins, phenoxy resins, phenol resins and the like, with unsaturated hydrocarbon groups.

[Chemical Formula 1]

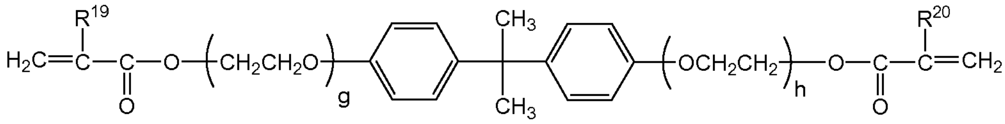

(18)

In the above formula (18), $R^{19}$ and $R^{20}$ each independently denote a hydrogen atom or a methyl group; and g and h each independently denote an integer of 1 to 20.

Additionally, radiation-polymerizable copolymers having an ethylenically unsaturated group on their side chains and the like can be used which are obtained by addition reacting a vinyl copolymer containing a functional group with a compound having at least one ethylenically unsaturated group, and a functional group such as an oxirane ring, an isocyanate group, a hydroxyl group or a carboxyl group. These radiation-polymerizable compounds may be used singly or in combination of two or more thereof.

Above all, a radiation-polymerizable compound represented by the formula (18) and having an ether skeleton is preferable in that it can sufficiently impart the alkali solubility, and the solvent resistance after curing, and a (meth)acrylate having a urethane bond, and a di(meth)acrylate and tri(meth)acrylate having an isocyanuric ring are preferable in that these can sufficiently impart the high-temperature adhesivity after curing.

Particularly, in the first photosensitive adhesive composition, the (C) component preferably contains a (meth)acrylate having a urethane bond and/or an isocyanuric ring from the viewpoint of the pattern formability and the high-temperature adhesivity.

In the first photosensitive adhesive composition, the (C) component preferably contains a monofunctional (meth)acrylate. Thereby, the crosslinking density in photosetting can be reduced, and the low-temperature thermocompression bondability, the low stress property and the adhesivity after photosetting can be improved.

The 5%-weight loss temperature of the monofunctional (meth)acrylate is preferably 150°C or higher. Such a monofunctional (meth)acrylate is not especially limited, but includes compounds having a 5%-weight loss temperature of 150°C or higher among glycidyl group-containing (meth)acrylates, phenol EO-modified (meth)acrylates, phenol PO-modified (meth)acrylates, nonylphenol EO-modified (meth)acrylate, nonylphenol PO-modified (meth)acrylates, phenolic hydroxyl group-containing (meth)acrylates, hydroxyl group-containing (meth)acrylates, imido group-containing (meth)acrylates, carboxyl group-containing (meth)acrylates, 2-phenylphenoxyethyl (meth)acrylate, isoboronyl-containing (meth)acrylates, phenylphenol glycidyl ether (meth)acrylate, dicyclopentadienyl group-containing (meth)acrylates and the like.

The 5%-weight loss temperature is preferably 150°C or higher, more preferably 180°C or higher, still more preferably 200°C or higher, and most preferably 260°C or higher.

The monofunctional (meth)acrylate is preferably a monofunctional (meth)acrylate having an epoxy group from the viewpoint of the adhesivity, the low outgas property, and the heat resistance and moisture resistance reliability. The monofunctional (meth)acrylate having an epoxy group is not especially limited, but includes glycidyl methacrylate, glycidyl acrylate, 4-hydroxybutyl acrylate glycidyl ether, 4-hydroxybutyl methacrylate glycidyl ether, and additionally compounds obtained by reacting a polyfunctional epoxy resin with a monofunctional (meth)acrylate having a functional group reactive with an epoxy group. The functional group reactive with an epoxy group is not especially limited, but includes an isocyanate group, a carboxyl group, a phenolic hydroxyl group, a hydroxyl group, an acid anhydride, amine, thiol and an amide group. Resins are further included which are obtained by modifying side chains and/or terminals of polyimide resins, polyamide polyurethane resins, polyamideimide resins, polyetherimide resins, polyurethane resins, polyurethaneimide resins, phenoxy resins, phenol resins and the like, with (meth)acrylate groups. These compounds may be used singly or in combination of two or more thereof.

A monofunctional (meth)acrylate having an epoxy group can be obtained, for example, by reacting a polyfunctional epoxy resin having at least two or more epoxy groups in one molecule thereof with 0.1 to 0.9 equivalent weight

of (meth)acrylic acid with respect to one equivalent weight of the epoxy group in the presence of triphenylphosphine or tetrabutylammonium bromide. A glycidyl group-containing urethane (meth)acrylate and the like can be obtained by reacting a polyfunctional isocyanate compound with a hydroxy group-containing (meth)acrylate and a hydroxy group-containing epoxy compound, or by reacting a polyfunctional epoxy resin with an isocyanate group-containing (meth) acrylate, in the presence of dibutyltin dilaurate.

In the monofunctional (meth)acrylate having an epoxy group, the 5%-weight loss temperature is preferably 150°C or higher in that the volatilization, and the segregation to the surface by heat drying in film formation can be suppressed, from the viewpoint of the preservation stability, the adhesivity, the low outgas property of packages in assembling heating and after assembling, and the heat and moisture resistance, and is more preferably 180°C or higher, and still more preferably 200°C or higher, in that voids, exfoliation, and a decrease in adhesivity due to outgas in thermosetting can be suppressed. The 5%-weight loss temperature is most preferably 260°C or higher in that voids and exfoliation due to volatilization of unreacted components in reflow can be suppressed. Such a monofunctional (meth) acrylate having an epoxy group is preferably a compound having an aromatic ring in its molecule.

Further, as the monofunctional (meth)acrylate having an epoxy group, use of a high-purity product thereof is preferable in which alkaline metal ions, alkaline earth metal ions and halogen ions as impurity ions, particularly chlorine ions, hydrolyzable chlorine and the like, are decreased to 1,000 ppm or less, from the viewpoint of the prevention of electromigration and the prevention of corrosion of metal conductor circuits. In order to obtain such a monofunctional (meth)acrylate having an epoxy group, for example, use of a polyfunctional epoxy resin in which alkaline metal ions, alkaline earth metal ions, halogen ions and the like are decreased, as a raw material, can satisfy the impurity ion concentration described above. The whole chlorine content can be measured according to JIS K7243-3.

The monofunctional (meth)acrylate having an epoxy group, which meets the heat resistance and the purity described above, is not especially limited, but includes monofunctional (meth)acrylates having an epoxy group using, as a raw material, glycidyl ethers of a bisphenol A type (or AD type, S type, F type), glycidyl ethers of a hydrogenated bisphenol A type, glycidyl ethers of an ethylene oxide adduct bisphenol A and/or F type, glycidyl ethers of a propylene oxide adduct bisphenol A and/or F type, glycidyl ethers of phenol novolac resins, glycidyl ethers of cresol novolac resins, glycidyl ethers of bisphenol A novolac resins, glycidyl ethers of naphthalene resins, trifunctional (or tetrafunctional) glycidyl ethers, glycidyl ethers of dicyclopentadiene phenol resins, glycidyl esters of dimer acids, trifunctional (or tetrafunctional) glycidyl amines, glycidyl amines of naphthalene resins, or the like. Such a monofunctional (meth)acrylate having an epoxy group is not especially limited, but compounds represented by the following formulae (13) to (17) are preferably used. In the following formulae, $R^{12}$ and $R^{16}$ denote a hydrogen atom or a methyl group; $R^{10}$, $R^{11}$, $R^{13}$ and $R^{14}$ denote a divalent organic group; and $R^{15}$ to $R^{18}$ denote an organic group having an epoxy group or an ethylenically unsaturated group.

[Chemical Formula 2]

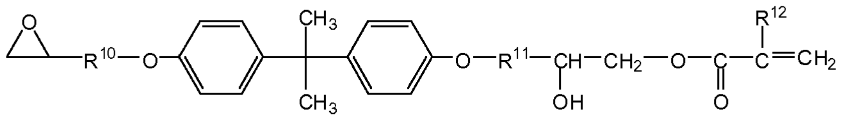

(13)

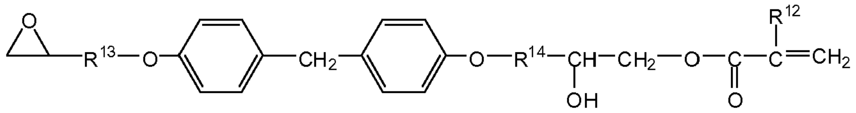

(14)

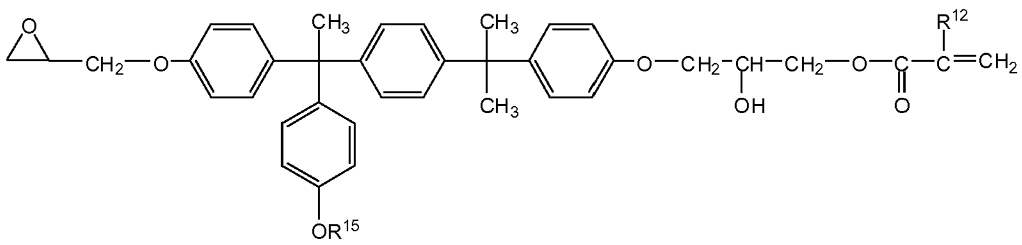

(15)

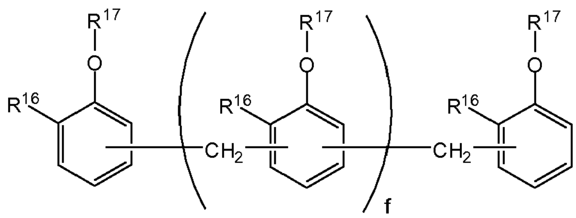

(16)

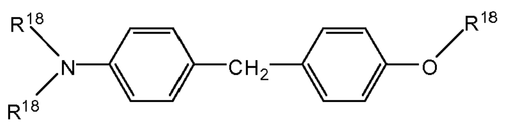

(17)

The content of the (C) component is preferably 20 to 300 parts by mass, and more preferably 30 to 250 parts by mass, with respect to 100 parts by mass of the (A) component. If the content exceeds 300 parts by mass, the fluidity in heat melting is likely to decrease due to polymerization, and the adhesivity in thermocompression bonding is likely to decrease. By contrast, if the content is less than 20 parts by mass, the solvent resistance after photosetting by exposure decreases, and the pattern formation becomes difficult; that is, the change in film thickness before and after development is likely to increase and/or much of residues are likely to be left. Further, patterns are likely to deform due to melting in thermocompression bonding.

The content of the monofunctional (meth)acrylate having an epoxy group is not especially limited as long as the lowest melt viscosity after the pattern formation is 30,000 Pa·s or lower, but is preferably 1 to 100 parts by mass, more preferably 2 to 70 parts by mass, and still more preferably 5 to 40 parts by mass, with respect to 100 parts by mass of the (A) component. If the content exceeds 100 parts by mass, the thixotropy decreases in film formation and films are likely to be hardly formed; and the tackiness increases and the handleability is likely to become insufficient. Further, since the developability decreases in pattern formation and the melt viscosity after photosetting becomes too low, patterns are likely to deform in thermocompression bonding. By contrast, if the content is less than 1 part by mass, the sufficient effect of the addition is unlikely to be seen.

A photosensitive adhesive composition (hereinafter, referred to as "the second photosensitive adhesive composition") according to a second embodiment of the present invention is a photosensitive adhesive composition comprising (A) an alkali-soluble resin, (B) a thermosetting resin, (C) a radiation-polymerizable compound, and (D) a photoinitiator, and the average functional group equivalent weight of (C) the radiation-polymerizable compound is 230 g/eq or more.

The second photosensitive adhesive composition, by containing the above-mentioned components, makes the

composition excellent in all terms of the low-temperature thermocompression bondability, the low-temperature pastability, the high-temperature adhesivity and the pattern formability.

In the second photosensitive adhesive composition, the average functional group equivalent weight of (C) the radiation-polymerizable compound is 230 g/eq or more, more preferably 245 g/eq or more, and still more preferably 270 g/eq or more. Selection of a radiation-polymerizable compound having such a high functional group equivalent weight, and setting the average functional group equivalent weight of the (C) component in the range described above can make the stress lower and the warpage lower and can improve the low-temperature thermocompression bondability, and can make the lowest melt viscosity after the pattern formation and after heating at 150°C for 10 min to be 30,000 Pa·s or lower. The upper limit of the average functional group equivalent weight is not especially set, but the average functional group equivalent weight is preferably 1,000 g/eq or less from the viewpoint of the heat resistance reliability, the adhesivity and the moisture resistance reliability after development.

The (C) component contained in the second photosensitive adhesive composition includes compounds having an unsaturated hydrocarbon group exemplified in the first photosensitive adhesive composition. Above all, in the second photosensitive adhesive composition, the (C) component preferably contains a (meth)acrylate having a urethane bond and/or an isocyanuric ring from the viewpoint of the pattern formability and the high-temperature adhesivity.

The content of the (C) component in the second photosensitive adhesive composition is similar to that in the first photosensitive adhesive composition.

A photosensitive adhesive composition (hereinafter, referred to as "the third photosensitive adhesive composition") according to a third embodiment of the present invention is a photosensitive adhesive composition comprising (A) a thermoplastic resin, (B) a thermosetting resin, (C) a radiation-polymerizable compound and (D) a photoinitiator, and (C) the radiation-polymerizable compound contains a compound having an ethylenically unsaturated group and an epoxy group.

The third photosensitive adhesive composition, by containing the above-mentioned components, makes the composition excellent in all terms of the low-temperature thermocompression bondability, the low-temperature pastability, the high-temperature adhesivity and the pattern formability.

The third photosensitive adhesive composition comprises a thermoplastic resin having a film formation capability. Since the thermoplastic resin having a film formation capability exhibits a strong molecular entanglement and cohesive force, the case where the third photosensitive adhesive composition is used in a paste form can impart the stability and the thixotropy to an applied resin, and can further provide a tough resin excellent in the low stress property, the adhesivity after curing, and the like. The case of use in a film form can improve the film formability in coating, and can improve defects such as bleeding of the resin and pinholes. When the film photosensitive adhesive obtained is cured, a tough resin excellent in the low stress property, adhesivity and the like can be obtained.

When a film adhesive is fabricated using such a photosensitive adhesive composition comprising a thermoplastic resin having a film formation capability, the resin as the (A) component is not especially limited, but, for example, resins from which a film can be formed by the following method are preferably used. Resins are preferably used, from which a film can be formed by dissolving 60% by mass of an (A) component in a solvent selected from dimethylformamide, toluene, benzene, xylene, methyl ethyl ketone, tetrahydrofuran, ethyl cellosolve, ethyl cellosolve acetate, dioxane, cyclohexanone, ethyl acetate and N-methyl-pyrrolidinone, applying the solution on a PET film so that the film thickness after drying becomes 50 μm, heating the applied film in an oven at 80°C for 20 min, and then heating the film at 120°C for 20 min.

Above all, (A) the thermoplastic resin is preferably an alkali-soluble resin from the viewpoint of the pattern formability.

The third photosensitive adhesive composition, by making the (C) component contain a compound having an ethylenically unsaturated group and an epoxy group, can reduce the crosslinking density in photosetting, can improve the low-temperature thermocompression bondability, the low stress property and the adhesivity after photosetting, and further makes the composition excellent in the alkali resistance, the solvent resistance and the plating resistance after thermosetting.

In the compound having an ethylenically unsaturated group and an epoxy group, the ethylenically unsaturated group includes a vinyl group, an allyl group, a propargyl group, a butenyl group, an ethynyl group, a phenylethynyl group, a maleimide group, a nadiimido group and a (meth)acrylic group, and a (meth)acrylic group is preferable from the viewpoint of the reactivity.

The compound having an ethylenically unsaturated group and an epoxy group is not especially limited, but includes glycidyl methacrylate, glycidyl acrylate, 4-hydroxybutyl acrylate glycidyl ether, 4-hydroxybutyl methacrylate glycidyl ether, and additionally compounds obtained by reacting a compound having a functional group reactive with an epoxy group and an ethylenically unsaturated group with a polyfunctional epoxy resin. The functional group reactive with an epoxy group is not especially limited, but includes an isocyanate group, a carboxyl group, a phenolic hydroxyl group, a hydroxyl group, an acid anhydride, an amino group, a thiol group and an amide group. These compounds may be used singly or in combination of two or more thereof.

The compound having an ethylenically unsaturated group and an epoxy group can be obtained, for example, by reacting a polyfunctional epoxy resin having at least two or more epoxy groups in one molecule thereof with 0.1 to 0.9 equivalent weight of (meth)acrylic acid with respect to one equivalent weight of the epoxy group in the presence of triphenylphosphine or tetrabutylammonium bromide. A glycidyl group-containing urethane (meth)acrylate and the like can be obtained by reacting a polyfunctional isocyanate compound with a hydroxy group-containing (meth)acrylate and a hydroxy group-containing epoxy compound, or by reacting a polyfunctional epoxy resin with an isocyanate group-containing (meth)acrylate, in the presence of dibutyltin dilaurate.

In the compound having an ethylenically unsaturated group and an epoxy group, the 5%-weight loss temperature is preferably 150°C or higher in that the volatilization, and the segregation to the surface by heat drying in film formation can be suppressed, from the viewpoint of the preservation stability, the adhesivity, the low outgas property of packages in assembling heating and after assembling, and the heat and moisture resistance, and is more preferably 180°C or higher, and still more preferably 200°C or higher, in that voids, exfoliation, and a decrease in adhesivity due to outgas in thermosetting can be suppressed. The 5%-weight loss temperature is most preferably 260°C or higher in that voids and exfoliation due to volatilization of unreacted components in reflow can be suppressed. Such a compound having an ethylenically unsaturated group and an epoxy group is preferably a compound having an aromatic ring in its molecule.

Further, as the compound having an ethylenically unsaturated group and an epoxy group, use of a high-purity product thereof is preferable in which alkaline metal ions, alkaline earth metal ions and halogen ions as impurity ions, particularly chlorine ions, hydrolyzable chlorine and the like, are decreased to 1,000 ppm or less, from the viewpoint of the prevention of electromigration and the prevention of corrosion of metal conductor circuits. For example, use of a polyfunctional epoxy resin in which alkaline metal ions, alkaline earth metal ions, halogen ions and the like are decreased, as a raw material, can satisfy the impurity ion concentration described above. The whole chlorine content can be measured according to JIS K7243-3.

The compound having an ethylenically unsaturated group and an epoxy group, which meets the heat resistance and the purity described above, is not especially limited, but includes compounds using, as a raw material, glycidyl ethers of a bisphenol A type (or AD type, S type, F type), glycidyl ethers of a hydrogenated bisphenol A type, glycidyl ethers of an ethylene oxide adduct bisphenol A and/or F type, glycidyl ethers of a propylene oxide adduct bisphenol A and/or F type, glycidyl ethers of phenol novolac resins, glycidyl ethers of cresol novolac resins, glycidyl ethers of bisphenol A novolac resins, glycidyl ethers of naphthalene resins, trifunctional (or tetrafunctional) glycidyl ethers, glycidyl ethers of dicyclopentadiene phenol resins, glycidyl esters of dimer acids, trifunctional (or tetrafunctional) glycidyl amines, glycidyl amines of naphthalene resins, or the like.

In order to improve the thermocompression bondability, the low stress property and the adhesivity, and maintain the developability in pattern formation, the numbers of the epoxy group and the ethylenically unsaturated group of the compound having an ethylenically unsaturated group and an epoxy group are preferably each 3 or less, and especially the number of the ethylenically unsaturated group is preferably 2 or less. Further, the compound having an ethylenically unsaturated group and an epoxy group is preferably a monofunctional (meth)acrylate having an epoxy group from the viewpoint of the low-temperature thermocompression bondability, the low stress property and the adhesivity after photosetting. Such a monofunctional (meth)acrylate having an epoxy group includes ones exemplified in the first photosensitive adhesive composition.

The content of the (C) component in the third photosensitive adhesive composition is similar to that in the first photosensitive adhesive composition.

The content of the compound having an ethylenically unsaturated group and an epoxy group in the third photosensitive adhesive composition is preferably 1 to 100 parts by mass, more preferably 2 to 70 parts by mass, and still more preferably 5 to 50 parts by mass, with respect to 100 parts by mass of the (A) component. If the content exceeds 100 parts by mass, the thixotropy decreases in film formation and films are likely to be hardly formed; and the tackiness increases and the handleability is likely to become insufficient. Further, the developability is likely to decrease in pattern formation and the melt viscosity after photosetting becomes too low, and patterns are likely to thereby deform in thermocompression bonding. By contrast, if the content of the compound having an ethylenically unsaturated group and an epoxy group is less than 1 part by mass, the sufficient effect of the addition is unlikely to be seen.

The first and third photosensitive adhesive compositions preferably further comprise (E) a thermal radical generating agent. Thereby, since a heat treatment after adhering can reduce an unreacted radiation-polymerizable compound, generation of outgas from packages in assembling heating and after assembling can be made sufficiently low, and additionally, cured products can be made uniformly of a high elasticity. Thereby, cured products can be obtained which have a high heat resistance, a low moisture permeability and a low moisture absorptivity, and the high-temperature adhesivity and the moisture resistance reliability are improved. The compositions, since the reaction hardly proceeds by coating drying in the pattern formation or in the formation into a film form, make sufficient the low-temperature thermocompression bondability after the pattern formation and the low-temperature pastability in the formation into a film form.

(E) The thermal radical generating agent is preferably an organic peroxide. Use of an organic peroxide having

a high half-life temperature, a high radical production efficiency and a high solubility to a solvent, as a thermal radical generating agent, can further reduce an unreacted radiation-polymerizable compound in the photosensitive adhesive composition. Since the organic peroxide dissolves homogeneously, a good pattern can be obtained after development.

In the second and third photosensitive adhesive compositions, the lowest melt viscosity at 20°C to 200°C after pattern formation is preferably 30,000 Pa·s or lower, more preferably 20,000 Pa·s or lower, still more preferably 18,000 Pa·s or lower, and further still more preferably 15,000 Pa·s or lower. The second and third photosensitive adhesive compositions, by having a lowest melt viscosity in the range described above, can secure a sufficient low-temperature thermocompression bondability while controlling pattern deformation, and can impart a good close adhesivity to a substrate having irregularities and the like. The lower limit of the lowest melt viscosity is not especially set, but is desirably 100 Pa·s or higher in terms of handleability and the like.

The first to third photosensitive adhesive compositions, by containing an alkali-soluble resin as the (A) component, make the compositions good in developability.

Tg of the (A) component is preferably 150°C or lower, and more preferably -20°C to 150°C. If the Tg exceeds 150°C, when a film adhesive (adhesive layer) is pasted on an adherend (semiconductor wafer), a high temperature of 200°C or higher is needed, and warpage is likely to generate in the semiconductor wafer. The pasting temperature of the film adhesive on the rear surface of the wafer is preferably 20 to 150°C, and more preferably 25 to 100°C, from the viewpoint of suppressing warpage of the semiconductor wafer. In order to allow pasting at the temperature described above, Tg of the film adhesive is made preferably 150°C or lower. By contrast, if Tg is lower than -20°C, the tackiness of the film surface in the B-stage condition becomes too strong and the handleability is unlikely to be good.

Here, "Tg" means a peak temperature in the primary dispersion when the (A) component is made a film. Tanδ is measured using a viscoelasticity analyzer "RSA-2" (trade name), made by Rheometrics Scientific F.E. Ltd., under the conditions of a temperature-rise rate of 5°C/min, a frequency of 1 Hz, and a measurement temperature range of -150°C to 300°C, and the tanδ peak temperature near Tg is denoted as the primary dispersion peak temperature.

The weight-average molecular weight of the (A) component is preferably controlled in the range of 5,000 to 500,000, more preferably 10,000 to 300,000 in that the low-temperature pastability, the thermocompression bondability and the high-temperature adhesivity are all highly satisfied simultaneously, and still more preferably 10,000 to 100,000 in that the pattern formability is improved more. If the weight-average molecular weight is in the range described above, the strength, flexibility and tackiness when a photosensitive adhesive composition is made into a sheet form or a film form become good, and since the hot fluidity becomes good, good embeddability of wiring steps (irregularities) on the substrate surface can be secured. If the weight-average molecular weight is less than 5,000, the film formability is likely to be insufficient. By contrast, if the weight-average molecular weight exceeds 500,000, the hot fluidity and the embeddability are likely to become insufficient, and the solubility of the resin composition to an alkali developing solution in pattern formation is likely to become insufficient. Here, "the weight-average molecular weight" means a weight-average molecular weight in terms of polystyrene as measured using a high-performance liquid chromatography "C-R4A" (trade name), made by Shimadzu Corp.

By making Tg and the weight-average molecular weight of the (A) component in the ranges described above, since the pasting temperature on the wafer rear surface can be suppressed low, and the heating temperature (thermocompression bonding temperature) when a semiconductor element is adhered and fixed to a support member for mounting the semiconductor element can be made low, an increase in warpage of the semiconductor element can be suppressed. The pastability, the thermocompression bondability and the developability can effectively be imparted also. Here, "pastability" means pastability in the case where a photosensitive adhesive composition is made a film adhesive by forming the photosensitive adhesive composition into a film form.

The (A) component (alkali-soluble resin) is preferably a polymer having an alkali-soluble group, and more preferably a polymer having an alkali-soluble group on its terminals or side chains. The alkali-soluble group includes an ethylene glycol group, a carboxyl group, a hydroxyl group, a sulfonyl group and a phenolic hydroxyl group. These functional groups may be used singly or in combination of two or more thereof. The (A) component is, for example, a thermoplastic resin having a carboxyl group and/or a hydroxyl group.

The (A) component specifically includes polyester resins, polyether resins, polyimide resins, polyamide resins, polyamideimide resins, polyetherimide resins, polyurethane resins, polyurethaneimide resins, polyurethaneamidoimide resins, siloxane polyimide resins, polyesterimide resins, copolymers thereof, precursors thereof (polyamic acid and the like), and additionally polybenzoxazol resins, phenoxy resins, polysulfone resins, polyether sulfone resins, polyphenylene sulfide resins, polyester resins, polyether resins, polycarbonate resins, polyether ketone resins, and (meth)acrylic copolymers of 10,000 to 1,000,000 in weight-average molecular weight, novolac resins and phenol resins. These may be used singly or in combination of two or more thereof. These resins may also be ones imparted an ether group, a carboxyl group and/or a hydroxyl group on main chains and/or side chains thereof.

Above all, the (A) component is preferably a polyimide resin and/or a polyamideimide resin from the viewpoint of the high-temperature adhesivity, the heat resistance and the film formability. The polyimide resin and/or the polyamideimide resin can be obtained, for example, by condensation reacting a tetracarboxylic dianhydride and a diamine by

a well-known method. That is, in an organic solvent, a tetracarboxylic dianhydride and a diamine in equimolar concentrations are addition reacted at a reaction temperature of 80°C or lower, preferably 0 to 60°C; or as required, in an organic solvent, the compositional ratio is adjusted in the range of preferably 0.5 to 2.0 mol, more preferably 0.8 to 1.0 mol of the total of the diamine with respect to 1.0 mol of the total of the tetracarboxylic dianhydride, and these are addition reacted likewise. The viscosity of the reaction solution gradually increases as the reaction proceeds, and a polyamic acid as a precursor of a polyimide resin is produced. In order to suppress the degradation of various characteristics of the resin composition, the tetracarboxylic dianhydride is preferably one recrystallized and refined with acetic anhydride.

With respect to the compositional ratio of a tetracarboxylic dianhydride and a diamine in the condensation reaction, if the total of the diamine exceeds 2.0 mol with respect to 1.0 mol of the total of the tetracarboxylic dianhydride, in an obtained polyimide resin and/or polyamideimide resin, the amount of a polyimide oligomer having an amine terminal is likely to become much; the weight-average molecular weights of the polyimide resin and/or polyamideimide resin decrease; and various characteristics including the heat resistance of the resin composition are likely to become insufficient. By contrast, if the total of the diamine is less than 0.5 mol with respect to 1.0 mol of the total of the tetracarboxylic dianhydride, the amount of a polyimide resin and/or polyamideimide resin oligomer having an acid terminal is likely to become much; the weight-average molecular weights of the polyimide resin and/or polyamideimide resin decrease; and various characteristics including the heat resistance of the resin composition are likely to become insufficient.

A polyimide resin and/or polyamideimide resin can be obtained by dehydratively cyclizing the reaction product described above (polyamic acid). The dehydrative cyclization can be carried out by a thermal cyclization method using a heat treatment, a chemical cyclization method using a dehydrating agent, or the like.

The tetracarboxylic dianhydride used as a raw material of a polyimide resin and/or polyamideimide resin is not especially limited, and examples thereof include pyromellitic dianhydride, 3,3',4,4'-biphenyltetracarboxylic dianhydride, 2,2',3,3'-biphenyltetracarboxylic dianhydride, 2,2-bis(3,4-dicarboxyphenyl)propane dianhydride, 2,2-bis(2,3-dicarboxyphenyl)propane dianhydride, 1,1-bis(2,3-dicarboxyphenyl)ethane dianhydride, 1,1-bis(3,4-dicarboxyphenyl)ethane dianhydride, bis(2,3-dicarboxyphenyl)methane dianhydride, bis(3,4-dicarboxyphenyl)methane dianhydride, bis(3,4-dicarboxyphenyl)sulfone dianhydride, 3,4,9,10-perylenetetracarboxylic dianhydride, bis(3,4-dicarboxyphenyl)ether dianhydride, benzene-1,2,3,4-tetracarboxylic dianhydride, 3,4,3',4'-benzophenonetetracarboxylic dianhydride, 2,3,2',3'-benzophenonetetracarboxylic dianhydride, 3,3,3',4'-benzophenonetetracarboxylic dianhydride, 1,2,5,6-naphthalenetetracarboxylic dianhydride, 1,4,5,8-naphthalenetetracarboxylic dianhydride, 2,3,6,7-naphthalenetetracarboxylic dianhydride, 1,2,4,5-naphthalenetetracarboxylic dianhydride, 2,6-dichloronaphthalene-1,4,5,8-tetracarboxylic dianhydride, 2,7-dichloronaphthalene-1,4,5,8-tetracarboxylic dianhydride, 2,3,6,7-tetrachloronaphthalene-1,4,5,8-tetracarboxylic dianhydride, phenanthrene-1,8,9,10-tetracarboxylic dianhydride, pyrazine-2,3,5,6-tetracarboxylic dianhydride, thiophene-2,3,5,6-tetracarboxylic dianhydride, 2,3,3',4'-biphenyltetracarboxylic dianhydride, 3,4,3',4'-biphenyltetracarboxylic dianhydride, 2,3,2',3'-biphenyltetracarboxylic dianhydride, bis(3,4-dicarboxyphenyl)dimethylsilane dianhydride, bis(3,4-dicarboxyphenyl)methylphenylsilane dianhydride, bis(3,4-dicarboxyphenyl)diphenylsilane dianhydride, 1,4-bis(3,4-dicarboxyphenyldimethylsilyl)benzene dianhydride, 1,3-bis(3,4-dicarboxyphenyl)-1,1,3,3-tetramethyldicyclohexane dianhydride, p-phenylene bis(trimellitate anhydride), ethylenetetracarboxylic dianhydride, 1,2,3,4-butanetetracarboxylic dianhydride, decahydronaphthalene-1,4,5,8-tetracarboxylic dianhydride, 4,8-dimethyl-1,2,3,5,6,7-hexahydronaphthalene-1,2,5,6-tetracarboxylic dianhydride, cyclopentane-1,2,3,4-tetracarboxylic dianhydride, pyrrolidine-2,3,4,5-tetracarboxylic dianhydride, 1,2,3,4-cyclobutanetetracarboxylic dianhydride, bis(exo-bicyclo[2,2,1]heptane-2,3-dicarboxylic acid) dianhydride, bicyclo[2,2,2]-oct-7-ene-2,3,5,6-tetracarboxylic dianhydride, 2,2-bis(3,4-dicarboxyphenyl)propane dianhydride, 2,2-bis[4-(3,4-dicarboxyphenyl)phenyl]propane dianhydride, 2,2-bis(3,4-dicarboxyphenyl)hexafluoropropane dianhydride, 2,2-bis[4-(3,4-dicarboxyphenyl)phenyl]hexafluoropropane dianhydride, 4,4'-bis(3,4-dicarboxyphenoxy) diphenyl sulfide dianhydride, 1,4-bis(2-hydroxyhexafluoroisopropyl)benzenebis(trimellitic anhydride), 1,3-bis(2-hydroxyhexafluoroisopropyl)benzenebis (trimellitic anhydride), 5-(2,5-dioxotetrahydrofuryl)-3-methyl-3-cyclohexene-1,2-dicarboxylic dianhydride, tetrahydrofuran-2,3,4,5-tetracarboxylic dianhydride and a tetracarboxylic dianhydride represented by the following formula (1). In the following formula (1), a denotes an integer of 2 to 20.

[Chemical Formula 3]

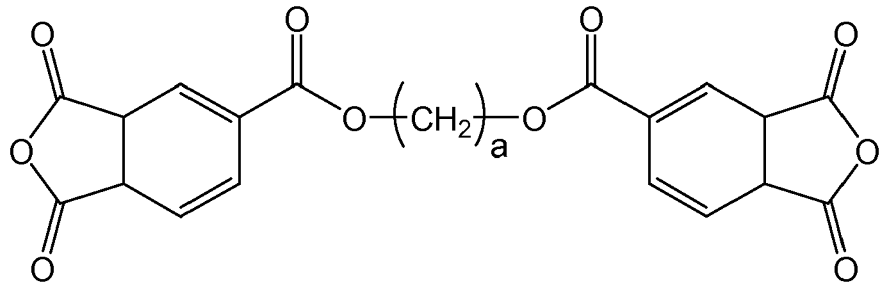

(1)

A tetracarboxylic dianhydride represented by the above formula (1) can be synthesized, for example, from an anhydrous trimellitic acid monochloride and a diol corresponding thereto, and specifically includes 1,2-(ethylene)bis (trimellitate anhydride), 1,3-(trimethylene)bis(trimellitate anhydride), 1,4-(tetramethylene)bis(trimellitate anhydride), 1,5-(pentamethylene)bis(trimellitate anhydride), 1,6-(hexamethylene)bis(trimellitate anhydride), 1,7-(heptamethylene) bis(trimellitate anhydride), 1,8-(octamethylene)bis(trimellitate anhydride), 1,9-(nonamethylene)bis(trimellitate anhydride), 1,10-(decamethylene)bis(trimellitate anhydride), 1,12-(dodecamethylene)bis(trimellitate anhydride), 1,16-(hexadecamethylene)bis(trimellitate anhydride) and 1,18-(octadecamethylene)bis(trimellitate anhydride).

The tetracarboxylic dianhydride is preferably a tetracarboxylic dianhydride represented by the following formula (2) or (3) from the viewpoint of imparting a good solubility to a solvent, a moisture resistance, and the transparency to light of 365 nm.

[Chemical Formula 4]

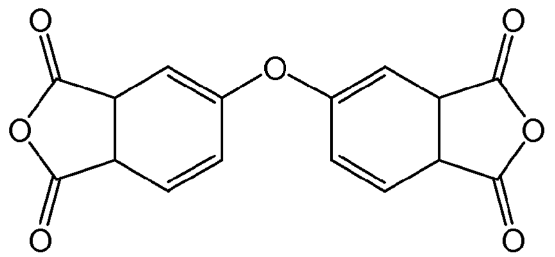

(2)

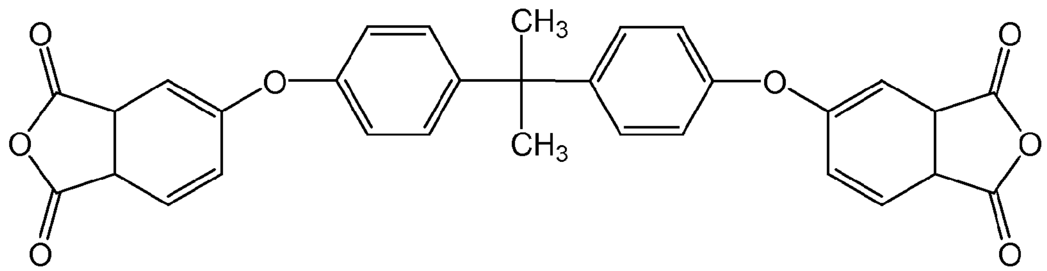

(3)

The tetracarboxylic dianhydride described hitherto may be used singly or in combination of two or more thereof.

The (A) component is preferably further a polyimide resin and/or polyamideimide resin containing a carboxyl group and/or a hydroxyl group. A diamine used as a raw material of the polyimide resin and/or polyamideimide resin containing a carboxyl group and/or a hydroxyl group preferably contains an aromatic diamine represented by the following formula (4), (5), (6) or (7). The diamine represented by the following formula (4), (5), (6) or (7) is preferably 1 to 100 mol%, more preferably 3 to 80 mol%, and most preferably 5 to 50 mol%, with respect to the whole diamine.

[Chemical Formula 5]

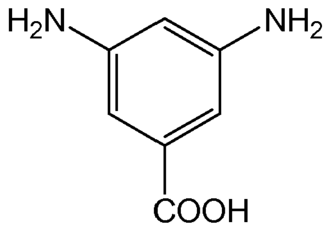
(4)

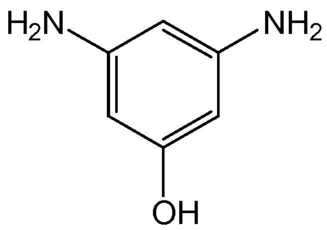
(5)

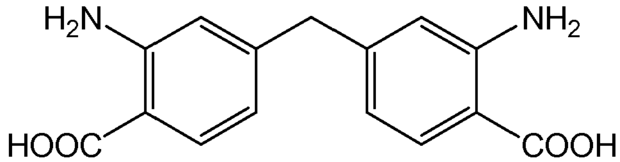
(6)

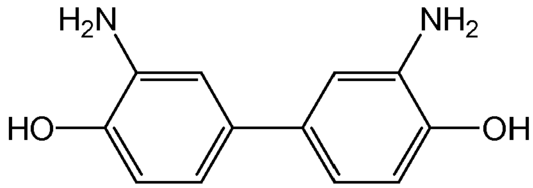
(7)

Other diamines used as a raw material of the polyimide resin and/or polyamideimide resin are not especially limited, and examples thereof include o-phenylenediamine, m-phenylenediamine, p-phenylenediamine, 3,3'-diaminodiphenyl ether, 3,4'-diaminodiphenyl ether, 4,4'-diaminodiphenyl ether, 3,3'-diaminodiphenylmethane, 3,4'-diaminodiphenylmethane, 4,4'-diaminodiphenylmethane, bis(4-amino-3,5-dimethylphenyl)methane, bis(4-amino-3,5-diisopropylphenyl)methane, 3,3'-diaminodiphenyldifluoromethane, 3,4'-diaminodiphenyldifluoromethane, 4,4'-diaminodiphenyldifluoromethane, 3,3'-diaminodiphenylsulfone, 3,4'-diaminodiphenylsulfone, 4,4'-diaminodiphenylsulfone, 3,3'-diaminodiphenyl sulfide, 3,4'-diaminodiphenylsulfide, 4,4'-diaminodiphenyl sulfide, 3,3'-diaminodiphenyl ketone, 3,4'-diaminodiphenyl ketone, 4,4'-diaminodiphenyl ketone, 2,2-bis(3-aminophenyl)propane, 2,2'-(3,4'-diaminodiphenyl)propane, 2,2-bis(4-aminophenyl)propane, 2,2-bis(3-aminophenyl)hexafluoropropane, 2,2-(3,4'-diaminodiphenyl)hexafluoropropane, 2,2-bis(4-aminophenyl)hexafluoropropane, 1,3-bis(3-aminophenoxy)benzene, 1,4-bis(3-aminophenoxy)benzene, 1,4-bis(4-aminophenoxy)benzene, 3,3'-(1,4-phenylenebis(1-methyethylidene))bisaniline, 3,4'-(1,4-phenylenebis (1-methylethylidene))bisaniline, 4,4'-(1,4-phenylenebis(1-methylethylidene))bisaniline, 2,2-bis(4-(3-aminophenoxy) phenyl)propane, 2,2-bis(4-(3-aminophenoxy)phenyl)hexafluoropropane, 2,2-bis(4-(4-aminophenoxy)phenyl)hexafluoropropane, bis(4-(3-aminophenoxy)phenyl) sulfide, bis(4-(4-aminophenoxy)phenyl) sulfide, bis(4-(3-aminophenoxy)phenyl)sulfone, bis(4-(4-aminophenoxy)phenyl)sulfone, 3,3'-dihydroxy-4,4'-diaminobiphenyl, aromatic diamines such as 3,5-diaminobenzoic acid, 1,3-bis(aminomethyl)cyclohexane, 2,2-bis(4-aminophenoxyphenyl)propane, an aliphatic ether diamine represented by the following formula (8), an aliphatic diamine represented by the following formula (8-1) and a siloxane diamine represented by the following formula (9).

[Chemical Formula 6]

$$H_2N-R^1-\left(O-R^2\right)_b-O-R^3-NH_2 \qquad (8)$$

In the above formula (8), $R^1$, $R^2$ and $R^3$ each independently denote an alkylene group having 1 to 10 carbon atoms; and b denotes an integer of 1 to 80.

[Chemical Formula 7]

$$H_2N-\left(CH_2\right)_c-NH_2 \qquad (8\text{-}1)$$

In the above formula (8-1), c denotes an integer of 5 to 20.

Among the diamines described above, an aliphatic ether diamine represented by the above formula (8) is preferable, and an ethylene glycol- and/or propylene glycol-based diamine is more preferable, in that the compatibility with other components, the organic solvent solubility and the alkali solubility can be imparted.

Such an aliphatic ether diamine specifically includes aliphatic diamines of polyoxyalkylenediamines and the like such as Jeffamine D-230, D-400, D-2000, D-4000, ED-600, ED-900, ED-2000 and EDR-148, made by Sun Technochemical Co., Ltd., and polyetheramines D-230, D-400 and D-2000, made by BASF AG. These diamines are preferably 1 to 80 mol% with respect to the whole diamine, and more preferably 5 to 60 mol% in that the compatibility with other formulation components, the low-temperature pastability, the thermocompression bondability and the high-temperature adhesivity are highly satisfied simultaneously. If the amount is less than 1 mol%, the impartment of the high-temperature adhesivity and the hot fluidity is likely to be difficult; and by contrast, if the amount exceeds 80 mol%, Tg of the polyimide resin becomes too low and the self-supportability of films is likely to be damaged.

The diamine is preferably a siloxane diamine represented by the following formula (9) in that the close adhesivity and the adhesivity at room temperature are imparted. In the following formula (9), $R^4$ and $R^9$ each independently denote an alkylene group having 1 to 5 carbon atoms or a phenylene group which may have a substituent; $R^5$, $R^6$, $R^7$ and $R^8$ each independently denote an alkyl group having 1 to 5 carbon atoms, a phenyl group or a phenoxy group; and d denotes an integer of 1 to 5.

[Chemical Formula 8]

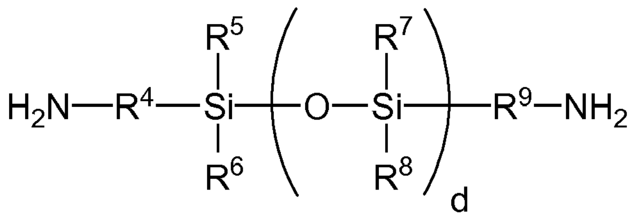

(9)

These diamines are preferably 0.5 to 80 mol% with respect to the whole diamine, and more preferably 1 to 50 mol% in that the low-temperature pastability, the thermocompression bondability and the high-temperature adhesivity are highly satisfied simultaneously. If the amount is less than 0.5 mol%, the effect of addition of a siloxane diamine becomes small; and if the amount exceeds 80 mol%, the compatibility with other components, the high-temperature adhesivity and the developability are likely to decrease.

The siloxane diamine represented by the above formula (9) specifically includes, as those having d of 1 in the formula (9), 1,1,3,3-tetramethyl-1,3-bis(4-aminophenyl)disiloxane, 1,1,3,3-tetraphenoxy-1,3-bis(4-aminoethyl)disiloxane, 1,1,3,3-tetraphenyl-1,3-bis(2-aminoethyl)disiloxane, 1,1,3,3-tetraphenyl-1,3-bis(3-aminopropyl)disiloxane,

1,1,3,3-tetramethyl-1,3-bis(2-aminoethyl)disiloxane, 1,1,3,3-tetramethyl-1,3-bis(3-aminopropyl)disiloxane, 1,1,3,3-tetramethyl-1,3-bis(3-aminobutyl)disiloxane and 1,3-dimethyl-1,3-dimethoxy-1,3-bis(4-aminobutyl)disiloxane, and as those having d of 2, 1,1,3,3,5,5-hexamethyl-1,5-bis(4-aminophenyl)trisiloxane, 1,1,5,5-tetraphenyl-3,3-dimethyl-1,5-bis(3-aminopropyl)trisiloxane, 1,1,5,5-tetraphenyl-3,3-dimethoxy-1,5-bis(4-aminobutyl)trisiloxane, 1,1,5,5-tetraphenyl-3,3-dimethoxy-1,5-bis(5-aminopentyl)trisiloxane, 1,1,5,5-tetramethyl-3,3-dimethoxy-1,5-bis(2-aminoethyl)trisiloxane, 1,1,5,5-tetramethyl-3,3-dimethoxy-1,5-bis(4-aminobutyl)trisiloxane, 1,1,5,5-tetramethyl-3,3-dimethoxy-1,5-bis(5-aminopentyl)trisiloxane, 1,1,3,3,5,5-hexamethyl-1,5-bis(3-aminopropyl)trisiloxane, 1,1,3,3,5,5-hexaethyl-1,5-bis(3-aminopropyl)trisiloxane and 1,1,3,3,5,5-hexapropyl-1,5-bis(3-aminopropyl)trisiloxane.

The diamines described above may be used singly or in combination of two or more thereof.

The polyimide resin and/or polyamideimide resin may be used singly or as a blend of two or more as required.

As described above, when the composition of a polyimide resin and/or polyamideimide resin is determined, the composition is preferably designed so that Tg thereof becomes 150°C or lower; then, as a diamine as a raw material of the polyimide resin, an aliphatic ether diamine represented by the above formula (8) is especially preferably used.

In the synthesis of the polyimide resin and/or polyamideimide resin, by charging a monofunctional acid anhydride such as a compound represented by the following formula (10), (11) or (12) and/or a monofunctional amine in a condensation reaction solution, a functional group except an acid anhydride and a diamine can be introduced to the polymer terminal. Thereby, the molecular weight of the polymer can be decreased and the developability and the thermocompression bondability in pattern formation can be improved. The functional group except an acid anhydride and a diamine is not especially limited, but is preferably an alkali-soluble group such as a carboxyl group, a phenolic hydroxyl group or an ether group in that the alkali solubility in pattern formation is improved. Further in order to impart an adhesivity, a compound having a radiation-polymerizable group and/or a thermosetting group, such as a compound represented by the following formula (12) or a (meth)acrylate having an amino group, is preferably used. Further in order to impart a low hygroscopicity, a compound having a siloxane skeleton and the like is preferably used.

[Chemical Formula 9]

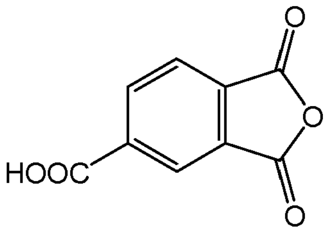

(10)

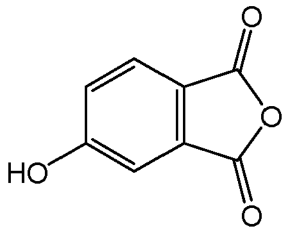

(11)

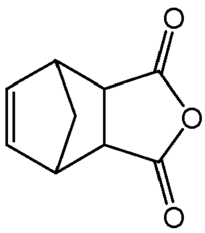

(12)

In the polyimide resin and/or polyamideimide resin, the transmittance at 365 nm when formed into a film form of 30 μm is preferably 10% or more at a point where the side wall of the pattern is vertical to an adherend, from the viewpoint of the photosetting, and more preferably 20% or more at a point where a pattern can be formed in a smaller exposure amount. Such a polyimide resin can be synthesized, for example, by reacting an acid anhydride represented by the above formula (2) with an aliphatic ether diamine represented by the above formula (8) and/or a siloxane diamine represented by the above formula (9).

In the photosensitive adhesive composition according to the present embodiment, the content of the (A) component is preferably 5 to 90% by mass, and more preferably 20 to 80% by mass, based on the total amount of the solid content of the photosensitive adhesive composition. If the content is less than 20% by mass, the developability in pattern formation is likely to become insufficient; and if the content exceeds 80% by mass, the developability and the adhesivity in pattern formation are likely to become insufficient.

In the case where the alkali solubility of the (A) component is poor, or the (A) component does not dissolve in

an alkali solvent, as a dissolving auxiliary agent, a resin having a carboxyl group and/or a hydroxyl group, and/or a resin having a hydrophilic group may be added. The resin having a hydrophilic group is not especially limited as long as being an alkali-soluble resin, but includes resins having a glycol group such as an ethylene glycol group and a propylene glycol group.

In the first to third photosensitive resin compositions, the (B) thermosetting resin is preferably one containing at least two or more epoxy groups in its molecule, and is more preferably a glycidyl ether type epoxy resin of phenol from the viewpoint of the curability and characteristics of cured products. Examples of such resins include glycidyl ethers of a bisphenol A type (or AD type, S type, F type), glycidyl ethers of a hydrogenated bisphenol A type, glycidyl ethers of an ethylene oxide adduct bisphenol A type, glycidyl ethers of a propylene oxide adduct bisphenol A type, glycidyl ethers of phenol novolac resins, glycidyl ethers of cresol novolac resins, glycidyl ethers of bisphenol A novolac resins, glycidyl ethers of naphthalene resins, trifunctional (or tetrafunctional) glycidyl ethers, glycidyl ethers of dicyclopentadiene phenol resins, glycidyl esters of dimer acids, trifunctional (or tetrafunctional) glycidyl amines and glycidyl amines of naphthalene resins. These may be used singly or in combination of two or more thereof.

As the (B) thermosetting resin, use of a high-purity product thereof is preferable in which alkaline metal ions, alkaline earth metal ions and halogen ions as impurity ions, particularly chlorine ions, hydrolyzable chlorine and the like, are decreased to 300 ppm or less, from the viewpoint of the prevention of electromigration and the prevention of corrosion of metal conductor circuits.

The content of the (B) component is preferably 0.1 to 100 parts by mass, and more preferably 2 to 50 parts by mass, with respect to 100 parts by mass of the (A) component. If the content exceeds 100 parts by mass, the solubility to an alkali aqueous solution decreases and the pattern formability is likely to become insufficient. By contrast, if the content is less than 0.1 part by mass, the high-temperature adhesivity is likely to become insufficient.

Other than the (B) component, a curing agent, a curing accelerator, a radiation-polymerizable compound and the like may be contained.

Examples of the curing agent include phenol-based compounds, aliphatic amines, alicyclic amines, aromatic polyamines, polyamides, aliphatic acid anhydrides, alicyclic acid anhydrides, aromatic acid anhydrides, dicyandiamide, organic acid dihydrazides, boron trifluoride-amine complexes, imidazoles and tertiary amines. Above all, phenol-based compounds are preferable, and phenol-based compounds having at least two or more phenolic hydroxyl groups in their molecule are more preferable. Examples of such compounds include phenol novolac, cresol novolac, t-butylphenol novolac, dicyclopentadiene cresol novolac, dicyclopentadiene phenol novolac, xylylene-modified phenol novolac, naphthol-based compounds, trisphenol-based compounds, tetrakisphenol novolac, bisphenol A novolac, poly-p-vinylphenol and phenol aralkyl resins. Above all, the compounds having a number-average molecular weight in the range of 400 to 4,000 are preferable. Thereby, in assembling heating of semiconductor devices, outgas in heating which causes contaminations to semiconductor elements or devices can be suppressed. The content of the phenol-based compound is preferably 1 to 100 parts by mass, more preferably 2 to 50 parts by mass, and most preferably 2 to 30 parts by mass, with respect to 100 parts by mass of the (A) component. If the content exceeds 100 parts by mass, the reactivity in exposure of a compound having an ethylenically unsaturated group and an epoxy group, and a radiation-polymerizable compound is likely to become poor, or the film thickness is likely to decrease or swell after development, due to rising of the acid value and the phenolic hydroxyl group value of the resin. The penetration of a developing solution into a resin pattern becomes large and thereby, the amount of outgas in thermosetting and the assembling thermal history thereafter becomes large, and the heat resistance reliability and the moisture resistance reliability are likely to largely decrease. By contrast, if the content is less than 1 part by mass, a sufficient high-temperature adhesivity is unlikely to be obtained.

The curing accelerator is not especially limited as long as being one containing a curing accelerator to accelerate curing/polymerization of epoxy by heating, and examples thereof include imidazoles, dicyandiamide derivatives, dicarboxylic acid dihydrazides, triphenylphosphine, tetraphenylphosphonium tetraphenylborate, 2-ethyl-4-methylimidazole-tetraphenylborate and 1,8-diazabicyclo[5.4.0]undecene-7-tetraphenylborate. The content of a curing accelerator in a photosensitive adhesive composition is preferably 0.01 to 50 parts by mass with respect to 100 parts by mass of an epoxy resin.

In the first to third photosensitive adhesive compositions, the (D) component (photoinitiator) is preferably one having a molecular extinction coefficient for light of 365 nm in wavelength of 1,000 ml/g.cm or higher, and more preferably 2,000 ml/g·cm or higher, from the viewpoint of improving the sensitivity. The molecular extinction coefficient can be determined by preparing a 0.001-mass% acetonitrile solution of a sample, and measuring an absorbance of the solution by using a spectrophotometer ("U-3310"(trade name), made by Hitachi High-Technologies Corp.).

When a photosensitive adhesive composition is made an adhesive layer having a film thickness of 30 μm or more, the (D) component is more preferably one which bleaches by light irradiation, from the viewpoint of improving the sensitivity and improving the internal curability. Examples of such (D) components include compounds to photobleach by UV irradiation, among aromatic ketones such as 2-benzyl-2-dimethylamino-1-(4-morpholinophenyl)-butanone-1,2,2-dimethoxy-1,2-diphenylethan-1-one, 1-hydroxy-cyclohexyl-phenyl-ketone, 2-methyl-1-(4-(methylthio)phenyl)-2-morpholinopropanone-1,2,4-diethylthioxanthone, 2-ethylanthraquinone and phenanthrene quinone, benzyl derivatives such

as benzyl dimethyl ketal, 2,4,5-triarylimidazole dimers such as 2-(o-chlorophenyl)-4,5-diphenylimidazole dimer, 2-(o-chlorophenyl)-4,5-di(m-methoxyphenyl)imidazole dimer, 2-(o-fluorophenyl)-4,5-phenylimidazole dimer, 2-(o-methoxypheny)-4,5-diphenylimidazole dimer, 2-(p-methoxypheny)-4,5-diphenylimidazole dimer, 2,4-di(p-methoxypheny)-5-phenylimidazole dimer and 2-(2,4-dimethoxyphenyl)-4,5-diphenylimidazole dimer, acridine derivatives such as 9-phenylacridine and 1,7-bis(9,9'-acridinyl)heptane, and bisacylphosphine oxides such as bis(2,6-dimethoxybenzoyl)-2,4,4-trimethyl-pentylphosphine oxide and bis(2,4,6,-trimethylbenzoyl)-phenylphosphine oxide. These may be used singly or in combination of two or more thereof.

The (D) component may contain a photoinitiator to develop a function to promote the polymerization and/or the reaction of an epoxy resin by radiation irradiation. Examples of such a photoinitiator include photobase generating agents to generate a base by radiation irradiation, and photoacid generating agents to generate an acid by radiation irradiation, and photobase generators are especially preferable.

Use of a photobase generating agent can further improve the high-temperature adhesivity of a photosensitive adhesive composition to an adherend, and the moisture resistance. The reason is conceivably because a base produced from a photobase generating agent acts efficiently as a curing catalyst of an epoxy resin, thereby more enhancing the crosslinking density, and the produced curing catalyst scarcely corrodes substrates and the like. By making a photosensitive adhesive composition contain a photobase generating agent, the crosslinking density can be improved, and outgas when left at a high temperature can be reduced more. It is further conceivable that the curing process temperature can be made lower and the curing process can be made shorter.

If the content proportion of a carboxyl group and/or a hydroxyl group of the (A) component is high, there arise apprehensions of rising of the moisture absorptivity after curing and decreasing of the adhesive force after curing. By contrast, use of a photosensitive adhesive composition containing a photobase generating agent can decrease the carboxyl group and/or the hydroxyl group remaining after the reaction of the carboxyl group and/or the hydroxyl group with an epoxy resin due to the generation of a base by irradiation of radiation; and the moisture resistance, the adhesivity and the pattern formability can be all satisfied simultaneously in high levels.

Any photobase generating agent can be used with no special limitation as long as being a compound to generate a base in radiation irradiation. The base generated is preferably a strong base compound from the viewpoint of the reactivity and the curing rate. The pKa value being a logarithm of an acid dissociation constant as an index of the basicity is generally used, and a base having a pKa value in an aqueous solution of 7 or more is preferable, and a base of 9 or more is more preferable.

Examples of such bases to be generated in radiation irradiation include imidazole derivatives such as imidazole, 2,4-dimethylimidazole and 1-methylimidazole, piperazine derivatives such as piperazine and 2,5-dimethylpiperazine, piperidine derivatives such as piperidine and 1,2-dimethylpiperidine, proline derivatives, trialkylamine derivatives such as trimethylamine, triethylamine and triethanolamine, pyridine derivatives, at the 4-position of which an amino group or the alkylamino group is substituted, such as 4-methylaminopyridine and 4-dimethylaminopyridine, pyrrolidine derivatives such as pyrrolidine and n-methylpyrrolidine, dihydropyridine derivatives, alicyclic amine derivatives such as triethylenediamine and 1,8-diazabiscyclo(5,4,0)undecene-1 (DBU), and benzylamine derivatives such as benzylmethylamine, benzyldimethylamine and benzyldiethylamine.

As a photobase generating agent to generate a base by radiation irradiation as described above, for example, quaternary ammonium salt derivatives can be used which are described in Journal of Photopolymer Science and Technology, vol. 12, section 313-314 (1999), Chemistry of Materials, vol. 11, section 170-176 (1999), and the like. Since these produce a highly basic trialkylamine by irradiation of active light rays, these are best suited for curing of an epoxy resin.

As a photobase generating agent, carbamic acid derivatives also can be used which are described in Journal of American Chemical Society, vol. 118, p. 12925 (1996), Polymer Journal, vol. 28, p. 795 (1996), and the like.

As a photobase generating agent to generate a base by irradiation of active light rays, usable are oxime derivatives such as 2,4-dimethoxy-1,2-diphenylethan-1-one, 1,2-octanedione, 1-[4-(phenylthio)-, 2-(O-benzoyloxime)] and ethanone, 1-[9-ethyl-6-(2-methylbenzoyl)-9H-carbazole-3-yl]-, 1-(O-acetyloxime), and commercially available optical radical generating agents such as 2-benzyl-2-dimethylamino-1-(4-morpholinophenyl)-butanone-1,2,2-dimethoxy-1,2-diphenylethan-l-one, 2-methyl-1-(4-(methylthio)phenyl)-2-morpholinopropan-1-one, 2-benzyl-2-dimethylamino-1-(4-morpholinophenyl)-butanone-1, hexaarylbisimidazole derivatives (a substituent such as a halogen, an alkoxy group, a nitro group and a cyano group is substituted with a phenyl group), benzoisooxazolone derivatives, and the like.

As the photobase generating agent, a compound may be used in which a group to generate a base is introduced to the main chain and/or the side chain of the polymer. The weight-average molecular weight in this case is preferably 1,000 to 10,000, and more preferably 5,000 to 30,000, from the viewpoint of the adhesivity, the fluidity and the heat resistance as an adhesive.

The photobase generating agent described above is very excellent in the storage stability at room temperature because it exhibits no reactivity with an epoxy resin in the state that no radiation is irradiated at room temperature.

In the first to third photosensitive adhesive compositions, (E) a thermal radical generating agent can be used

as required. (E) The thermal radical generating agent is preferably an organic peroxide. The organic peroxide preferably has a one-minute half-life temperature of 120°C or higher, and more preferably 150°C or higher. An organic peroxide is selected in consideration of the preparation condition of a photosensitive adhesive composition, the film formation temperature, the curing (pasting) condition, other process conditions, the storage stability, and the like. Peroxides usable are not especially limited, but examples thereof include 2,5-dimethyl-2,5-di(t-butylperoxyhexane), dicumyl peroxide, t-butylperoxy-2-ethyl hexanoate, t-hexylperoxy-2-ethyl hexanoate, 1,1-bis(t-butylperoxy)-3,3,5-trimethylcyclohexane, 1,1-bis(t-hexylperoxy)-3,3,5-trimethylcyclohexane and bis(4-t-butylcyclohexyl)peroxydicarbonate, and these may be used singly or as a blend of two or more thereof.

Examples of (E) thermal radical generating agents commercially available include Perhexa 25B (made by NOF Corp.), 2,5-dimethyl-2,5-di(t-butylperoxyhexane)(one-minute half-life temperature: 180°C), Percumyl D (made by NOF Corp.) and dicumyl peroxide (one-minute half-life temperature: 175°C).

The addition amount of (E) a thermal radical generating agent is preferably 0.01 to 20% by weight, more preferably 0.1 to 10% by weight, and most preferably 0.5 to 5% by weight, with respect to the total weight of compounds having an ethylenically unsaturated group. If the addition amount is less than 0.01% by weight, the curability decreases, and the effect of the addition decreases; and if that exceeds 5% by weight, the amount of outgas increases, and the preservation stability decreases.

In the first to third photosensitive adhesive compositions, a sensitizer can be concurrently used as required. Examples of the sensitizer include compounds containing camphor quinone, benzyl, diacetyl, benzyl dimethyl ketal, benzyl diethyl ketal, benzyl di(2-methoxyethyl) ketal, 4,4'-dimethylbenzyl-dimethyl ketal, anthraquinone, 1-chloroanthraquinone, 2-chloroanthraquinone, 1,2-benzanthraquinone, 1-hydroxyanthraquinone, 1-methylanthraquinone, 2-ethylanthraquinone, 1-bromoanthraquinone, thioxanthone, 2-isopropylthioxanthone, 2-nitrothioxanthone, 2-methylthioxanthone, 2,4-dimethylthioxanthone, 2,4-diethylthioxanthone, 2,4-diisopropylthioxanthone, 2-chloro-7-trifluoromethylthioxanthone and thioxanthone-10,10-dioxide, thioxanthone-10-oxide, benzoin methyl ether, benzoin ethyl ether, isopropyl ether, benzoin isobutyl ether, benzophenone, bis(4-dimethylaminophenyl) ketone, 4,4'-bisdiethylaminobenzophenone, or an azido group. These may be used singly or concurrently in two or more thereof.

To the first to third photosensitive adhesive compositions, in order to impart the preservation stability, the process adaptability or the oxidation preventability, a polymerization inhibitor or an antioxidant such as quinones, polyhydric phenols, phenols, phosphites and sulfurs may be further added in the range not damaging the curability.

The photosensitive adhesive compositions may further contain fillers suitably. Examples of the fillers include metal fillers such as silver powder, gold powder, copper powder and nickel powder, inorganic fillers such as alumina, aluminum hydroxide, magnesium hydroxide, calcium carbonate, magnesium carbonate, calcium silicate, magnesium silicate, calcium oxide, magnesium oxide, aluminum oxide, aluminum nitride, crystalline silica, amorphous silica, boron nitride, titania, glass, iron oxide and ceramics, and organic fillers such as carbon and rubbery fillers, and these can be used with no special limitation irrespective of types, shapes and the like.

The fillers can be used segregatedly according to desired functions. For example, metal fillers are added in order to impart the electroconductivity, the thermal conductivity, the thixotropy and the like to a resin composition; non-metal inorganic fillers are added in order to impart the thermal conductivity, the low thermal expansion, the low hygroscopicity and the like to an adhesive layer; and organic fillers are added in order to impart the toughness and the like to an adhesive layer.

These metal fillers, inorganic fillers or organic fillers may be used singly or in combination of two or more thereof. Above all, metal fillers, inorganic fillers or insulative fillers are preferable in that the electroconductivity, the thermal conductivity, the low hygroscopic characteristic, the insulation property and the like, which are required for adhesive materials for semiconductor devices, can be imparted, and among inorganic fillers or insulative fillers, silica filler is more preferable in that the dispersibility to a resin vanish is good, and a high hot adhesive force can be imparted.

The filler preferably has an average particle diameter of 10 $\mu$m or less, and a maximum particle diameter of 30 $\mu$m or less, and more preferably an average particle diameter of 5 $\mu$m or less, and a maximum particle diameter of 20 $\mu$m or less. If the average particle diameter exceeds 10 $\mu$m and the maximum particle diameter exceeds 30 $\mu$m, the effect of a sufficient improvement in the fracture toughness is unlikely to be obtained. The lower limits of the average particle diameter and the maximum particle diameter have no limitation, but both are usually 0.001 $\mu$m.

The content of the filler is determined according to characteristics and functions imparted, but is preferably 0 to 50% by mass, more preferably 1 to 40% by mass, and still more preferably 3 to 30% by mass, with respect to the total of the resin components and the fillers. Increasing the amount of fillers can achieve a higher elastic modulus, and can effectively improve the dicing property (cutting property by a dicer blade), the wire bonding property (ultrasonic efficiency), and the hot adhesive strength.

Since if the amount of fillers is increased more than necessary, the thermocompression bondability and the pattern formability are likely to be damaged, the content of the fillers are preferably set in the range described above. The optimum filler content is determined so that required characteristics are balanced. The blending and kneading when fillers are used can be carried out in a suitable combination of common dispersing machines such as a stirrer, a grinder,

a three-roll and a ball mill.

To the photosensitive adhesive compositions, in order to improve the interfacial bond between unlike materials, various types of coupling agents may be added. Examples of the coupling agents include a silane type, a titanium type and an aluminum type; above all, silane-based coupling agents are preferable from the viewpoint of a high effect, and compounds having a thermosetting group such as an epoxy group and a radiation-polymerizable group such as a methacrylate and/or an acrylate are more preferable. The boiling point and/or the decomposition temperature of the silane-based coupling agent is preferably 150°C or higher, more preferably 180°C or higher, and still more preferably 200°C or higher. That is, silane-based coupling agents are most preferably used which have the boiling point and/or the decomposition temperature of 200°C or higher and have a thermosetting group such as an epoxy group and a radiation-polymerizable group such as a methacrylate and/or an acrylate. The use amount of the coupling agent is preferably 0.01 to 20 parts by mass with respect to 100 parts by mass of an (A) component to be used from aspects of the effect, the heat resistance and the cost.

To the photosensitive adhesive compositions, in order to absorb ionic impurities to improve the insulation reliability during moisture absorption, an ion capturing agent may be added further. Such an ion capturing agent is not especially limited, but examples thereof include compounds known as copper inhibitors to prevent copper from being ionized and eluting, such as triazinethiol compounds and phenolic reducing agents, and powdery inorganic compounds such as bismuth-, antimony-, magnesium-, aluminum-, zirconium-, calcium-, titanium- and tin-based ones, and mixtures thereof. Specific examples thereof are not especially limited, but include inorganic ion capturing agents made by Toagosei Co., Ltd., such as, in trade names, IXE-300 (antimony-based), IXE-500 (bismuth-based), IXE-600 (antimonybismuth mixture-based), IXE-700 (magnesium-aluminum mixture-based), IXE-800 (zirconium-based) and IXE-1100 (calcium-based). These may be used singly or as a blend of two or more thereof. The use amount of the ion capturing agent is preferably 0.01 to 10 parts by mass with respect to 100 parts by mass of the (A) component from the viewpoint of the addition effect, the heat resistance and the cost.

A film adhesive can be obtained by forming the first to third photosensitive adhesive compositions into a film form. Figure 1 is an end view showing one embodiment of the film adhesive according to the present invention. The film adhesive 1 shown in Figure 1 is one obtained by forming the photosensitive adhesive composition into a film form.

A film adhesive 1 is formed into a film form, for example, by applying and drying the photosensitive adhesive composition on a substrate 3 shown in Figure 2. In such a way, an adhesive sheet 100 is obtained which has the substrate 3, and an adhesive layer 1 composed of the film adhesive formed on the substrate 3. Figure 2 is an end view showing one embodiment of the adhesive sheet 100 according to the present invention. The adhesive sheet 100 shown in Figure 2 is constituted of the substrate 3, and the adhesive layer 1 composed of the film adhesive provided on one surface of the substrate 3.

Figure 3 is an end view showing one embodiment of the adhesive sheet according to the present invention. An adhesive sheet 100 shown in Figure 3 is constituted of a substrate 3, an adhesive layer 1 composed of a film adhesive provided on one surface of the substrate 3, and a cover film 2.

The film adhesive 1 can be obtained by a method in which an (A) component, a (B) component, a (C) component and a (D) component, and as required, other components added are blended in an organic solvent; the blended solution is kneaded to prepare a vanish; the vanish is applied onto the substrate 3 to form a vanish layer; the vanish layer is dried by heating; and thereafter, the substrate 3 is removed. At this time, the film adhesive 1 may be preserved or used in the state of being the adhesive sheet 100 without removing the substrate 3.

The organic solvent used in preparation of the vanish, that is, a vanish solvent, is not especially limited as long as being capable of homogeneously dissolving or dispersing the materials. Examples thereof include dimethylformamide, toluene, benzene, xylene, methyl ethyl ketone, tetrahydrofuran, ethyl cellosolve, ethyl cellosolve acetate, dioxane, cyclohexanone, ethyl acetate and N-methyl-pyrrolidinone.

The blending and kneading can be carried out in a suitable combination of common dispersing machines such as a stirrer, a grinder, a three-roll and a ball mill. The drying by heating is carried out at a temperature at which the (B) component does not sufficiently react, and under the condition where the solvent sufficiently volatilizes. The "temperature at which the (B) component does not sufficiently react" is specifically a temperature lower than a peak temperature of the reaction heat in DSC using a DSC (for example, "DSC-7 model" (trade name), made by PerkinElmer Inc.) as measured under the conditions of a sample amount of 10 mg, a temperature-rise rate of 5°C/min, and a measurement atmosphere of air. Specifically, the vanish layer is dried usually by heating it at 60 to 180°C for 0.1 to 90 min. A preferable thickness of the vanish layer before the drying is 1 to 200 μm. If the thickness is less than 1 μm, the adhesive fixing function is likely to become insufficient; and if the thickness exceeds 200 μm, a remaining volatile content described later is likely to become much.

A preferable remaining volatile content of a vanish layer obtained is 10% by mass or less. If the remaining volatile content exceeds 10% by mass, due to foaming due to solvent volatilization in assembling heating, voids are liable to remain inside the adhesive layer, and the moisture resistance is likely to become insufficient. Further, due to volatile components generated in heating, the possibility that peripheral materials or members are contaminated is likely

to become high. Here, the measurement condition of the remaining volatile components is as follows. That is, for a film adhesive 1 cut into a size of 50 mm x 50 mm, the initial mass is denoted as M1, and the mass after the film adhesive 1 is heated in an oven at 160°C for 3 hours is denoted as M2, and the remaining volatile content (%) is determined by the following expression.

$$\text{Expression: Remaining volatile content (\%)} = [(M2 - M1)/M1] \times 100$$

The substrate 3 is not especially limited as long as being capable of withstanding the above-mentioned drying condition. Examples usable as the substrate 3 are polyester film, polypropylene film, polyethylene terephthalate film, polyimide film, polyetherimide film, polyether naphthalate film and methylpentene film. The film as the substrate 3 may be a multilayer film in combination of two or more thereof, and may be one whose surface has been treated with a silicone-, silica- or another-based release agent, or the like.

A film adhesive 1 and a dicing sheet may be laminated to make an adhesive sheet. The dicing sheet is a sheet in which a sticky adhesive layer is provided on a substrate, and the sticky adhesive layer may be either of a pressure sensitive type and a radiation curing type. The substrate is preferably an expandable one. By making such an adhesive sheet, a dicing/die bond-integrated adhesive sheet having both a function as a die bond film and a function as a dicing sheet together is obtained.

The dicing/die bond-integrated adhesive sheet specifically includes an adhesive sheet 100, as shown in Figure 4, in which a substrate 3, a sticky adhesive layer 6 and a film adhesive (adhesive layer) 1 are laminated in this order.

Figure 5 is a top view showing one embodiment of the semiconductor wafer with an adhesive layer according to the present invention, and Figure 6 is an end view taken along the line IV-IV of Figure 5. The semiconductor wafer with an adhesive layer 20 has a semiconductor wafer 8 and a film adhesive (adhesive layer) 1 provided on one surface of the semiconductor wafer 8.

The semiconductor wafer with an adhesive layer 20 can be obtained by laminating the film adhesive 1 on the semiconductor wafer 8 while the film adhesive 1 is being heated. The film adhesive 1 can be pasted on the semiconductor wafer 8 at a low temperature of about room temperature (25°C) to 150°C.

Figure 7 and Figure 9 are each a top view showing one embodiment of the adhesive pattern according to the present invention. Figure 8 is an end view taken along the line V-V of Figure 7, and Figure 10 is an end view taken along the line VI-VI of Figure 9. Adhesive patterns 1a shown in Figures 7, 8, 9 and 10 are formed so as to have a pattern along nearly square sides or a square pattern on a semiconductor wafer 8 as an adherend.

The adhesive pattern 1a is formed by laminating an adhesive layer 1 on the semiconductor wafer 8 as an adherend to obtain a semiconductor wafer with an adhesive layer 20, exposing the adhesive layer 1 through a photomask, and subjecting the adhesive layer 1 after the exposure to a development treatment with an alkali developing solution. Thereby, a semiconductor wafer with an adhesive layer 20 in which the adhesive pattern 1a is formed is obtained.

Hereinafter, a semiconductor device manufactured using the film adhesive according to the present invention will be described specifically using drawings. Semiconductor devices of various structures have recently been proposed, and applications of the film adhesive according to the present invention is not limited to a semiconductor device of a structure described hereinafter.

Figure 11 is an end view showing one embodiment of the semiconductor device according to the present invention. In the semiconductor device 200 shown in Figure 11, a semiconductor element 12 is adhered to a support member for mounting a semiconductor element 13 through a film adhesive 1; connection terminals (not shown in figure) of the semiconductor element 12 are electrically connected to external connection terminals (not shown in figure) through wires 14, and are sealed with a sealing material 15.

Figure 12 is an end view showing one other embodiment of the semiconductor device according to the present invention. In the semiconductor device 200 shown in Figure 12, a semiconductor element 12a on the first stage is adhered to a support member for mounting a semiconductor element 13 on which terminals 16 are formed, through a film adhesive 1; and a semiconductor element 12b on the second stage is further adhered on the semiconductor element 12a on the first stage through a film adhesive 1. Connection terminals (not shown in figure) of the semiconductor element 12a on the first stage and the semiconductor element 12b on the second stage are electrically connected to external connection terminals through wires 14, and sealed with a sealing material. In such a way, the film adhesive according to the present invention can suitably been used also for a semiconductor device having a structure in which a plurality of semiconductor elements are stacked.

The semiconductor devices (semiconductor packages) shown in Figure 11 and Figure 12 can be obtained, for example, by dicing the semiconductor wafer with an adhesive layer 20 shown in Figure 9 along a dashed line D, thermocompression bonding the semiconductor element with an adhesive layer after the dicing to the support member for mounting a semiconductor element 13 to adhere the both, and thereafter subjecting the resultant to a wire bonding

step, and as required, to a sealing step using a sealing material and other steps. The heating temperature in the thermocompression bonding is usually 20 to 250°C; the load is usually 0.01 to 20 kgf; and the heating time is usually 0.1 to 300 sec.

As another embodiment of the semiconductor device according to the present invention, there is one as shown in Figure 18. Hereinafter, a method for manufacturing a semiconductor device shown in Figure 18 will be described in detail using drawings. Figures 13, 14 and 16 to 19 are end views showing one embodiment of a manufacturing method of the semiconductor device according to the present invention, and Figure 15 is a top view showing one embodiment of the manufacturing method of the semiconductor device according to the present invention.

The manufacturing method of the semiconductor device according to the present embodiment comprises the following (Step 1) to (Step 7).

(Step 1): A step of laminating a film adhesive (adhesive layer) 1 on a circuit surface 18 of semiconductor chips (semiconductor elements) 12 formed in a semiconductor wafer 8 (Figures 13(a) and (b)).

(Step 2): A step of patterning the adhesive layer 1 provided on the circuit surface 18 of the semiconductor chips 12 by exposure and development (Figure 13(c) and Figure 14(a)).

(Step 3): A step of polishing the semiconductor wafer 8 from the surface thereof on the opposite side to the circuit surface 18 to make the semiconductor wafer 8 thin (Figure 14(b)).

(Step 4): A step of dicing the semiconductor wafer 8 to cut and divide the wafer into a plurality of semiconductor chips 12 (Figure 14(c) and Figure 16(a)).

(Step 5): A step of picking up the semiconductor chips 12 and mounting them on a platy support member for a semiconductor device (support member for mounting a semiconductor element) 13 (Figure 16(b) and Figure 17(a)).

(Step 6): A step of laminating a second-layer semiconductor chip 12b on the adhesive layer 1 which has been patterned on the circuit surface 18 of a semiconductor chip 12a mounted on the support member 13 (Figure 17(b)).

(Step 7): A step of connecting the semiconductor chip 12a and the semiconductor chip 12b to respective external connection terminals (Figure 18).

Hereinafter, (Step 1) to (Step 7) will be described in detail.

(Step 1)

In a semiconductor wafer 8 shown in Figure 13(a), a plurality of semiconductor chips 12 segmented by dicing lines D are formed. A film adhesive (adhesive layer) 1 is laminated on the surface of the circuit surface 18 side of the semiconductor chips 12 (Figure 13(b)). As a method for laminating the adhesive layer 1, a method is simple in which a film adhesive previously formed into a film form is prepared and the film adhesive is pasted on the semiconductor wafer 8, but a method may be used in which a vanish of a liquid photosensitive adhesive composition is applied on the semiconductor wafer 8 by a spin coat method or the like, and heat dried.

(Step 2)

The adhesive layer 1 is a negative-type photosensitive adhesive having an adhesivity to an adherend after patterning by exposure and development, and capable of being alkali developed. In more detail, a resist pattern (adhesive pattern) formed by patterning the adhesive layer 1 by exposure and development has an adhesivity to adherends such as semiconductor chips and support members. For example, an adhesive pattern and an adherend can be adhered by compression-bonding the adherend to the adhesive pattern, as required, under heating.

The adhesive layer 1 laminated on the semiconductor wafer 8 is irradiated with active light rays (typically ultraviolet rays) through a mask 4 in which openings are formed at predetermined positions (Figure 13(c)). Thereby, the adhesive layer 1 is exposed in a predetermined pattern.

After the exposure, by removing unexposed portions in the adhesive layer 1 by development using an alkali developing solution, the adhesive layer 1 is patterned so that openings 11 are formed (Figure 14(a)). A positive-type photosensitive adhesive composition can be used in place of a negative-type, and in this case, exposed portions in the adhesive layer 1 are removed by development.

Figure 15 is a top view showing a state that the adhesive layer 1 is patterned. Bonding pads of semiconductor chips 12 are exposed in the openings 11. That is, the patterned adhesive layer 1 is a buffer coat film of the semiconductor chips 12. The rectangular openings 11 are formed side by side in a plural number on each of the semiconductor chips 12. The shape, arrangement and number of the openings 11 are not limited to the mode of the present embodiment, and can suitably be modified so that predetermined portions such as bonding pads are exposed. Here, an end view taken along the line II-II in Figure 15 is Figure 14.

(Step 3)

After the patterning, the surface of the semiconductor wafer 8 on the opposite side to the adhesive layer 1 is polished to make the semiconductor wafer 8 thin to a predetermined thickness (Figure 14(b)). The polishing is carried out, for example, by pasting a sticky adhesive film on the adhesive layer 1, and fixing the semiconductor wafer 8 on a polishing jig with the sticky adhesive film.

(Step 4)

After the polishing, a composite film 5 having a die bonding material 30 and a dicing tape 40 laminated to each other is pasted on the surface of the semiconductor wafer 8 on the opposite side to the adhesive layer 1 so that the die bonding material 30 contacts with the semiconductor wafer 8. The pasting is carried out, as required, under heating.

Then, the semiconductor wafer 8 is cut together with the adhesive layer 1 and the composite film 5 along the dicing lines D. Thereby, a plurality of semiconductor chips 12 each having the adhesive layer 1 and the composite film are obtained (Figure 16(a)). The dicing is carried out, for example, by using a dicing blade in the state that the whole system is fixed to a frame with the dicing tape 40.

(Step 5)

After the dicing, the cut and divided semiconductor chips 12 are each picked up together with the adhesive layer 1 and the die bonding material 30 (Figure 16(b)), and mounted on a support member 13 through the die bonding material 30 (Figure 17(a)).

(Step 6)

On the adhesive layer 1 on the semiconductor chip 12a mounted on the support member 13, a second-layer semiconductor chip 12b is laminated (Figure 17(b)). That is, the semiconductor chip 12a and the semiconductor chip 12b located on the upper layer thereof are adhered through the patterned adhesive layer 1 (buffer coat film) present between the chips. The semiconductor chip 12b is adhered to a location not closing the openings 11 in the patterned adhesive layer 1. A patterned adhesive layer 1 (buffer coat film) is formed also on the circuit surface 18 of the semiconductor chip 12b.

The adhering of the semiconductor chip 12b is carried out, for example, by a thermocompression bonding method under heating to a temperature at which the adhesive layer 1 develops fluidity. After the thermocompression bonding, as required, the adhesive layer 1 is heated further to advance curing.

(Step 7)

Thereafter, the semiconductor chip 12a is connected to external connection terminals on the support member 13 through wires 14a connected to bonding pads of the semiconductor chip 12a; and the semiconductor chip 12b is connected to external connection terminals on the support member 13 through wires 14b connected to bonding pads of the semiconductor chip 12b. Then, by sealing a laminate containing the semiconductor chip 12a and the semiconductor chip 12b with a sealing material 15, a semiconductor device 200 is obtained (Figure 18).

The method for manufacturing the semiconductor device according to the present invention is not limited to the above-mentioned embodiment, and suitable changes and modifications may be made without departing from the gist of the present invention. For example, the order of (Step 1) to (Step 7) can be exchanged suitably. As shown in Figure 19, the dicing may be carried out after the semiconductor wafer 8 having the adhesive layer 1 formed thereon is made thin by polishing. In this case, after the dicing, by patterning the adhesive layer 1 by exposure and development, a laminate similar to that in Figure 16(a) can be obtained. After the semiconductor wafer is made thin by polishing, and the dicing is carried out, the pasting and the exposure and development of the film adhesive 1 may be carried out. Additionally, semiconductor chips 12 of three or more layers may be laminated. In this case, at least one set of adjacent semiconductor chips is directly adhered to each other through a patterned adhesive layer 1 (buffer coat film on the lower layer side).

Figure 20 is an end view showing one other embodiment of the semiconductor device according to the present invention. The semiconductor device 200 shown in Figure 20 has a support member (first adherend) 13 having connection terminals (first connection parts, not shown in figure), a semiconductor chip (second adherend) 12 having connection electrode parts (second connection parts, not shown in figure), an adhesive layer 1 composed of an insulative material, and electroconductive layers 9 composed of an electroconductive material. The support member 13 has a circuit surface 18 opposing to the semiconductor chip 12, and is arranged with a predetermined interval from the semiconductor chip

12. The adhesive layer 1 is contacted with and formed between the support member 13 and the semiconductor chip 12, and has a predetermined pattern. The electroconductive layers 9 are formed in portions where the adhesive layer 1 is not disposed between the support member 13 and the semiconductor chip 12. The connection electrode parts of the semiconductor chip 12 are electrically connected to connection terminals of the support member 13 through the electroconductive layers 9.

Hereinafter, a method for manufacturing the semiconductor device shown in Figure 20 will be described in detail using Figure 21 to Figure 25. Figure 21 to Figure 25 are end views showing one embodiment of the manufacturing method of the semiconductor device according to the present invention. The manufacturing method of the semiconductor device according to the present embodiment has the following (a first step) to (a fourth step).

(A first step): A step of providing an adhesive layer 1 on a support member 13 having connection terminals (Figure 21 and Figure 22).

(A second step): A step of patterning an adhesive layer 1 so that openings 11 to expose the connection terminals are formed by exposure and development (Figure 23 and Figure 24).

(A third step): A step of filling an electroconductive material in the openings 11 to form electroconductive layers 9 (Figure 25).

(A fourth step): A step of adhering the semiconductor chips 12 having connection electrode portions to the adhesive layer 1 side of a laminate of the support member 13 and the adhesive layer 1, and electrically connecting the connection terminals of the support member 13 and the connection electrode portions of the semiconductor chips 12 through the electroconductive layers 9 (Figure 20).

Hereinafter, (a first step) to (a fourth step) will be described in detail.

(A first step)

On the circuit surface 18 of a support member 13 shown in Figure 21, an adhesive layer 1 is laminated (Figure 22). As a lamination method, a method is simple in which a film adhesive previously formed into a film form is prepared and the film adhesive is pasted on the support member 13, but the lamination may be carried out by a method in which a liquid vanish containing a photosensitive adhesive composition is applied on the support member 13 by a spin coat method or the like, and heat dried.

The photosensitive adhesive composition is a negative-type photosensitive adhesive having an adhesivity to an adherend after patterning by exposure and development, and capable of being alkali developed. In more detail, a resist pattern formed by patterning the photosensitive adhesive by exposure and development has an adhesivity to adherends such as semiconductor chips and substrates. For example, a resist pattern and an adherend can be adhered by compression-bonding the adherend to the resist pattern, as required, under heating.

(A second step)

The adhesive layer 1 provided on the support member 13 is irradiated with active light rays (typically ultraviolet rays) through a mask 4 in which openings are formed at predetermined positions (Figure 23). Thereby, the adhesive layer 1 is exposed in a predetermined pattern.

After the exposure, by removing unexposed portions in the adhesive layer 1 by development using an alkali developing solution, the adhesive layer 1 is patterned so that openings 11 to expose connection terminals of the support member 13 are formed (Figure 24). A positive-type photosensitive adhesive can be used in place of a negative-type, and in this case, exposed portions in the adhesive layer 1 are removed by development.

(A third step)

An electroconductive material is filled in the openings 11 of the obtained resist pattern to form electroconductive layers 9 (Figure 25). As a filling method of an electroconductive material, various types of methods can be employed, such as gravure printing, pressing-in by a roll and filling under reduced pressure. The electroconductive material used here includes electrode materials composed of metals or metal oxides such as solder, gold, silver, nickel, copper, platinum, palladium or ruthenium oxide, bumps of metals described above, and additionally for example, materials containing at least an electroconductive particle and a resin component. Electroconductive particles to be used are ones such as metals or metal oxides, for example, gold, silver, nickel, copper, platinum, palladium or ruthenium oxide or an organic metal compound. Resin components to be used are, for example, the above-mentioned curable resin compositions of epoxy resins and curing agents thereof.

(A fourth step)

Semiconductor chips 12 are directly adhered to the adhesive layer 1 of the support member 13. Connection electrode parts of the semiconductor chips 12 are electrically connected to connection terminals of the support member 13 through the electroconductive layers 9. A patterned adhesive layer (buffer coat film) may be formed on the circuit surface of the semiconductor chip 12 on the opposite side to the adhesive layer 1.

The adhering of the semiconductor chip 12 is carried out, for example, by thermocompression-bonding the semiconductor chip 12 while the adhesive layer 1 (photosensitive adhesive composition) is being heated to a temperature at which the adhesive layer 1 develops fluidity. After the thermocompression bonding, as required, the adhesive layer 1 is heated to further advance the curing.

A rear surface protection film is preferably pasted on the circuit surface (rear surface) of the semiconductor chip 12 on the opposite side to the adhesive layer 1.

According to the method described hitherto, the semiconductor device 200 shown in Figure 20 is obtained. The manufacturing method of the semiconductor device according to the present invention is not limited to the embodiment described hitherto, and suitable changes and modifications may be made without departing the gist of the present invention.

For example, the adhesive layer 1 is not limited to being provided first on the support member 13, and may be provided first on the semiconductor chip 12. In this case, a manufacturing method of the semiconductor device comprises, for example, a first step of providing an adhesive layer 1 on a semiconductor chip 12 having connection electrode parts, a second step of patterning the adhesive layer 1 by exposure and development so that openings 11 to expose the connection electrode parts are formed, a third step of filling an electroconductive material in the openings 11 to form electroconductive layers 9, and a fourth step of adhering a support member 13 having connection terminals directly to the adhesive layer 1 of a laminate of the semiconductor chip 12 and the adhesive layer 1, and electrically connecting the connection terminals of the support member 13 and the connection electrode parts of the semiconductor chip 12 through the electroconductive layers 9.

In the above-mentioned manufacturing method, since connection is one between a segmented support member 13 and a segmented semiconductor chip 12, the method is preferable from the viewpoint of easiness of connection of the connection terminals on the support member 13 and the connection electrode parts on the semiconductor chip 12.

The adhesive layer 1 may be provided first on a semiconductor wafer constituted of a plurality of semiconductor chips 12. In this case, a manufacturing method of the semiconductor device comprises, for example, a first step of providing an adhesive layer 1 on a semiconductor wafer constituted of a plurality of semiconductor chips 12 having connection electrode parts, a second step of patterning the adhesive layer 1 by exposure and development so that openings 11 to expose the connection electrode parts are formed, a third step of filling an electroconductive material in the openings 11 to form electroconductive layers 9, a fourth step of adhering a support member 13 (a support member having nearly the same size as the semiconductor wafer) having connection terminals directly to the adhesive layer 1 side of a laminate of the semiconductor wafer and the adhesive layer 1, and electrically connecting the connection terminals of the support member 13 and the connection electrode parts of the semiconductor chips 12 constituting the semiconductor wafer through the electroconductive layers 9, and a fifth step of cutting and dividing (dicing) a laminate of the semiconductor wafer, the adhesive layer 1 and the support member 13 into every semiconductor chip 12.

The above-mentioned manufacturing method may be carried out as follows: in the first step, an adhesive layer 1 is provided on a support member 13 of a wafer size; in the fourth step, a semiconductor wafer is adhered directly on the adhesive layer 1 side of a laminate of the support member 13 and the adhesive layer 1, and connection terminals of the support member 13 and connection electrode parts of semiconductor chips 12 constituting the semiconductor wafer are electrically connected through electroconductive layers 9; and in the fifth step, a laminate of the semiconductor wafer, the adhesive layer 1 and the support member 13 is cut and divided into every semiconductor chip 12.

The above-mentioned manufacturing method, since being capable of carrying out the steps up to the connection of the semiconductor wafer and the support member 13 (including up to the fourth step) in a wafer size, is preferable from the viewpoint of the working efficiency. A rear surface protection film is preferably pasted on the circuit surface (rear surface) of the semiconductor wafer on the opposite side of the adhesive layer 1.

Another manufacturing method of the semiconductor device comprises a first step of providing an adhesive layer 1 on a semiconductor wafer constituted of a plurality of semiconductor chips 12 having connection electrode portions, a second step of patterning the adhesive layer 1 by exposure and development so that openings 11 to expose connection electrode parts are formed, a third step of filling an electroconductive material in the openings to form electroconductive layers 9, a fourth step of cutting and dividing (dicing) a laminate of the semiconductor wafer and the adhesive layer 1 into every semiconductor chip 12, and a fifth step of adhering a support member 13 having connection terminals directly to the adhesive layer 1 side of the segmented laminate of the semiconductor chip 12 and the adhesive layer 1, and electrically connecting connection terminals of the support member 13 and connection electrode parts of the semiconductor chip 12 through the electroconductive layers 9.

The above-mentioned manufacturing method may be carried out as follows: in the first step, an adhesive layer 1 is provided on a support member 13 of a wafer size; in the fourth step, a laminate of the support member 13 of a wafer size and the adhesive layer 1 is cut and divided into every semiconductor chip 12; and in the fifth step, the semiconductor chip 12 is adhered directly on the adhesive layer 1 side of a segmented laminate of the support member 13 and the adhesive layer 1, and connection terminals of the support member 13 and connection electrode parts of the semiconductor chip 12 are electrically connected through the electroconductive layers 9.
The above-mentioned manufacturing method is preferable because the method can carry out the steps from the formation of the adhesive layer 1 up to the filling of the electroconductive material (up to the third step) in a wafer size, and the dicing step (the fourth step) can be smoothly carried out.
By using a film adhesive, a semiconductor device (semiconductor laminate) can be constituted by adhering semiconductor wafers or semiconductor chips. Through-electrodes may be formed in the laminate.
In this case, a manufacturing method of the semiconductor device comprises, for example, a first step of providing an adhesive layer 1 composed of a photosensitive adhesive on a first semiconductor chip 12 having connection electrode parts of through-electrodes, a second step of patterning the adhesive layer 1 by exposure and development so that openings 11 to expose the connection electrode parts are formed, a third step of filling an electroconductive material in the openings 11 to form through-electrode connections, and a fourth step of adhering a second semiconductor chip 12 having connection electrode parts directly to the adhesive layer 1 of a laminate of the first semiconductor chip 12 and the adhesive layer 1, and electrically connecting connection electrode parts of the first and second semiconductor chips 12 through the electroconductive layers 9. In the manufacturing method, a semiconductor wafer may be used in place of semiconductor chips.
The semiconductor device according to the present invention may be a solid-state image pick-up device as shown in Figure 26. Figure 26 is an end view showing one embodiment of the semiconductor device according to the present invention. The semiconductor device (solid-state image pick-up device) 200 shown in Figure 26 comprises a glass substrate 7, a semiconductor chip 12, an adhesive layer 1 and an effective pixel region 17. The glass substrate 7 and the semiconductor chip 12 are adhered through the patterned adhesive layer 1, and the effective pixel region 17 is formed on the surface of the semiconductor chip 12 on a support member 13 side.
Hereinafter, a method for manufacturing the semiconductor device shown in Figure 26 will be described in detail using Figures 27 to 33. Figures 27 to 33 are end views or plan views showing one embodiment of the manufacturing method of the semiconductor device according to the present invention. The manufacturing method of the semiconductor device according to the present embodiment comprises the following (a first step) to (a fourth step).

(Step 1): A step of providing an adhesive layer 1 composed of the photosensitive adhesive composition according to the present invention on a front surface 7a of a glass substrate 7 having the front surface (first principal surface) 7a and a rear surface (second principal surface) 7b opposing to each other (Figure 27 and Figure 28).
(Step 2): A step of exposing the adhesive layer 1 by light irradiation from the rear surface 7b side, and patterning the adhesive layer 1 by development (Figure 29 to Figure 31).
(Step 3): A step of adhering a semiconductor element 12 directly to the patterned adhesive layer 1 so that the circuit surface of the semiconductor element 12 faces the glass substrate 7 side (Figure 32).
(Step 4): A step of dicing the glass substrate 7 and the semiconductor element 12 adhered to each other to cut and divide them into a plurality of semiconductor devices 200 (Figure 33).

Hereinafter, (Step 1) to (Step 4) will be described in detail.

(Step 1)

On the front surface 7a of a glass substrate 7 shown in Figure 27, an adhesive layer 1 composed of the photosensitive adhesive composition according to the present invention is provided (Figure 28). In the present embodiment, a method is simple in which a film adhesive obtained by previously forming the photosensitive adhesive composition according to the present invention into a film form is prepared, and the film adhesive is pasted on the glass substrate 7.
The adhesive layer 1 composed of the photosensitive adhesive composition according to the present invention can function as a negative-type photosensitive adhesive capable of being alkali developed, and can have a sufficient low-temperature thermocompression bondability to an adherend such as a semiconductor element and a glass substrate after patterning by exposure and development. For example, by compression-bonding an adherend to a resist pattern, as required, under heating, the resist pattern and the adherend can be adhered. The details of the photosensitive adhesive composition according to the present invention having such a function are as described before.

(Step 2)

A mask 4 in which openings are formed on predetermined locations is disposed on the rear surface 7b of the glass substrate 7, and the adhesive layer 1 provided on the front surface 7a of the glass substrate 7 is irradiated with active light rays (typically ultraviolet rays) from the rear surface 7b side through the mask 4 (Figure 29). Thereby, active light rays transmit the glass substrate 7 and are irradiated to the adhesive layer 1, and the photosetting of the adhesive layer 1 progresses and the adhesive layer 1 is exposed in a predetermined pattern.

After the exposure, the adhesive layer 1 is patterned by removing unexposed portions of the adhesive layer 1 by development using an alkali developing solution (Figure 30). The adhesive layer 1 has been formed so as to have a pattern along sides of a near square (Figure 31). A positive-type photosensitive adhesive can be used in place of a negative type, and in this case, exposed portions in the adhesive layer 1 are removed by development.

(Step 3)

A semiconductor element 12 is adhered directly to the adhesive layer 1 so that a plurality of effective pixel regions 17 provided on the circuit surface of the semiconductor element 12 are surrounded by the adhesive layer 1 formed as a pattern along sides of a near square, and the circuit surface of the semiconductor element 12 faces the glass substrate 7 side (figure 32). The adhesive layer 1 adheres the semiconductor element 12, and also functions as a spacer to secure spaces surrounding the effective pixel regions 17. The adhering of the semiconductor element 12 is carried out, for example, by a method of thermocompression bonding while the adhesive layer 1 is being heated to a temperature at which the adhesive layer 1 develops fluidity. After the thermocompression bonding, as required, the adhesive layer 1 is heated to further advance the curing.

After the semiconductor element 12 is adhered, a plurality of semiconductor devices 200 shown in Figure 26 are obtained by dicing along dashed lines D (Figure 33). In this case, the plurality of semiconductor devices 200 are obtained by pasting a dicing film on the surface of the semiconductor element 200 on the opposite side to the circuit surface thereof, and cutting the glass substrate 7 and the semiconductor element 12 together with the dicing film. The dicing is carried out, for example, by using a dicing blade in the state that the whole system is fixed to a frame by the dicing film.

The manufacturing method of the semiconductor device (solid-state image pick-up device) is not limited to the embodiment described hitherto, and suitable changes and modifications may be made without departing from the gist of the present invention.

The semiconductor device (solid-state image pick-up device) is used, for example, for manufacture of a CMOS sensor as shown in Figure 34. Figure 34 is an end view showing an example of a CMOS sensor using the semiconductor device shown in Figure 26 as a solid-state image pick-up device. In the CMOS sensor 300 shown in Figure 34, the semiconductor device 200 is electrically connected to connection terminals (not shown in figure) on a support member for mounting a semiconductor element 13 through a plurality of electroconductive bumps 32. In place of a constitution in which the semiconductor device 200 is adhered using the electroconductive bumps 32, the constitution may be one in which the semiconductor device 200 is connected to connection terminals on the support member for mounting a semiconductor element 13 through electroconductive wires.

The CMOS sensor 300 has a constitution in which a lens 38 provided so as to locate right above the effective pixel region 17 (on the opposite side to the semiconductor chip 12), a side wall 50 provided so as to internally contain the semiconductor device 200 together with the lens 38, and a fitting-in member 42 interposed between the lens 38 and the side wall 50 in the state that the lens 38 is fit in, are mounted on the support member for mounting a semiconductor element 13.

The CMOS sensor 300 is manufactured by connecting the semiconductor device manufactured by the method as described above to connection terminals on the support member for mounting a semiconductor element 13 through the electroconductive bumps 32 of the semiconductor chip 12, and forming the lens 38, the side wall 50 and the fitting-in member 42 on the support member for mounting a semiconductor element 13 so as to internally contain the semiconductor device 200.

Examples

Hereinafter, the present invention will be described in detail by way of Examples. However, the present invention is not limited to the following Examples.

Examples 1 to 7 and Comparative Examples 1 to 3

<(A) components: polyimide resins>

(PI-1)

1.89 g of 3,5-diaminobenzoic acid (molecular weight: 152.2)(hereinafter, abbreviated to "DABA"), 15.21 g of an aliphatic ether diamine ("D-400" (trade name) made by BASF AG, molecular weight: 452.4) and 0.39 g of 1,1,3,3-tetramethyl-1,3-bis(4-aminophenyl)disiloxane ("LP-7100" (trade name), made by Shin-Etsu Chemical Co., Ltd., molecular weight: 248.5) as diamines, and 116 g of NMP (N-methyl-2-pyrrolidone) as a solvent were charged in a flask equipped with a stirrer, a thermometer and a nitrogen replacing device (nitrogen inflow tube), and stirred to dissolve the diamines in the solvent.
While the flask was being cooled in an ice bath, 16.88 g of 4,4'-oxydiphthalic dianhydride (molecular weight: 326.3)(hereinafter, abbreviated to "ODPA") was added little by little in the solution in the flask. After the completion of the addition, the solution was stirred at room temperature (25°C) for 5 hours.
Thereafter, a reflux cooler with a moisture-receiving vessel was attached to the flask; 70 g of xylene was added thereto; and the solution was heated to 180°C and held at the temperature for 5 hours while nitrogen gas was being blown in, to azeotropically remove xylene with water. The obtained solution was cooled to room temperature, and thereafter charged in distilled water to reprecipitate a precipitate; and the precipitate was dried in a vacuum drier to obtain a polyimide resin (PI-1). The measurement of (PI-1) by GPC revealed that the weight-average molecular weight in terms of polystyrene was (Mw) = 33,000. Tg of (PI-1) was 55°C.

(PI-2)

20.5 g of 2,2-bis(4-(4-aminophenoxy)phenyl)propane (molecular weight: 410.5)(hereinafter, abbreviated to "BAPP") as a diamine, and 101 g of NMP as a solvent were charged in a flask equipped with a stirrer, a thermometer and a nitrogen replacing device (nitrogen inflow tube), and stirred to dissolve the diamine in the solvent.
While the flask was being cooled in an ice bath, 20.5 g of 1,2-(ethylene) bis(trimellitate anhydride)(molecular weight: 410.3)(hereinafter, abbreviated to "EBTA") was added little by little in the solution in the flask. After the completion of the addition, the solution was stirred at room temperature for 5 hours.
Thereafter, a reflux cooler with a moisture-receiving vessel was attached to the flask; 67 g of xylene was added thereto; and the solution was heated to 180°C and held at the temperature for 5 hours while nitrogen gas was being blown in, to azeotropically remove xylene with water. The obtained solution was cooled to room temperature, and thereafter charged in distilled water to reprecipitate a precipitate; and the precipitate was dried in a vacuum drier to obtain a polyimide resin (PI-2). The measurement of (PI-2) by GPC revealed that the weight-average molecular weight in terms of polystyrene was (Mw) = 98,000. Tg of (PI-2) was 180°C.

<Photosensitive adhesive compositions>

By using the polyimide resins (PI-1) and (PI-2) obtained as described above, each component was formulated in a compositional ratio (unit: parts by mass) indicated in Tables 1 and 2 shown below, and photosensitive adhesive compositions (vanishes for forming an adhesive layer) of Examples 1 to 7 and Comparative Examples 1 to 3 were obtained.
In Table 1, each abbreviation means the following.

EA-5222: ethoxylated bisphenol A diepoxy acrylate, made by Shi-Nakamura Chemical Co., Ltd., having a polymerization functional group equivalent weight of 380 g/eq
BPE-100: ethoxylated bisphenol A dimethacrylate, made by Shi-Nakamura Chemical Co., Ltd., having a polymerization functional group equivalent weight of 240 g/eq
BPE-500: ethoxylated bisphenol A dimethacrylate, made by Shi-Nakamura Chemical Co., Ltd., having a polymerization functional group equivalent weight of 565 g/eq
A-9300: isocyanuric acid EO-modified triacrylate, made by Shi-Nakamura Chemical Co., Ltd., having a polymerization functional group equivalent weight of 140 g/eq
UA-3110: isocyanuric acid-modified triacrylate, made by Shi-Nakamura Chemical Co., Ltd., having a polymerization functional group equivalent weight of 350 g/eq
UA-3300: isocyanuric acid-modified triacrylate, made by Shi-Nakamura Chemical Co., Ltd., having a polymerization functional group equivalent weight of 310 g/eq
UF-8001G: bifunctional urethane acrylate, made by Kyoueisha Chemical Co., Ltd., having a polymerization functional group equivalent weight of 2,250 g/eq
A-DPH: propoxylated dipentaerythritol hexaacrylate (hexafunctional aliphatic acrylate), made by Shi-Nakamura Chemical Co., Ltd., having a polymerization functional group equivalent weight of 95 g/eq

VG-3101: a trifunctional epoxy resin, made by Printec Co., Ltd.
YDF-8170C: bisphenol F bisglycidyl ether, made by Tohto Kasei Co., Ltd.
TrisP-PA: a trisphenol compound (α,α, α'-tris(4-hydroxyphenol)-1-ethyl-4-isopropylbenzene), made by Honshu Chemical Industry Co., Ltd.
R972: hydrophobic fumed silica (average particle diameter: about 16 nm), made by Nippon Aerosil Co., Ltd.
I-819: bis(2,4,6-trimethylbenzoyl)-phenylphosphine oxide, made by Ciba Speciality Chemicals Corp.
NMP: N-methyl-2-pyrrolidone, made by Kanto Chemical Co., Ltd.

[Table 1]

| | | | Examples | | | | | | |
|---|---|---|---|---|---|---|---|---|---|
| | | | 1 | 2 | 3 | 4 | 5 | 6 | 7 |
| (A) Polyimide Resin | | PI-1 | 100 | 100 | 100 | 100 | 100 | 100 | 100 |
| Curable Components | (C) Radiation-Polymerizable Compounds | EA-5222 | 80 | - | - | - | - | - | - |
| | | BPE-100 | - | - | 40 | - | - | 40 | - |
| | | BPE-500 | - | 80 | - | - | - | - | - |
| | | A-9300 | - | - | 40 | - | - | 40 | 40 |
| | | UA-3110 | - | - | - | - | 80 | - | 40 |
| | | UA-3330 | - | - | - | 80 | - | - | - |
| | | UF-8001G | - | - | - | - | - | 10 | - |
| | (B) Thermosetting Resins | VG-3101 | 5 | 5 | 5 | 5 | 5 | 5 | 5 |
| | | YDF-8170C | 10 | 10 | 10 | 10 | 10 | 10 | 10 |
| | Curing Agent | TrisP-PA | 5 | 5 | 5 | 5 | 5 | 5 | 5 |
| (D) Photoinitiator | | I-819 | 3 | 3 | 3 | 3 | 3 | 3 | 3 |
| Filler | | R-972 | 5 | 5 | 5 | 5 | 5 | 5 | 5 |
| Coating Solvent | | NMP | 220 | 220 | 220 | 224 | 213 | 210 | 210 |
| (C) Average Functional Group Equivalent Weight of (C) Component (g/eq) | | | 380 | 565 | 190 | 310 | 350 | 420 | 245 |
| Lowest Melt Viscosity (Pa·s) | | | 10000 | 3000 | 18000 | 15000 | 4000 | 10000 | 7000 |
| Low-Temperature Pastability | | | A | A | A | A | A | A | A |
| Pattern Formability | | | A | A | A | A | A | A | A |
| Low-Temperature Thermocompression Bondability | | | A | A | A | A | A | A | A |
| High-Temperature Adhesivity (MPa) | | | 0.13 | 0.10 | 0.60 | 0.45 | 0.45 | 0.50 | 1.5 |
| Amount of Warpage (μm) | | | 5.1 | 2.8 | 8.9 | 7.3 | 5.5 | 5.5 | 6.7 |

[Table 2]

| | | | Comparative Examples | | |
|---|---|---|---|---|---|
| | | | 1 | 2 | 3 |
| (A) Polyimide Resin | | PI-1 | 100 | 100 | - |
| | | PI-2 | - | - | 100 |
| Curable Components | (C) Radiation-Polymerizable Compounds | BPE-100 | - | 40 | - |
| | | BPE-500 | - | - | 40 |
| | | A-9300 | 80 | - | 40 |
| | | A-DPH | - | 40 | - |
| | (B) Thermosetting Resins | VG-3101 | 5 | 5 | 5 |
| | | YDF-870GS | 10 | 10 | 10 |
| | Curing Agent | TrisP-PA | 5 | 5 | 5 |
| (D) Photoinitiator | | I-819 | 3 | 3 | 3 |
| Filler | | R-972 | 5 | 5 | 5 |
| Coating Solvent | | NMP | 220 | 220 | 230 |
| (C) Average Functional Group Equivalent Weight of (C) Component | | | 140 | 170 | 350 |
| Lowest Melt Viscosity (Pa·s) | | | 32000 | 39000 | $>1.0\times10^5$ |
| Low-Temperature Pastability | | | A | A | B |
| Pattern Formability | | | A | B | B |
| Low-Temperature Thermocompression Bondability | | | B | B | B |
| High-Temperature Adhesivity (MPa) | | | 1.0 | 0.2 | 2.5 |
| Amount of Warpage (μm) | | | 17.8 | 21.6 | - |

<Adhesive sheets>

The obtained photosensitive adhesive compositions of Examples 1 to 7 and Comparative Examples 1 to 3 were each applied on a base material (release agent-treated PET film) so that the film thickness after the drying of the photosensitive adhesive composition became 50 μm, heated at 80°C for 20 min in an oven, and then heated at 120°C for 20 min to form an adhesive layer composed of the photosensitive adhesive composition on the base material. In such a way, an adhesive sheet having the base material and the adhesive layer formed on the base material was obtained. The adhesive sheets obtained from photosensitive adhesive compositions of Examples 1 to 7 and Comparative Examples 1 to 3 were made adhesive sheets of Examples 1 to 7 and Comparative Examples 1 to 3, respectively.

<Evaluation tests>

(Lowest melt viscosity)

The obtained adhesive sheets of Examples 1 to 7 and Comparative Examples 1 to 3 were each laminated on a Teflon sheet by roll pressing (line pressure: 4 kgf/cm, feed rate: 0.5 m/min) so that the adhesive layer was brought into contact with the Teflon sheet. The temperature condition of the roll pressing was set at 50°C for the adhesive sheets of Examples 1 to 7 and Comparative Examples 1 and 2, and at 150°C for the adhesive sheet of Comparative Example 3. In such a way, laminates composed of the Teflon sheet, the adhesive layer and the base material and obtained by laminating these in this order were obtained.

The obtained laminate was exposed at 1,000 mJ/cm$^2$ by a high-precision parallel exposure machine ("EXM-1172-B-∞"(trade name), made by ORC Manufacturing Co., Ltd.), and allowed to stand on a hot plate at 80°C for about 30 sec. Then, by using a conveyer developing machine (made by Yako Co., Ltd.), the exposed laminate was developed by spraying using a 2.38-mass% solution of tetramethylammonium hydride (TMAH) as a developing solution under the condition of a temperature of 26°C and a spray pressure of 0.18 MPa, and thereafter washed with pure water at a temperature of 25°C for 3 min under the condition of a spray pressure of 0.02 MPa. In such a way, the adhesive layer

composed of the photosensitive adhesive composition was formed on the Teflon sheet. The base material (PET film) was removed; and the laminates composed of the Teflon sheet and the adhesive layer were laminated so that the thickness became about 200 μm, and cut out into a size of 10 mm x 10 mm to make a sample. The laminating temperature condition was 80°C for Examples 1 to 7 and Comparative Examples 1 and 2, and 200°C for Comparative Example 3.

The Teflon sheet on one side of the obtained sample was peeled off; and the sample was heat dried at 150°C for 10 min, and measured for the lowest melt viscosity using a viscoelasticity measuring instrument ARES (made by Rheometrics Scientific F.E. Ltd.). The measuring plates were parallel plates of 8 mm in diameter; and the measuring conditions were set as follows: the temperature-rise was 5°C/min; and the frequency was 1 Hz. A lowest value of melt viscosity at -50°C to 300°C was denoted as the lowest melt viscosity. Measurement results are shown in Table 1 and Table 2.

(Low-temperature pastability)

A silicon wafer (6 inches in diameter, 400 μm in thickness) was placed on a support table; the adhesive sheet was laminated thereon by roll pressing (temperature: 100°C, line pressure: 4 kgf/cm, feed rate: 0.5 m/min) so that the adhesive layer was brought into contact with the rear surface (the surface on the opposite side to the support table) of the silicon wafer. After the base material (PET film) was peeled off and removed, a polyimide film ("UPILEX", made by UBE Industries, Ltd.) 80 μm thick, 10 mm wide and 40 mm long was laminated on the exposed adhesive layer by roll pressing of the same condition as described above. In such a way, a sample of a laminate composed of the silicon wafer, the adhesive layer and the polyimide film and obtained by laminating these in this order was obtained.

The obtained sample was measured for the peel strength between the adhesive layer and the polyimide film by a 90° peel test at room temperature using a rheometer ("Strograph E-S" (trade name), made by Toyo Seiki Seisaku-sho, Ltd.). Based on the measurement results, the evaluation of the low-temperature pastability was carried out by denoting a sample having a peel strength of 2 N/cm or higher as A, and a sample having a peel strength of less than 2 N/cm as B. Evaluation results are shown in Table 1 and Table 2.

(High-temperature (260°C) adhesivity)

The adhesive sheets were each laminated on the silicon wafer as in the above-mentioned evaluation test of the low-temperature pastability, except for setting the temperature of the roll pressing at 50°C for the adhesive sheets of Examples 1 to 7 and Comparative Examples 1 and 2, and at 150°C for the adhesive sheet of Comparative Example 3. The obtained laminate was exposed, from the adhesive sheet side, at 1,000 mJ/$cm^2$ by a high-precision parallel exposure machine ("EXM-1172-B-∞" (trade name), made by ORC Manufacturing Co., Ltd.), and allowed to stand on a hot plate at 80°C for about 30 sec. After the base material (PET film) was peeled off and removed, by using a conveyer developing machine (made by Yako Co., Ltd.), the exposed laminate was developed by spraying using a 2.38-mass% solution of tetramethylammonium hydride (TMAH) as a developing solution under the condition of a temperature of 26°C and a spray pressure of 0.18 MPa, thereafter washed with pure water at a temperature of 25°C for 6 min under the condition of a spray pressure of 0.02 MPa, and dried at 150°C for 1 min. In such a way, the adhesive layer composed of the photosensitive adhesive composition was formed on the silicon wafer.

The obtained laminate composed of the silicon wafer and the adhesive layer was segmented into a size of 3 mm x 3 mm. The segmented laminate was dried at 150°C for 10 min, thereafter laminated on a glass substrate (10 mm x 10 mm x 0.55 mm) so that the adhesive layer was brought into contact with the glass substrate, and compression-bonded for 10 sec under a pressure of 2 kgf. The compression-bonding temperature was set at 150°C for Examples 1 to 7 and Comparative Examples 1 and 2, and at 200°C for Comparative Example 3. In such a way, a sample of a laminate composed of the silicon wafer, the adhesive layer and the glass substrate and obtained by laminating these in this order was obtained.

The obtained sample was heated in an oven at 180°C for 3 hours, and further heated on a hot plate at 260°C for 10 sec; thereafter, the sample was measured for the adhesive force using a shearing adhesive force tester "Dage-4000" (trade name). Measurement results are shown in Table 1 and Table 2.

(Pattern formability)

The adhesive sheets were each laminated on the silicon wafer as in the above-mentioned evaluation test of the high-temperature adhesivity, except for setting the temperature of the roll pressing at 60°C for the adhesive sheets of Examples 1 to 7 and Comparative Examples 1 and 2, and at 150°C for the adhesive sheet of Comparative Example 3. The obtained laminate was exposed, as in the above-mentioned test, from the adhesive sheet side through a mask for a negative-type pattern ("No. G-2" (trade name), made by Hitachi Chemical Co., Ltd.). Then, as in the above-mentioned test, the exposed sample was allowed to stand on a hot plate; the base material was removed; and the sample was

developed and washed with water. In such a way, an adhesive pattern composed of the photosensitive adhesive composition was formed on the silicon wafer.

The formed adhesive pattern was observed by a microscope (magnification: 50 times); and by denoting the case where a pattern of line width/space width = 400 μm/400 μm was formed, as A, and denoting the case where that was not formed, as B, the evaluation of the pattern formability was carried out. Evaluation results are shown in Table 1 and Table 2.

(Low-temperature thermocompression bondability)

Adhesive patterns composed of the photosensitive adhesive composition were each formed on the silicon wafer as in the above-mentioned evaluation test of the pattern formability, except for setting the temperature of the roll pressing at 50°C for the adhesive sheets of Examples 1 to 7 and Comparative Examples 1 and 2, and at 150°C for the adhesive sheet of Comparative Example 3, and using a picture frame-like 6-inch sized mask pattern (hollow parts: 2 mm, line width: 0.5 mm) in place of the above-mentioned mask for a negative-type pattern.

The silicon wafer with the adhesive layer was dried at 150°C for 10 min; thereafter, a glass substrate (15 mm x 40 mm x 0.55 mm) was laminated on the surface of the formed adhesive pattern on the opposite side to the silicon wafer, and compression-bonded at 150°C for 10 min under a pressure of 0.5 MPa to obtain a sample of a laminate composed of the silicon wafer, the adhesive pattern and the glass substrate and obtained by laminating these in this order.

The obtained sample was observed by a microscope (magnification: 50 times); and by denoting the case where the area of unadhered portions (vacancies) to the adhering area of the glass substrate and the adhesive pattern was 20% or less, as A, and denoting the case where that was 20% or more, as B, the evaluation of the low-temperature thermocompression bondability was carried out. Evaluation results are shown in Table 1 and Table 2.

(Amount of warpage)

The adhesive sheets were each laminated on a silicon wafer as in the above-mentioned evaluation test of the low-temperature pastability, except for making the thickness of the silicon wafer to be 280 μm and setting the temperature of roll pressing at 50°C. The obtained laminate was exposed from the adhesive sheet side at 1,000 mJ/cm$^2$ by a high-precision parallel exposure machine ("EXM-1172-B-∞"(trade name), made by ORC Manufacturing Co., Ltd.), and allowed to stand on a hot plate at 80°C for about 30 sec, and thereafter segmented into a size of 15 mm x 40 mm. The base material (PET film) was peeled off, and the segmented laminated was thermoset in an oven at 180°C for 3 hours to obtain a laminate composed of the silicon wafer and a cured material layer composed of a cured material of the photosensitive adhesive composition.

The surface of the obtained laminate on the silicon wafer side was measured for the surface roughness using a surface roughness tester ("SE-2300", made by Kosaka Laboratory Ltd.). After the measurement was carried out on diagonal lines, IR reflow at 250°C for 10 sec was carried out three times, and an average value for both the diagonal lines was defined as the amount of warpage. Results are shown in Table 1 and Table 2.

As is clear from the results in Table 1 and Table 2, the photosensitive adhesives or the adhesive sheets of Examples 1 to 7 were remarkably superior in the low-temperature thermocompression bondability to the photosensitive adhesives or the adhesive sheets of Comparative Examples 1 to 3.

Examples I to V, and Comparative Examples I and II

<(A) components: polyimide resins>

(PI-1)

1.89 g of 3,5-diaminobenzoic acid (molecular weight: 152.2)(hereinafter, abbreviated to "DABA"), 15.21 g of an aliphatic ether diamine ("D-400" (trade name) made by BASF AG, molecular weight: 452.4) and 0.39 g of 1,1,3,3-tetramethyl-1,3-bis(4-aminophenyl)dicyloxane ("LP-7100" (trade name), made by Shin-Etsu Chemical Co., Ltd., molecular weight: 248.5) as diamines, and 116 g of NMP (N-methyl-2-pyrrolidone) as a solvent were charged in a flask equipped with a stirrer, a thermometer and a nitrogen replacing device (nitrogen inflow tube), and stirred to dissolve the diamines in the solvent.

While the flask was being cooled in an ice bath, 16.88 g of 4,4'-oxydiphthalic dianhydride (molecular weight: 326.3)(hereinafter, abbreviated to "ODPA") was added little by little in the solution in the flask. After the completion of the addition, the solution was stirred at room temperature (25°C) for 5 hours.

Thereafter, a reflux cooler with a moisture-receiving vessel was attached to the flask; 70 g of xylene was added thereto; and the solution was heated to 180°C and held at the temperature for 5 hours while nitrogen gas was being

blown in, to azeotropically remove xylene with water. The obtained solution was cooled to room temperature, and thereafter charged in distilled water to reprecipitate a precipitate; and the precipitate was dried in a vacuum drier to obtain a polyimide resin (PI-1). The measurement of (PI-1) by GPC revealed that the weight-average molecular weight in terms of polystyrene was (Mw) = 33,000. Tg of (PI-1) was 55°C.

(PI-2)

20.5 g of 2,2-bis(4-(4-aminophenoxy)phenyl)propane (molecular weight: 410.5)(hereinafter, abbreviated to "BAPP") as a diamine, and 101 g of NMP as a solvent were charged in a flask equipped with a stirrer, a thermometer and a nitrogen replacing device (nitrogen inflow tube), and stirred to dissolve the diamine in the solvent.

While the flask was being cooled in an ice bath, 20.5 g of 1,2-(ethylene) bis(trimellitate anhydride)(molecular weight: 410.3)(hereinafter, abbreviated to "EBTA") was added little by little in the solution in the flask. After the completion of the addition, the solution was stirred at room temperature for 5 hours.

Thereafter, a reflux cooler with a moisture-receiving vessel was attached to the flask; 67 g of xylene was added thereto; and the solution was heated to 180°C and held at the temperature for 5 hours while nitrogen gas was being blown in, to azeotropically remove xylene with water. The obtained solution was cooled to room temperature, and thereafter charged in distilled water to reprecipitate a precipitate; and the precipitate was dried in a vacuum drier to obtain a polyimide resin (PI-2). The measurement of (PI-2) by GPC revealed that the weight-average molecular weight in terms of polystyrene was (Mw) = 98,000. Tg of (PI-2) was 180°C.

<(C) components: radiation-polymerizable compounds>

(C-1)

178 g (1.0 equivalent weight) of a liquid high-purity bisphenol A bisglycidyl ether epoxy resin (epoxy equivalent weight: 178 g/eq), 36 g (0.5 equivalent weight) of acrylic acid, 0.5 g of triphenylphosphine and 0.15 g of hydroquinone were charged in a 500-mL flask equipped with a stirrer, a thermometer and a nitrogen replacing device (nitrogen inflow tube), and allowed to react at 100°C for 7 hours to obtain a radiation-polymerizable compound (C-1) as a monofunctional (meth)acrylate having an epoxy group. (C-1) was a reactive compound having an ethylenically unsaturated group and an epoxy group. The acid value of (C-1) was 0.3 KOHmg/g or less, and the 5%-weight loss temperature thereof was 300°C. The acid value was determined by titrating with an ethanol solution of potassium hydroxide, and the 5%-weight loss temperature was measured using a Thermo Gravimetry/Differential Thermal Analyzer ("TG/DTA6300" (trade name), made by SII Nano Technology Inc.) under the condition of a nitrogen flow of 400 ml/min. The number of the epoxy group in (C-1) was about 1; the number of the ethylenically unsaturated group was about 1; the equivalent weight of the radiation-polymerizable functional group was 410 g/eq; and the whole chlorine content was 400 ppm or less.

(C-2)

(C-2) was obtained as in (C-1), except for using 168 g (1.0 equivalent weight) of a liquid high-purity bisphenol F bisglycidyl ether epoxy resin (epoxy equivalent weight: 160 g/eq) as an epoxy resin. The acid value of (C-2) was 0.3 KOHmg/g or less, and the 5%-weight loss temperature thereof was 300°C. The number of the epoxy group in (C-2) was about 1; the number of the ethylenically unsaturated group was about 1; the equivalent weight of the radiation-polymerizable functional group was 395 g/eq; and the whole chlorine content was 400 ppm or less.

<Photosensitive adhesive compositions>

By using the polyimide resins (PI-1) and (PI-2) and the radiation-polymerizable compounds (C-1) and (C-2) obtained as described above, each component was formulated in a compositional ratio (unit: parts by mass) indicated in Tables 3 and 4 shown below, and photosensitive adhesive compositions (vanishes for forming an adhesive layer) of Examples I to V and Comparative Examples I and II were obtained.

In Tables 3 and 4, each abbreviation means the following.

BPE-100: ethoxylated bisphenol A dimethacrylate (the equivalent weight of the radiation-polymerizable functional group: 240 g/eq, the 5%-weight loss temperature: 330°C), made by Shi-Nakamura Chemical Co., Ltd.
A-9300: isocyanuric acid EO-modified triacrylate (the equivalent weight of the radiation-polymerizable functional group: 140 g/eq, the 5%-weight loss temperature: >400°C), made by Shi-Nakamura Chemical Co., Ltd.
M-140: 2-(1,2-cyclohexacarboxyimide)ethyl acrylate (the equivalent weight of the radiation-polymerizable functional group: 251 g/eq, the 5%-weight loss temperature: 200°C, the number of the glycidyl group: 0, the number of the

acryl group: 1), made by Toagosei Co., Ltd.
4-HBAGE: 4-hydroxybutyl acrylate glycidyl ether (the equivalent weight of the radiation-polymerizable functional group: 200 g/eq, the 5%-weight loss temperature: 135°C), made by Nippon Kasei Chemical Co., Ltd.
VG-3101: a trifunctional epoxy resin (the 5%-weight loss temperature: 350°C), made by Printec Co., Ltd.
YDF-870GS: bisphenol F bisglycidyl ether (the 5%-weight loss temperature: 270°C), made by Tohto Kasei Co., Ltd.
TrisP-PA: a trisphenol compound (α,α, α'-tris(4-hydroxyphenol)-1-ethyl-4-isopropylbenzene) (the 5%-weight loss temperature: 350°C), made by Honshu Chemical Industry Co., Ltd.
R972: hydrophobic fumed silica (average particle diameter: about 16 nm), made by Nippon Aerosil Co., Ltd.
I-819: bis(2,4,6-trimethylbenzoyl)-phenylphosphine oxide, made by Ciba Speciality Chemicals Corp.
Percumyl D: dicumyl peroxide (the one-minute half-life temperature: 175°C), made by NOF Corp.
NMP: N-methyl-2-pyrrolidone, made by Kanto Chemical Co., Ltd.

[Table3]

| | | | Examples | | | | |
|---|---|---|---|---|---|---|---|
| | | | I | II | III | IV | V |
| (A) Polyimide Resin | | PI-1 | 100 | 100 | 100 | 100 | 100 |
| Curable Components | (C) Radiation-Polymerizable Compounds | BPE-100 | 40 | 40 | 40 | 40 | 40 |
| | | A-9300 | 40 | 40 | 40 | 40 | 40 |
| | | C-1 | - | 20 | - | - | - |
| | | C-2 | - | - | 20 | - | - |
| | | M-140 | - | - | - | 20 | - |
| | | 4-HBAGE | - | - | - | - | 20 |
| | (B) Thermosetting Resins | VG-3101 | 5 | 5 | 5 | 5 | 5 |
| | | YDF-870GS | 10 | 10 | 10 | 10 | 10 |
| | Curing Agent | TrisP-PA | 10 | 10 | 10 | 10 | 10 |
| (D) Photoinitiator | | I-819 | 3 | 3 | 3 | 3 | 3 |
| Filler | | R-972 | 5 | 5 | 5 | 5 | 5 |
| (E) Thermal Radical Generating Agent | | Percumyl D | 2 | 2 | 2 | 2 | 2 |
| Coating Solvent | | NMP | 220 | 220 | 224 | 213 | 210 |
| Lowest Melt Viscosity (Pa·s) | | | 18000 | 3500 | 3800 | 5900 | 3800 |
| Low-Temperature Pastability | | | A | A | A | A | A |
| Pattern Formability | | | A | A | A | A | A |
| Low-Temperature Thermocompression Bondability | | | A | A | A | A | A |
| Amount of Warpage (μm) | | | 8.9 | 10.2 | 9.7 | 7.2 | 8.2 |
| High-Temperature Adhesivity | | | 0.58 | 3.4 | 3.2 | 0.59 | 0.91 |

[Table 4]

| | | | Comparative Examples | |
|---|---|---|---|---|
| | | | I | II |
| (A) Polyimide Resin | | PI-1 | 100 | - |
| | | PI-2 | - | 100 |
| Curable Components | (C) Radiation-Polymerizable Compounds | BPE-100 | - | 40 |
| | | A-9300 | 80 | 40 |
| | | C-1 | - | 20 |
| | (B) Thermosetting Resins | VG-3101 | 5 | 5 |
| | | YDF-870GS | 10 | 10 |
| | Curing Agent | TrisP-PA | 10 | 10 |
| (D) Photoinitiator | | I-819 | 3 | 3 |
| Filler | | R-972 | 5 | 5 |
| (E) Thermal Radical Generating Agent | | Percumyl D | 2 | 2 |
| Coating Solvent | | NMP | 220 | 230 |
| Lowest Melt Viscosity (Pa·s) | | | 32000 | >$1.0\times10^5$ |
| Low-Temperature Pastability | | | A | B |
| Pattern Formability | | | A | B |
| Low-Temperature Thermocompression Bondability | | | B | B |
| Amount of Warpage (μm) | | | 17.8 | - |
| High-Temperature Adhesivity | | | 1.0 | 2.5 |

<Adhesive sheets>

The obtained photosensitive adhesive compositions of Examples I to V and Comparative Examples I and II were each applied on a base material (release agent-treated PET film) so that the film thickness after the drying of the photosensitive adhesive composition became 50 μm, heated at 80°C for 20 min in an oven, and then heated at 120°C for 20 min to form an adhesive layer composed of the photosensitive adhesive composition on the base material. In such a way, an adhesive sheet having the base material and the adhesive layer formed on the base material was obtained. The adhesive sheets obtained from the photosensitive adhesive compositions of Examples I to V and Comparative Examples I and II were made adhesive sheets of Examples I to V and Comparative Examples I and II, respectively.

<Evaluation tests>

(Lowest melt viscosity)

The obtained adhesive sheets of Examples I to V and Comparative Examples I and II were each laminated on a Teflon sheet by roll pressing (temperature: 50°C, line pressure: 4 kgf/cm, feed rate: 0.5 m/min) so that the adhesive layer was brought into contact with the Teflon sheet. In such a way, laminates composed of the Teflon sheet, the adhesive layer and the base material and obtained by laminating these in this order were obtained.

The obtained laminate was exposed at 1,000 mJ/cm$^2$ by a high-precision parallel exposure machine ("EXM-1172-B-∞" (trade name), made by ORC Manufacturing Co., Ltd.), and allowed to stand on a hot plate at 80°C for about 30 sec. Then, by using a conveyer developing machine (made by Yako Co., Ltd.), the exposed laminate was developed by spraying using a 2.38-mass% solution of tetramethylammonium hydride (TMAH) as a developing solution under the condition of a temperature of 26°C and a spray pressure of 0.18 MPa, and thereafter washed with pure water at a temperature of 25°C for 3 min under the condition of a spray pressure of 0.02 MPa. In such a way, the adhesive layer composed of the photosensitive adhesive composition was formed on the Teflon sheet. The base material (PET film) was removed; and the laminates composed of the Teflon sheet and the adhesive layer were laminated at 80°C so that the thickness became about 200 μm, and cut out into a size of 10 mm x 10 mm to make a sample.

The Teflon sheet on one side of the obtained sample was peeled off; and the sample was heat dried at 150°C

for 10 min, and measured for the lowest melt viscosity using a viscoelasticity measuring instrument ARES (made by Rheometrics Scientific F.E. Ltd.). The measuring plates were parallel plates of 8 mm in diameter; and the measuring conditions were set as follows: the temperature-rise was 5°C/min; and the frequency was 1 Hz. A lowest value of melt viscosity at -50°C to 300°C was denoted as the lowest melt viscosity. Measurement results are shown in Table 3 and Table 4.

(Low-temperature pastability)

A silicon wafer (6 inches in diameter, 400 μm in thickness) was placed on a support table; the adhesive sheet was laminated thereon by roll pressing (temperature: 100°C, line pressure: 4 kgf/cm, feed rate: 0.5 m/min) so that the adhesive layer was brought into contact with the rear surface (the surface on the opposite side to the support table) of the silicon wafer. After the base material (PET film) was peeled off and removed, a polyimide film ("UPILEX" (trade name), made by UBE Industries, Ltd.) 80 μm thick, 10 mm wide and 40 mm long was laminated on the exposed adhesive layer by roll pressing of the same condition as described above. In such a way, a laminate composed of the silicon wafer, the adhesive layer and the polyimide film and obtained by laminating these in this order was obtained.

The obtained sample was measured for the peel strength between the adhesive layer and the polyimide film by a 90° peel test at room temperature using a rheometer ("Strograph E-S" (trade name), made by Toyo Seiki Seisaku-sho, Ltd.). Based on the measurement results, the evaluation of the low-temperature pastability was carried out by denoting a sample having a peel strength of 2 N/cm or higher, as A, and denoting a sample having a peel strength of less than 2 N/cm, as B. Evaluation results are shown in Table 3 and Table 4.

(High-temperature (260°C) adhesivity)

The adhesive sheets were each laminated on the silicon wafer as in the above-mentioned evaluation test of the low-temperature pastability, except for setting the temperature of the roll pressing at 50°C for the adhesive sheets of Examples I to V and Comparative Example I, and at 150°C for the adhesive sheet of Comparative Example II. The obtained laminate was exposed, from the adhesive sheet side, at 1,000 mJ/cm$^2$ by a high-precision parallel exposure machine ("EXM-1172-B-∞"(trade name), made by ORC Manufacturing Co., Ltd.), and allowed to stand on a hot plate at 80°C for about 30 sec. After the base material (PET film) was peeled off and removed, by using a conveyer developing machine (made by Yako Co., Ltd.), the exposed laminate was developed by spraying using a 2.38-mass% solution of tetramethylammonium hydride (TMAH) as a developing solution under the condition of a temperature of 26°C and a spray pressure of 0.18 MPa, thereafter washed with pure water at a temperature of 25°C for 6 min under the condition of a spray pressure of 0.02 MPa, and dried at 150°C for 1 min. In such a way, an adhesive layer composed of the photosensitive adhesive composition was formed on the silicon wafer.

The obtained laminate composed of the silicon wafer and the adhesive layer was segmented into a size of 3 mm x 3 mm. The segmented laminate was dried at 150°C for 10 min, thereafter laminated on a glass substrate (10 mm x 10 mm x 0.55 mm) so that the adhesive layer was brought into contact with the glass substrate, and compression-bonded for 10 sec under a pressure of 2 kgf. The compression-bonding temperature was set at 150°C for Examples 1 to 7 and Comparative Examples 1 and 2, and at 200°C for Comparative Example 3. In such a way, a sample of a laminate composed of the silicon wafer, the adhesive layer and the glass substrate and obtained by laminating these in this order was obtained.

The obtained sample was heated in an oven at 180°C for 3 hours, and further heated on a hot plate at 260°C for 10 sec; thereafter, the sample was measured for the adhesive force using a shearing adhesive force tester "Dage-4000" (trade name). Measurement results are shown in Table 3 and Table 4.

(Pattern formability)

The adhesive sheets were each laminated on the silicon wafer as in the above-mentioned evaluation test of the high-temperature adhesivity, except for setting the temperature of the roll pressing at 60°C for the adhesive sheets of Examples I to V and Comparative Example I, and at 150°C for the adhesive sheet of Comparative Example II. The obtained laminate was exposed, as in the above-mentioned test, from the adhesive sheet side through a mask for a negative-type pattern ("No. G-2" (trade name), made by Hitachi Chemical Co., Ltd.). Then, as in the above-mentioned test, the exposed sample was allowed to stand on a hot plate; the base material was removed; and the sample was developed and washed with water. In such a way, an adhesive pattern composed of the photosensitive adhesive composition was formed on the silicon wafer.

The formed adhesive pattern was observed by a microscope (magnification: 50 times); and by denoting the case where a pattern of line width/space width = 400 μm/400 μm was formed, as A, and denoting the case where that was not formed, as B, the evaluation of the pattern formability was carried out. Evaluation results are shown in Table 3

and Table 4.

(Low-temperature thermocompression bondability)

Adhesive patterns composed of the photosensitive adhesive composition were each formed on the silicon wafer as in the above-mentioned evaluation test of the pattern formability, except for setting the temperature of the roll pressing at 50°C for the adhesive sheets of Examples I to V and Comparative Example I, and at 150°C for the adhesive sheet of Comparative Example II, and using a picture frame-like 6-inch sized mask pattern (hollow parts: 2 mm, line width: 0.5 mm) in place of the above-mentioned mask for a negative-type pattern.

The silicon wafer with the adhesive layer was dried at 150°C for 10 min; thereafter, a glass substrate (15 mm x 40 mm x 0.55 mm) was laminated on the surface of the formed adhesive pattern on the opposite side to the silicon wafer, and compression-bonded at 150°C for 10 min under a pressure of 0.5 MPa to obtain a sample of a laminate composed of the silicon wafer, the adhesive pattern and the glass substrate and obtained by laminating these in this order.

The obtained sample was observed by a microscope (magnification: 50 times); and by denoting the case where the area of unadhered portions (vacancies) to the adhering area of the glass substrate and the adhesive pattern was 20% or less, as A, and denoting the case where that was 20% or more, as B, the evaluation of the low-temperature thermocompression bondability was carried out. Evaluation results are shown in Table 3 and Table 4.

As is clear from the results in Table 3 and Table 4, the photosensitive adhesives or the adhesive sheets of Examples I to V were remarkably superior in the low-temperature thermocompression bondability to the photosensitive adhesives or the adhesive sheets of Comparative Examples I and II.

Examples i to viii, and Comparative Examples i to vii

<(A) components: thermoplastic resins>

Polyimide resins

(PI-3)

2.16 g (0.0075 mol) of 5,5'-methylene bis(anthranilic acid)(molecular weight: 286.3)(hereinafter, abbreviated to "MBAA"), 15.13 g (0.0335 mol) of a polyoxypropylenediamine (trade name "D-400", (molecular weight: 452.4), made by BASF AG) and 1.63 g (0.0065 mol) of 1,1,3,3-tetramethyl-1,3-bis(3-aminopropyl)disiloxane (trade name "BY16-871EG", made by Dow Corning Toray Co., Ltd.) as diamines, and 115 g of NMP (N-methyl-2-pyrrolidone) as a solvent were charged in a 300-mL flask equipped with a stirrer, a thermometer and a nitrogen replacing device (nitrogen inflow tube), and stirred to dissolve the diamines in the solvent.

While the flask was being cooled in an ice bath, 16.51 g (0.051 mol) of 4,4'-oxydiphthalic acid dianhydride (hereinafter, abbreviated to "ODPA") was added little by little in the solution in the flask. After the completion of the addition, the solution was stirred at room temperature for 5 hours. Thereafter, a reflux cooler with a moisture-receiving vessel was attached to the flask; 81 g of xylene was added thereto; and the solution was heated to 180°C and held at the temperature for 5 hours while nitrogen gas was being blown in, to azeotropically remove xylene with water, to obtain a polyimide resin (PI-3). The measurement of (PI-3) by GPC revealed that the weight-average molecular weight in terms of polystyrene was (Mw) = 30,000. Tg of (PI-3) was 31°C.

(PI-4)

5.72 g (0.02 mol) of MBAA, 13.57 g (0.03 mol) of "D-400", 2.48 g (0.01 mol) of "BY16-871EG" and 8.17 g (0.04 mol) of 1,4-butanediol bis(3-aminopropyl) ether (trade name "B-12", made by Tokyo Chemical Industry Co., Ltd., molecular weight: 204.31) as diamines, and 110 g of NMP as a solvent were charged in a flask equipped with a stirrer, a thermometer and a nitrogen replacing device, and stirred to dissolve the diamines in the solvent.

While the flask was being cooled in an ice bath, 29.35 g (0.09 mol) of ODPA and 3.84 g (0.02 mol) of TAA (trimellitic anhydride) were added little by little in the solution in the flask. After the completion of the addition, the solution was stirred at room temperature for 5 hours. Thereafter, a reflux cooler with a moisture-receiving vessel was attached to the flask; 70.5 g of xylene was added thereto; and the solution was heated to 180°C and held at the temperature for 5 hours while nitrogen gas was being blown in, to azeotropically remove xylene with water, to obtain a polyimide resin (PI-4). The measurement of (PI-4) by GPC revealed Mw = 21,000 in terms of polystyrene. Tg of (PI-4) was 55°C.

(PI-5)

34.32 g (0.12 mol) of MBAA, 17.32 g (0.04 mol) of "D-400" and 7.454 g (0.03 mol) of "BY16-871EG" as diamines, and 140 g of NMP as a solvent were charged in a 500-mL flask equipped with a stirrer, a thermometer and a nitrogen replacing device, and stirred to dissolve the diamines in the solvent.

While the flask was being cooled in an ice bath, 55.8 g (0.18 mol) of ODPA and 11.52 g (0.06 mol) of TAA were added little by little in the solution in the flask. After the completion of the addition, the solution was stirred at room temperature for 5 hours. Thereafter, a reflux cooler with a moisture-receiving vessel was attached to the flask; 81 g of xylene was added thereto; and the solution was heated to 180°C and held at the temperature for 5 hours while nitrogen gas was being blown in, to azeotropically remove xylene with water, to obtain a polyimide resin (PI-5). The measurement of (PI-5) by GPC revealed Mw = 20,000 in terms of polystyrene. Tg of (PI-5) was 100°C.

(Meth)acryl copolymers

(Polymer-1)

240 g of propylene glycol monomethyl ether acetate, 60 g of methyl lactate, 86.4 g of methacryloyloxytricyclo [5.2.1.0$^{2,6}$]decane ("FANCRYL FA-513M", made by Hitachi Chemical Co., Ltd.), 36.5 g of N-cyclohexylmaleimide, 106.7 g of 2-hydroxyethyl methacrylate and 40.5 g of (meth)acrylic acid were mixed, and dissolved under nitrogen bubbling. After the confirmation of the dissolution of N-cyclohexylmaleimide, 3 g of 2,2'-azobisisobutyronitrile was dissolved to prepare a mixed solution (a).

0.6 g of 2,2'-azobisisobutyronitrile was dissolved in 40 g of diethylene glycol dimethyl ether to prepare a solution (b).

264 g of propylene glycol monomethyl ether acetate and 66 g of methyl lactate were charged in a four-necked flask, and heated to 90°C. While the temperature inside the flask was being held at 90°C, the mixed solution (a) was continuously dropped in the flask over 3 hours. Thereafter, the temperature was held at 90°C for 3 hours; and during the period, the solution (b) was added in several times in order to decrease the remaining monomers. After the reaction at 90°C of 6 hours in total was carried out, the solution in the flask was heated to 120°C, and after the temperature was held at 120°C for 1 hour, the solution was self-cooled to obtain a solution of a polymer containing a monomer having a (meth)acryloyl group as a monomer unit.

In order to introduce an ethylenically unsaturated bond (methacryloyl group), 2-methacryloyloxyethyl isocyanate and a tin-based catalyst were added to the obtained solution of the polymer. 2-Methacryloyloxyethyl isocyanate was added so as to be 1.5 mmol/g to the polymer. Thereafter, the mixture was held at 80°C for 2 to 3 hours, and then self-cooled to obtain a solution of a (meth)acryl copolymer (Polymer-1) having an ethylenically unsaturated bond on the side chain and/or the terminal. The measurement of (Polymer-1) by GPC revealed Mw = 30,000 in terms of polystyrene. Tg of (Polymer-1) was 60°C.

<(C) components: radiation-polymerizable compounds>

(C-1)

178 g (1.0 equivalent weight) of a liquid high-purity bisphenol A bisglycidyl ether epoxy resin (epoxy equivalent weight: 178 g/eq), 36 g (0.5 equivalent weight) of acrylic acid, 0.5 g of triphenylphosphine and 0.15 g of hydroquinone were charged in a 500-mL flask equipped with a stirrer, a thermometer and a nitrogen replacing device (nitrogen inflow tube), and allowed to react at 100°C for 7 hours to obtain a radiation-polymerizable compound (C-1) as a monofunctional (meth)acrylate having an epoxy group. (C-1) was a reactive compound having an ethylenically unsaturated group and an epoxy group. The acid value of (C-1) was 0.3 KOHmg/g or less, and the 5%-weight loss temperature thereof was 300°C. The acid value was determined by titrating with an ethanol solution of potassium hydroxide, and the 5%-weight loss temperature was measured using a Thermo Gravimetry/Differential Thermal Analyzer ("TG/DTA6300" (trade name), made by SII Nano Technology Inc.) under the condition of a nitrogen flow of 400 ml/min. The number of the epoxy group in (C-1) was about 1; the number of the ethylenically unsaturated group was about 1; the equivalent weight of the radiation-polymerizable functional group was 410 g/eq; and the whole chlorine content was 400 ppm or less.

(C-2)

(C-2) was obtained as in (C-1), except for using 168 g (1.0 equivalent weight) of a liquid high-purity bisphenol F bisglycidyl ether epoxy resin (epoxy equivalent weight: 160 g/eq) as an epoxy resin. The acid value of (C-2) was 0.3 KOHmg/g or less, and the 5%-weight loss temperature thereof was 300°C. The number of the epoxy group in (C-2) was

about 1; the number of the ethylenically unsaturated group was about 1; the equivalent weight of the radiation-polymerizable functional group was 395 g/eq; and the whole chlorine content was 400 ppm or less.

(C-3)

174 g (1.0 equivalent weight) of a phenol novolac epoxy resin (epoxy equivalent weight: 174 g/eq, "YDPN-638", made by Tohto Kasei Co., Ltd.), 36 g (0.5 equivalent weight) of acrylic acid, 0.48 g of triphenylphosphine and 0.10 g of hydroquinone were charged in a 500-mL flask equipped with a stirrer, a thermometer and a nitrogen replacing device (nitrogen inflow tube), and allowed to react at 90°C to 100°C for 7 hours to obtain a radiation-polymerizable compound (C-3) as a monofunctional (meth)acrylate having an epoxy group. (C-3) was a reactive compound having an ethylenically unsaturated group and an epoxy group. The acid value of (C-3) was 0.3 KOHmg/g or less, and the 5%-weight loss temperature thereof was 310°C. The acid value was determined by titrating with an ethanol solution of potassium hydroxide, and the 5%-weight loss temperature was measured using a Thermo Gravimetry/Differential Thermal Analyzer ("TG/DTA6300" (trade name), made by SII Nano Technology Inc.) under the condition of a nitrogen flow of 400 ml/min. The number of the epoxy group in (C-3) was about 1.7; the number of the ethylenically unsaturated group was about 1.7; the equivalent weight of the radiation-polymerizable functional group was 440 g/eq; and the whole chlorine content was 400 ppm or less.

<Photosensitive adhesive compositions>

By using the polyimide resins (PI-3) to (PI-5) and the radiation-polymerizable compounds (C-1) to (C-3) obtained as described above, each component was formulated in a compositional ratio (unit: parts by mass) indicated in Tables 5 and 6 shown below, and photosensitive adhesive compositions (vanishes for forming an adhesive layer) of Examples i to viii and Comparative Examples i to vii were obtained.

In Tables 5 and 6, each abbreviation means the following.

BPE-100: ethoxylated bisphenol A dimethacrylate (the equivalent weight of the radiation-polymerizable functional group: 240 g/eq, the 5%-weight loss temperature: 330°C), made by Shi-Nakamura Chemical Co., Ltd.
A-9300: isocyanuric acid EO-modified triacrylate (the equivalent weight of the radiation-polymerizable functional group: 140 g/eq, the 5%-weight loss temperature: >400°C), made by Shi-Nakamura Chemical Co., Ltd.
EA-1020: bisphenol A bisglycidyl ether diacrylate (the equivalent weight of the radiation-polymerizable functional group: 228 g/eq, the 5%-weight loss temperature: 300°C), made by Shi-Nakamura Chemical Co., Ltd.
M-140: 2-(1,2-cyclohexacarboxyimide)ethyl acrylate (the equivalent weight of the radiation-polymerizable functional group: 251 g/eq, the 5%-weight loss temperature: 200°C, the number of the glycidyl group: 0, the number of the acryl group: 1), made by Toagosei Co., Ltd.
VG-3101: a trifunctional epoxy resin (the 5%-weight loss temperature: 350°C), made by Printec Co., Ltd.
YDF-870GS: bisphenol F bisglycidyl ether (the 5%-weight loss temperature: 270°C), made by Tohto Kasei Co., Ltd.
TrisP-PA: a trisphenol compound (α,α, α'-tris(4-hydroxyphenol)-1-ethyl-4-isopropylbenzene) (the 5%-weight loss temperature: 350°C), made by Honshu Chemical Industry Co., Ltd.
HRM-2019: an acrylate containing a phenolic hydroxyl group (the 5%-weight loss temperature: 210°C, the number of the phenolic hydroxyl group: about 4, the number of the acryl group: about 4), made by Showa Highpolymer Co., Ltd.
R972: hydrophobic fumed silica (average particle diameter: about 16 nm), made by Nippon Aerosil Co., Ltd.
I-819: bis(2,4,6-trimethylbenzoyl)-phenylphosphine oxide, made by Ciba Speciality Chemicals Corp.
Percumyl D: dicumyl peroxide (the one-minute half-life temperature: 175°C), made by NOF Corp.
NMP: N-methyl-2-pyrrolidone, made by Kanto Chemical Co., Ltd.

[Table 5]

| | | | Examples | | | | | | | |
|---|---|---|---|---|---|---|---|---|---|---|
| | | | i | ii | iii | iv | v | vi | vii | viii |
| (A) Components | Polyimide Resin | PI-3 | 100 | - | - | - | - | - | - | - |
| | | PI-4 | - | 100 | 100 | 100 | 100 | 100 | - | - |
| | | PI-5 | - | - | - | - | - | - | 100 | - |
| | (Meth) acryl Copolymer | Polymer-1 | - | - | - | - | - | - | - | 100 |
| Curable Components | (C) Radiation-Polymerizable Compounds | C-1 | 20 | - | - | - | 20 | 20 | 40 | 20 |
| | | C-2 | - | 20 | - | - | - | - | - | - |
| | | C-3 | - | - | 20 | 10 | - | - | - | - |
| | | BPE-100 | 40 | 40 | 40 | 40 | 40 | 40 | 40 | 40 |
| | | A-9300 | 40 | 40 | 40 | 40 | 40 | 40 | 40 | 40 |
| | | EA-1020 | - | - | - | - | - | - | - | - |
| | | M-140 | - | - | - | - | - | - | - | - |
| | (B) Thermosetting Resins | VG-3101 | 5 | 5 | 5 | 5 | 5 | 5 | 5 | 5 |
| | | YDF-870GS | 10 | 10 | 10 | 10 | 10 | 10 | 20 | 10 |
| | Curing Agent | TrisP-PA | 10 | 10 | 10 | 10 | 10 | 10 | 20 | 10 |
| (D) Photoinitiator | | I-819 | 3 | 3 | 3 | 3 | 3 | 3 | 3 | 3 |
| Filler | | R-972 | 5 | 5 | 5 | 5 | 5 | 20 | 5 | 5 |
| (E) Thermal Radical Generating Agent | | Percumyl D | 2 | 2 | 2 | 2 | 2 | 2 | 2 | 2 |
| Coating Solvent | | NMP | 220 | 220 | 220 | 224 | 213 | 210 | 210 | 150 |
| Low-Temperature Pastability | | | A | A | A | A | A | A | A | A |
| High-Temperature Adhesivity (MPa) | | | 3.0 | 2.8 | 3.5 | 2.1 | 3.3 | 4.5 | 8.5 | 1.2 |
| Pattern Formability | | | A | A | A | A | A | A | A | A |
| Thermocompression Bondability | | | A | A | A | A | A | A | A | A |
| Heat Resistance | | | A | A | A | A | A | A | A | A |
| Moisture Resistance | | Dew Condensation Resistance | A | A | A | A | A | A | A | A |
| | | Reflow Resistance | A | A | A | A | A | A | A | A |

[Table 6]

| | | | Comparative Examples | | | | | | |
|---|---|---|---|---|---|---|---|---|---|
| | | | i | ii | iii | iv | v | vi | vii |
| (A) Components | Polyimide Resin | PI-3 | 100 | - | - | 100 | 100 | - | - |
| | | PI-4 | - | 100 | 100 | - | - | - | - |
| | | PI-5 | - | - | - | - | - | 100 | - |
| | (Meth) acryl Copolymer | Polymer-1 | - | - | - | - | - | - | 100 |
| Curable Components | (C) Radiation-Polymerizable Compounds | BPE-100 | 40 | 40 | 40 | 40 | 40 | 40 | 40 |
| | | A-9300 | 40 | 40 | 40 | 40 | 40 | 40 | 40 |
| | | EA-1020 | - | - | 20 | - | - | - | - |
| | | M-140 | - | 20 | - | - | - | - | - |
| | (B) Thermosetting Resins | VG-3101 | 5 | 5 | 5 | 5 | 5 | 5 | 5 |
| | | YDF-870GS | 10 | 10 | 10 | 20 | 10 | 20 | 10 |
| | Curing Agent | TrisP-PA | 5 | 10 | 10 | 10 | 5 | 10 | 5 |
| | | HRM-2019 | - | - | - | - | 20 | - | - |
| (D) Photoinitiator | | I-819 | 3 | 3 | 3 | 3 | 3 | 3 | 3 |
| Filler | | R-972 | 5 | 5 | 5 | 5 | 5 | 5 | 5 |
| (E) Thermal Radical Generating Agent | | Percumyl D | 2 | 2 | 2 | 2 | 2 | 2 | 2 |
| Coating Solvent | | NMP | 220 | 220 | 220 | 220 | 210 | 220 | 160 |
| Low-Temperature Pastability | | | A | A | A | A | A | A | A |
| High-Temperature Adhesivity (MPa) | | | 0.6 | 0.3 | 0.5 | 0.8 | 0.2 | 1.2 | 0.2 |
| Pattern Formability | | | A | A | B | B | A | A | A |
| Thermocompression Bondability | | | A | A | - | - | A | B | A |
| Heat Resistance | | | A | B | - | - | B | - | B |
| Moisture Resistance | | Dew Condensation Resistance | B | B | - | - | B | - | B |
| | | Reflow Resistance | B | B | - | - | B | - | B |

<5%-Weight loss temperature>

The sample was measured for the 5%-weight loss temperature by using a Thermo Gravimetry/Differential Thermal Analyzer (trade name "TG/DTA6300", made by SII Nano Technology Inc.) at a temperature-rise rate of 10°C/min and in a nitrogen flow (400 ml/min).

<Whole chlorine content>

The whole chlorine content was measured according to JIS K7243-3.

<Adhesive sheets>

The obtained photosensitive adhesive compositions of Examples i to viii and Comparative Examples i to vii were each applied on a base material (release agent-treated PET film) so that the film thickness after the drying of the photosensitive adhesive composition became 50 μm, heated at 80°C for 20 min in an oven, and then heated at 120°C for 20 min to form an adhesive layer composed of the photosensitive adhesive composition on the base material. In such a way, an adhesive sheet having the base material and the adhesive layer formed on the base material was obtained. The adhesive sheets obtained from the photosensitive adhesive compositions of Examples i to viii and Comparative Examples i to vii were made adhesive sheets of Examples i to viii and Comparative Examples i to vii, respectively.

<Evaluation tests>

(Low-temperature pastability)

The low-temperature pastability was evaluated as in Examples I to V and Comparative Examples I and II. Evaluation results are shown in Table 5 and Table 6.

(High-temperature (260°C) adhesivity)

The adhesive sheets were each laminated on the silicon wafer as in the above-mentioned evaluation test of the low-temperature pastability, except for setting the temperature of the roll pressing at 80°C. The obtained laminate was exposed, from the adhesive sheet side, at 1,000 mJ/$cm^2$ by a high-precision parallel exposure machine ("EXM-1172-B-∞"(trade name), made by ORC Manufacturing Co., Ltd.), and allowed to stand on a hot plate at 80°C for about 30 sec. After the base material (PET film) was peeled off and removed, by using a conveyer developing machine (made by Yako Co., Ltd.), the exposed laminate was developed by spraying using a 2.38-mass% solution of tetramethylammonium hydride (TMAH) as a developing solution under the condition of a temperature of 26°C and a spray pressure of 0.18 MPa, thereafter washed with pure water at a temperature of 25°C for 6 min under the condition of a spray pressure of 0.02 MPa, and dried at 150°C for 1 min. In such a way, an adhesive layer composed of the photosensitive adhesive composition was formed on the silicon wafer.

The obtained laminate composed of the silicon wafer and the adhesive layer was segmented into a size of 3 mm x 3 mm. The segmented laminate was dried at 150°C for 10 min for Examples i to vi and viii and Comparative Examples i to v and vii, and at 120°C for 10 min for Example vii and Comparative Example vi on a hot plate, and thereafter laminated on a glass substrate (10 mm x 10 mm x 0.55 mm) so that the adhesive layer was brought into contact with the glass substrate, and compression-bonded at 150°C for 10 sec under a pressure of 2 kgf. In such a way, a sample of a laminate composed of the silicon wafer, the adhesive layer and the glass substrate and obtained by laminating these in this order was obtained.

The obtained sample was heated in an oven at 180°C for 3 hours, and further heated on a hot plate at 260°C for 10 sec; thereafter, the sample was measured for the adhesive force using a shearing adhesive force tester "Dage-4000" (trade name). Measurement results are shown in Table 5 and Table 6.

(Pattern formability)

The pattern formability was evaluated as in Examples I to V and Comparative Examples I and II, except for setting the temperature of roll pressing at 80°C. Evaluation results are shown in Table 5 and Table 6.

(Low-temperature thermocompression bondability)

Adhesive patterns composed of the photosensitive adhesive composition were each formed on the silicon wafer as in the above-mentioned evaluation test of the pattern formability, except for using a picture frame-like 6-inch sized mask pattern (hollow parts: 2 mm, line width: 0.5 mm) in place of the above-mentioned mask for a negative-type pattern.

The silicon wafer with the adhesive pattern was dried at 150°C for 10 min for Examples i to vi and viii and Comparative Examples i to v and vii, and at 120°C for 10 min for Example vii and Comparative Example vi on a hot plate; thereafter, a glass substrate (15 mm x 40 mm x 0.55 mm) was laminated on the surface of the formed adhesive pattern on the opposite side to the silicon wafer, and compression-bonded at 150°C for 10 min under a pressure of 0.5 MPa to obtain a sample of a laminate composed of the silicon wafer, the adhesive pattern and the glass substrate and obtained by laminating these in this order.

The obtained sample was observed by a microscope (magnification: 50 times); and by denoting the case where the area of unadhered portions (vacancies) to the adhering area of the glass substrate and the adhesive pattern was 20% or less, as A, and denoting the case where that was 20% or more, as B, the evaluation of the low-temperature thermocompression bondability was carried out. Evaluation results are shown in Table 5 and Table 6.

(Heat resistance)

A sample of a laminate composed of the silicon wafer, the adhesive pattern and the glass substrate and obtained by laminating these in this order was obtained as in the above-mentioned evaluation test of the low-temperature thermocompression bondability. The obtained sample was heated at 180°C for 3 hours in an oven, and further allowed to stand on a hot plate at 260°C for 30 min. Thereafter, the sample was observed by a microscope (magnification: 50 times), and by denoting the case where no exfoliation of 1IC size or larger was found, as A, and denoting the case where there was observed exfoliation of 1IC size or larger, as B, the evaluation of the heat resistance was carried out. Evaluation

results are shown in Table 5 and Table 6.

(Moisture resistance)

The sample of the laminate was heated at 180°C for 3 hours in an oven as in the above-mentioned evaluation test of the heat resistance. After the sample after the heating was subjected to a treatment under the condition of a temperature of 85°C and a humidity of 60% for 168 hours, the sample was placed in an environment of a temperature of 25°C and a humidity of 50%, and observed for whether or not there was dew condensation on the inside of the glass, by a microscope (magnification: 50 times). By denoting the case where no dew condensation was observed, as A, and denoting the case where dew condensation was observed, as B, the evaluation of the moisture resistance (dew condensation resistance) was carried out. Evaluation results are shown in Table 5 and Table 6.

The sample of the laminate was heated at 180°C for 3 hours in an oven as in the above-mentioned evaluation test of the heat resistance. After the sample after the heating was subjected to a treatment under the condition of a temperature of 60°C and a humidity of 90% for 168 hours, the sample was placed in an environment of a temperature of 25°C and a humidity of 50%, and thereafter subjected to an IR reflow at 250°C for 10 sec, and observed for the presence/absence of exfoliation by a microscope (magnification: 50 times). By denoting the case where no exfoliation was observed, as A, and denoting the case where exfoliation was observed, as B, the evaluation of the moisture resistance (reflow resistance) was carried out. Evaluation results are shown in Table 5 and Table 6.

As is clear from the results in Table 5 and Table 6, the photosensitive adhesives or the adhesive sheets of Examples i to viii were remarkably superior in the low-temperature thermocompression bondability, the pattern formability, the heat resistance and the moisture resistance to the photosensitive adhesives or the adhesive sheets of Comparative Examples i to vii.

Examples a to e, and Comparative Examples a to e

<(A) components: polyimide resins>

(PI-3)

2.16 g (0.0075 mol) of 5,5'-methylene bis(anthranilic acid)(molecular weight: 286.3)(hereinafter, abbreviated to "MBAA"), 15.13 g (0.0335 mol) of a polyoxypropylenediamine (trade name "D-400", (molecular weight: 452.4), made by BASF AG) and 1.63 g (0.0065 mol) of 1,1,3,3-tetramethyl-1,3-bis(3-aminopropyl)disiloxane (trade name "BY16-871EG", made by Dow Corning Toray Co., Ltd.) as diamines, and 115 g of NMP (N-methyl-2-pyrrolidone) as a solvent were charged in a 300-mL flask equipped with a stirrer, a thermometer and a nitrogen replacing device (nitrogen inflow tube), and stirred to dissolve the diamines in the solvent.

While the flask was being cooled in an ice bath, 16.51 g (0.051 mol) of 4,4'-oxydiphthalic acid dianhydride (hereinafter, abbreviated to "ODPA") was added little by little in the solution in the flask. After the completion of the addition, the solution was stirred at room temperature for 5 hours. Thereafter, a reflux cooler with a moisture-receiving vessel was attached to the flask; 81 g of xylene was added thereto; and the solution was heated to 180°C and held at the temperature for 5 hours while nitrogen gas was being blown in, to azeotropically remove xylene with water, to obtain a polyimide resin (PI-3). The measurement of (PI-3) by GPC revealed that the weight-average molecular weight in terms of polystyrene was (Mw) = 30,000. Tg of (PI-3) was 31°C.

(PI-6)

20.5 g of 2,2-bis(4-(4-aminophenoxy)phenyl)propane (molecular weight: 410.5)(hereinafter, abbreviated to "BAPP") as a diamine, and 101 g of NMP as a solvent were charged in a flask equipped with a stirrer, a thermometer and a nitrogen replacing device, and stirred to dissolve the diamine in the solvent.

While the flask was being cooled in an ice bath, 20.5 g of 1,2-(ethylene) bis(trimellitate anhydride)(molecular weight: 410.3)(hereinafter, abbreviated to "EBTA") was added little by little in the solution in the flask. After the completion of the addition, the solution was stirred at room temperature for 5 hours. Thereafter, a reflux cooler with a moisture-receiving vessel was attached to the flask; 67 g of xylene was added thereto; and the solution was heated to 180°C and held at the temperature for 5 hours while nitrogen gas was being blown in, to azeotropically remove xylene with water. After the obtained solution was cooled to room temperature, the solution was charged in distilled water to reprecipitate and obtain a polyimide resin (PI-6). The measurement of (PI-6) by GPC revealed that the weight-average molecular weight in terms of polystyrene was (Mw) = 98,000. Tg of (PI-6) was 180°C. (PI-6) exhibited no alkali-solubility.

<Photosensitive adhesive compositions>

By using the polyimide resins (PI-3) and (PI-6) obtained as described above, each component was formulated in a compositional ratio (unit: parts by mass) indicated in Tables 7 and 8 shown below, and photosensitive adhesive compositions (vanishes for forming an adhesive layer) of Examples a to e and Comparative Examples a to e were obtained.

In Tables 7 and 8, each abbreviation means the following.

BPE-100: ethoxylated bisphenol A dimethacrylate (the equivalent weight of the radiation-polymerizable functional group: 240 g/eq, the 5%-weight loss temperature: 330°C), made by Shi-Nakamura Chemical Co., Ltd.
BPE-500: ethoxylated bisphenol A dimethacrylate (the equivalent weight of the radiation-polymerizable functional group: 565 g/eq, the 5%-weight loss temperature: 330°C), made by Shi-Nakamura Chemical Co., Ltd.
A-9300: isocyanuric acid EO-modified triacrylate (the equivalent weight of the radiation-polymerizable functional group: 140 g/eq, the 5%-weight loss temperature: >400°C), made by Shi-Nakamura Chemical Co., Ltd.
U-2PPA: a bifunctional urethane acrylate (the equivalent weight of the radiation-polymerizable functional group: 230 g/eq, the 5%-weight loss temperature: 160°C), made by Shi-Nakamura Chemical Co., Ltd.
VG-3101: a trifunctional epoxy resin (the 5%-weight loss temperature: 350°C), made by Printec Co., Ltd.
YDF-870GS: bisphenol F bisglycidyl ether (the 5%-weight loss temperature: 270°C), made by Tohto Kasei Co., Ltd.
TrisP-PA: a trisphenol compound (α,α, α'-tris(4-hydroxyphenol)-1-ethyl-4-isopropylbenzene) (the 5%-weight loss temperature: 350°C), made by Honshu Chemical Industry Co., Ltd.
R-972: hydrophobic fumed silica (average particle diameter: about 16 nm), made by Nippon Aerosil Co., Ltd.
I-819: bis(2,4,6-trimethylbenzoyl)-phenylphosphine oxide, made by Ciba Speciality Chemicals Corp.
Perhexa 25B: 2,5-dimethyl-2,5-di(t-butylperoxyhexane) (the one-minute half-life temperature: 180°C), made by NOF Corp.
Percumyl D: dicumyl peroxide (the one-minute half-life temperature: 175°C), made by NOF Corp.
Peroyl L: dilauroyl peroxide (the one-minute half-life temperature: 116°C), made by NOF Corp.
NMP: N-methyl-2-pyrrolidone, made by Kanto Chemical Co., Ltd.

[Table 7]

| | | | Examples | | | | |
|---|---|---|---|---|---|---|---|
| | | | a | b | c | d | e |
| (A) Polyimide Resin | | PI-3 | 100 | 100 | 100 | 100 | 100 |
| Curable Components | (C) Radiation-Polymerizable Compounds | BPE-100 | 40 | 40 | 40 | - | - |
| | | BPE-500 | - | - | - | 40 | 40 |
| | | A-9300 | 20 | - | 20 | 40 | - |
| | | U-2PPA | - | 40 | - | - | 40 |
| | (B) Thermosetting Resins | VG-3101 | 5 | 5 | 5 | 5 | 5 |
| | | YDF-870GS | 10 | 10 | 10 | 10 | 10 |
| | Curing Agent | TrisP-PA | 5 | 5 | 5 | 5 | 5 |
| (D) Photoinitiator | | I-819 | 3 | 3 | 3 | 3 | 3 |
| Filler | | R-972 | 5 | 5 | 30 | 30 | 30 |
| (E) Thermal Radical Generating Agent | | Perhexa 25B | - | 2 | - | 2 | - |
| | | Percumyl D | 2 | - | 2 | - | 2 |
| Coating Solvent | | NMP | 220 | 220 | 211 | 210 | 210 |
| Low-Temperature Pastability | | | A | A | A | A | A |
| Pattern Formability | | | A | A | A | A | A |
| Low-Temperature Thermocompression Bondability | | | A | A | A | A | A |
| High-Temperature Adhesivity (MPa) | | | 0.73 | 0.7 | 1.2 | 0.5 | 0.4 |
| Moisture Resistance | | | A | A | A | A | A |

[Table 8]

| | | | Comparative Examples | | | | |
|---|---|---|---|---|---|---|---|
| | | | a | b | c | d | e |
| (A) Polyimide Resin | | PI-3 | 100 | 100 | 100 | 100 | - |
| | | PI-6 | - | - | - | - | 100 |
| Curable Components | (C) Radiation-Polymerizable Compounds | BPE-100 | 40 | 40 | - | 40 | 40 |
| | | BPE-500 | - | - | 40 | - | - |
| | | A-9300 | 20 | 20 | 40 | - | 20 |
| | | U-2PPA | - | - | - | 40 | - |
| | (B) Thermosetting Resins | VG-3101 | 5 | 5 | 5 | 5 | 5 |
| | | YDF-870GS | 10 | 10 | 10 | 10 | 10 |
| | Curing Agent | TrisP-PA | 5 | 5 | 5 | 5 | 5 |
| (D) Photoinitiator | | I-819 | 3 | 3 | 3 | 3 | 3 |
| (E) Thermal Radical Generating Agent | | Percumyl D | - | - | - | - | 2 |
| | | Peroyl L | - | 2 | - | - | - |
| Coating Solvent | | NMP | 220 | 210 | 216 | 210 | 216 |
| Low-Temperature Pastability | | | A | B | A | A | B |
| Pattern Formability | | | A | B | A | A | B |
| Low-Temperature Thermocompression Bondability | | | A | B | A | A | B |
| High-Temperature Adhesivity (MPa) | | | 0.30 | 0.03 | 0.20 | 0.24 | 0.39 |
| Moisture Resistance | | | B | - | B | B | - |

<Adhesive sheets>

The obtained photosensitive adhesive compositions of Examples a to e and Comparative Examples a to e were each applied on a base material (release agent-treated PET film) so that the film thickness after drying became 50 μm, heated at 80°C for 20 min in an oven, and then heated at 120°C for 20 min to form an adhesive layer composed of the photosensitive adhesive composition on the base material. In such a way, an adhesive sheet having the base material and the adhesive layer formed on the base material was obtained. The adhesive sheets obtained from the photosensitive adhesive compositions of Examples a to e and Comparative Examples a to e were made adhesive sheets of Examples a to e and Comparative Examples a to e, respectively.

<Evaluation tests>

(Low-temperature pastability)

The low-temperature pastability was evaluated as in Examples I to V and Comparative Examples I and II. Evaluation results are shown in Table 7 and Table 8.

(High-temperature (260°C) adhesivity)

The adhesive sheets were each laminated on the silicon wafer as in the above-mentioned evaluation test of the low-temperature pastability, except for setting the temperature of the roll pressing at 50°C for Examples a to e and Comparative Examples a to d, and at 200°C for Comparative Example e. The obtained laminate was exposed, from the adhesive sheet side, at 1,000 $mJ/cm^2$ by a high-precision parallel exposure machine ("EXM-1172-B-∞"(trade name), made by ORC Manufacturing Co., Ltd.), and allowed to stand on a hot plate at 80°C for about 30 sec. After the base material (PET film) was peeled off and removed, by using a conveyer developing machine (made by Yako Co., Ltd.), the exposed laminate was developed by spraying using a 2.38-mass% solution of tetramethylammonium hydride (TMAH) as a developing solution under the condition of a temperature of 26°C and a spray pressure of 0.18 MPa, thereafter

washed with pure water at a temperature of 25°C for 6 min under the condition of a spray pressure of 0.02 MPa, and dried at 150°C for 1 min. In such a way, an adhesive layer composed of the photosensitive adhesive composition was formed on the silicon wafer.

The obtained laminate composed of the silicon wafer and the adhesive layer was segmented into a size of 5 mm x 5 mm. The segmented laminate was dried at 150°C for 10 min, and thereafter laminated on a glass substrate (10 mm x 10 mm x 0.55 mm) so that the adhesive layer was brought into contact with the glass substrate, and compression-bonded at 150°C for Examples a to e and Comparative Examples a to d and at 300°C for Comparative Example e for 10 sec under a pressure of 2 kgf. In such a way, a sample of a laminate composed of the silicon wafer, the adhesive layer and the glass substrate and obtained by laminating these in this order was obtained.

The obtained sample was heated in an oven at 150°C for 3 hours, and further heated on a hot plate at 260°C for 10 sec; thereafter, the sample was measured for the adhesive force using a shearing adhesive force tester "Dage-4000" (trade name). Measurement results are shown in Table 7 and Table 8.

(Low-temperature thermocompression bondability)

The evaluation test of the low-temperature thermocompression bondability was carried out as in Examples I to V and Comparative Examples I and II, except for setting the temperature of roll pressing at 50°C. Results are shown in Table 7 and Table 8.

(Pattern formability)

The evaluation test of the pattern formability was carried out as in Examples I to V and Comparative Examples I and II, except for setting the temperature of roll pressing at 100°C for Examples a to e and Comparative Examples a to d, and at 200°C for Comparative Example e. Results are shown in Table 7 and Table 8.

(Moisture resistance)

The adhesive sheets were each laminated on the silicon wafer as in the above-mentioned evaluation test of the high-temperature adhesivity. The obtained laminate was exposed at 500 mJ/$cm^2$ by a high-precision parallel exposure machine from the adhesive sheet side through a picture frame-like 6-inch sized mask pattern (hollow parts: 2 mm, line width: 0.5 mm), and allowed to stand on a hot plate at 80°C for about 30 sec. After the base material (PET film) was peeled off and removed, by using a conveyer developing machine, the exposed laminate was developed by spraying using a 2.38-mass% solution of TMAH as a developing solution under the condition of a temperature of 26°C and a spray pressure of 0.18 MPa, and thereafter washed with pure water at a temperature of 25°C for 6 min under the condition of a spray pressure of 0.02 MPa. After the silicon wafer with the adhesive layer was dried at 150°C for 1 min, a glass substrate (15 mm x 40 mm x 0.55 mm) was mounted thereon so that the adhesive layer was on the glass substrate side, and compression-bonded at a temperature of 150°C for the adhesive sheets of Examples a to e and Comparative Examples a to d, and at a temperature of 300°C for the adhesive sheet of Comparative Example e for 10 min under a pressure of 0.5 MPa. A test piece thus obtained was thermoset at 150°C for 3 hours in an oven.

The sample obtained for evaluation was tested for the moisturing reliability test. After the evaluation sample was subjected to a treatment under the condition of a temperature of 85°C and a humidity of 85% for 48 hours, the evaluation sample was placed in an environment of a temperature of 25°C and a humidity of 50%, and observed for whether or not dew condensation was on the inside of the glass, by a microscope (magnification: 50 times). The evaluation was carried out by denoting the case where no dew condensation was observed, as A, and denoting the case where dew condensation was observed, as B. Results are shown in Table 7 and Table 8.

As is clear from the results in Table 7 and Table 8, the photosensitive adhesives or the adhesive sheets of Examples a to e were remarkably superior in the low-temperature pastability, the low-temperature thermocompression bondability, the pattern formability, the high-temperature adhesivity and the moisture resistance to the photosensitive adhesives or the adhesive sheets of Comparative Examples a to e.

Industrial Applicability

Since the photosensitive adhesive composition according to the present invention is excellent in the low-temperature thermocompression bondability, the photosensitive adhesive composition can suitably be used for applications to protection of semiconductor elements, optical elements, solid-state image pickup devices and the like, or applications to wafer circuit protection films including adhesives and/or buffer coats requiring fine adhesive regions, and can improve the reliability of apparatuses having these.

Reference Signs List

1 ... Film adhesive (Adhesive layer), 1a ... Adhesive pattern, 2 ... Cover film, 3 ... Base material, 4 ... Mask, 5 ... Composite film, 6 ... Sticky adhesive layer, 7 ... Glass substrate, 8 ... Semiconductor wafer, 9 ... Electroconductive layer, 11 ... Opening, 12, 12a, 12b ... Semiconductor element (Semiconductor chip), 13 ... Support member for mounting semiconductor element (Support member), 14, 14a, 14b ... Wire, 15 ... Sealing material, 16 ... Terminal, 17 ... Effective pixel region, 18 ... Circuit surface, 20 ... Semiconductor wafer with adhesive layer, 30 ... Die bonding material, 32 ... Electroconductive bump, 38 ... Lens, 40 ... Dicing tape, 42 ... Fitting-in member, 50 ... Side wall, 100 ... Adhesive sheet, 200 ... Semiconductor device, 300 ... CMOS sensor, D ... Dicing line.

A photosensitive adhesive composition, having a lowest melt viscosity at 20°C to 200°C after pattern formation of 30,000 Pa·s or lower.

The photosensitive adhesive composition according to claim 1, comprising (A) an alkali-soluble resin, (B) a thermosetting resin, (C) a radiation-polymerizable compound, and (D) a photoinitiator.

The photosensitive adhesive composition, wherein (C) the radiation-polymerizable compound has an average functional group equivalent weight of 230 g/eq or more.

The photosensitive adhesive composition, wherein (C) the radiation-polymerizable compound comprises a (meth)acrylate having a urethane bond and/or an isocyanuric ring.

The photosensitive adhesive composition, wherein (C) the radiation-polymerizable compound comprises a monofunctional (meth)acrylate.

The photosensitive adhesive composition, wherein the monofunctional (meth)acrylate has a 5%-weight loss temperature of 150°C or higher.

The photosensitive adhesive composition, wherein the monofunctional (meth)acrylate is a monofunctional (meth)acrylate having an epoxy group.

The photosensitive adhesive composition, wherein (B) the thermosetting resin comprises an epoxy resin.

The photosensitive adhesive composition, wherein (A) the alkali-soluble resin has a Tg of 150°C or lower.

The photosensitive adhesive composition, wherein (A) the alkali-soluble resin is a thermoplastic resin having a carboxyl group and/or a hydroxyl group.

The photosensitive adhesive composition, wherein (A) the alkali-soluble resin is a polyimide resin.

The photosensitive adhesive composition, further comprising (E) a thermal radical generating agent.

The photosensitive adhesive composition, wherein (E) the thermal radical generating agent is an organic peroxide.

A film adhesive, being obtained by forming the photosensitive adhesive composition into a film form.

An adhesive sheet, comprising a base material, and an adhesive layer comprising the film adhesive, formed on the base material.

An adhesive pattern, being obtained by exposing an adhesive layer comprising the film adhesive laminated on an adherend via a photomask, and subjecting the adhesive layer after the exposure to a development treatment with an alkali developing solution.

A semiconductor wafer with an adhesive layer, comprising a semiconductor wafer, and the adhesive layer comprising the film adhesive laminated on the semiconductor wafer.

A semiconductor device, having a structure in which semiconductor elements and/or a semiconductor element and a support member for mounting a semiconductor element are adhered by using the photosensitive adhesive composition.

The semiconductor device, wherein the support member for mounting a semiconductor element is a transparent substrate.

A photosensitive adhesive composition, comprising (A) an alkali-soluble resin, (B) a thermosetting resin, (C) a radiation-polymerizable compound, and (D) a photoinitiator, wherein (C) the radiation-polymerizable compound has an average functional group equivalent weight of 230 g/eq or more.

The photosensitive adhesive composition, wherein (C) the radiation-polymerizable compound comprises a (meth)acrylate having a urethane bond and/or an isocyanuric ring.

The photosensitive adhesive composition, wherein (B) the thermosetting resin comprises an epoxy resin.

The photosensitive adhesive composition, wherein (A) the alkali-soluble resin has a Tg of 150°C or lower.

The photosensitive adhesive composition, wherein (A) the alkali-soluble resin is a thermoplastic resin having a carboxyl group and/or a hydroxyl group.

The photosensitive adhesive composition, wherein (A) the alkali-soluble resin is a polyimide resin.

A film adhesive, being obtained by forming the photosensitive adhesive composition into a film form.

An adhesive sheet, comprising a base material, and an adhesive layer comprising the film adhesive formed on the base material.

An adhesive pattern, being obtained by exposing an adhesive layer comprising the film adhesive laminated on an adherend via a photomask, and subjecting the adhesive layer after the exposure to a development treatment with an alkali developing solution.

A semiconductor wafer with an adhesive layer, comprising a semiconductor wafer, and the adhesive layer comprising

the film adhesive laminated on the semiconductor wafer.
A semiconductor device, having a structure in which semiconductor elements and/or a semiconductor element and a support member for mounting a semiconductor element are adhered by using the photosensitive adhesive composition.
The semiconductor device, wherein the support member for mounting a semiconductor element is a transparent substrate.
A photosensitive adhesive composition, comprising (A) a thermoplastic resin, (B) a thermosetting resin, (C) a radiation-polymerizable compound, and (D) a photoinitiator, wherein (C) the radiation-polymerizable compound comprises a compound having an ethylenically unsaturated group and an epoxy group.
The photosensitive adhesive composition, wherein (A) the thermoplastic resin is an alkali-soluble resin.
The photosensitive adhesive composition, wherein the compound having an ethylenically unsaturated group and an epoxy group has a 5%-weight loss temperature of 150°C or higher.
The photosensitive adhesive composition, wherein the compound having an ethylenically unsaturated group and an epoxy group is a monofunctional (meth)acrylate having an epoxy group.
The photosensitive adhesive composition, wherein (B) the thermosetting resin comprises an epoxy resin.
The photosensitive adhesive composition, wherein the alkali-soluble resin has a Tg of 150°C or lower.
The photosensitive adhesive composition, wherein the alkali-soluble resin is a thermoplastic resin having a carboxyl group and/or a hydroxyl group.
The photosensitive adhesive composition, wherein the alkali-soluble resin is a polyimide resin.
The photosensitive adhesive composition, further comprising (E) a thermal radical generating agent.
The photosensitive adhesive composition, wherein (E) the thermal radical generating agent is an organic peroxide.
A film adhesive, being obtained by forming the photosensitive adhesive composition into a film form.
An adhesive sheet, comprising a base material, and an adhesive layer comprising the film adhesive formed on the base material.
An adhesive pattern, being obtained by exposing an adhesive layer comprising the film adhesive laminated on an adherend via a photomask, and subjecting the adhesive layer after the exposure to a development treatment with an alkali developing solution.
A semiconductor wafer with an adhesive layer, comprising a semiconductor wafer, and the adhesive layer comprising the film adhesive laminated on the semiconductor wafer.
A semiconductor device, having a structure in which semiconductor elements and/or a semiconductor element and a support member for mounting a semiconductor element are adhered by using the photosensitive adhesive composition.
The semiconductor device according to claim 46, wherein the support member for mounting a semiconductor element is a transparent substrate.

**Claims**

1. A photosensitive adhesive composition, comprising (A) a thermoplastic resin, (B) a thermosetting resin, (C) a radiation-polymerizable compound, and (D) a photoinitiator, wherein (C) the radiation-polymerizable compound comprises a compound having an ethylenically unsaturated group and an epoxy group.

2. The photosensitive adhesive composition according to claim 1, wherein (A) the thermoplastic resin is an alkali-soluble resin.

3. The photosensitive adhesive composition, according to claim 1 or 2, wherein the compound having an ethylenically unsaturated group and an epoxy group has a 5%-weight loss temperature of 150°C or higher.

4. The photosensitive adhesive composition according to any one of claims 1 to 3, wherein the compound having an ethylenically unsaturated group and an epoxy group is a monofunctional (meth)acrylate having an epoxy group.

5. The photosensitive adhesive composition according to any one of claims 2 to 4, wherein the alkali-soluble resin has a Tg of 150°C or lower.

6. The photosensitive adhesive composition according to any one of claims 2 to 5 wherein the alkali-soluble resin is a thermoplastic resin having a carboxyl group and/or a hydroxyl group.

7. The photosensitive adhesive composition according to any one of claims 2 to 6, wherein the alkali-soluble resin is a polyimide resin.

8. The photosensitive adhesive composition according to any one of claims 1 to 7, further comprising (E) a thermal

radical generating agent.

**9.** The photosensitive adhesive composition according to claim 8, wherein (E) the thermal radical generating agent is an organic peroxide.

**10.** A film adhesive, being obtained by forming the photosensitive adhesive composition according to any one of claims 1 to 9 into a film form.

**11.** An adhesive sheet, comprising a base material, and an adhesive layer comprising the film adhesive according to claim 10 formed on the base material.

**12.** An adhesive pattern, being obtained by exposing an adhesive layer comprising the film adhesive according to claim 10 laminated on an adherend via a photomask, and subjecting the adhesive layer after the exposure to a development treatment with an alkali developing solution.

**13.** A semiconductor wafer with an adhesive layer, comprising a semiconductor wafer, and the adhesive layer comprising the film adhesive according to claim 10 laminated on the semiconductor wafer.

**14.** A semiconductor device, having a structure in which semiconductor elements and/or a semiconductor element and a support member for mounting a semiconductor element are adhered by using the photosensitive adhesive composition according to any one of claims 1 to 9.

**15.** The semiconductor device according to claim 14, wherein the support member for mounting a semiconductor element is a transparent substrate.

Fig.1

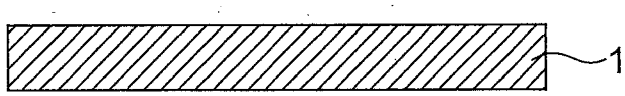

Fig.2

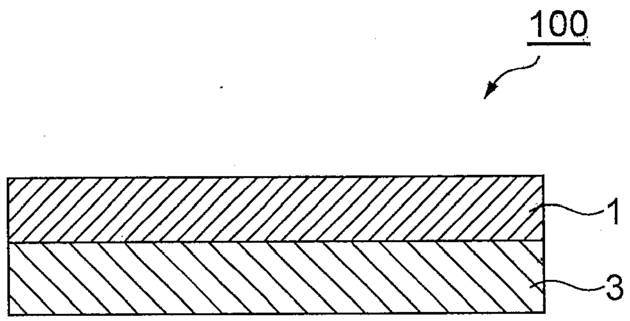

*Fig.3*

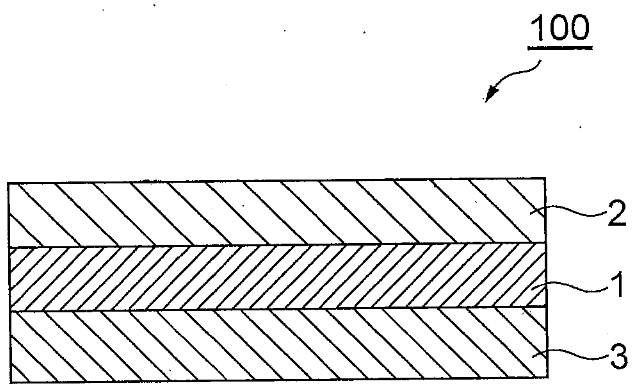

Fig.4

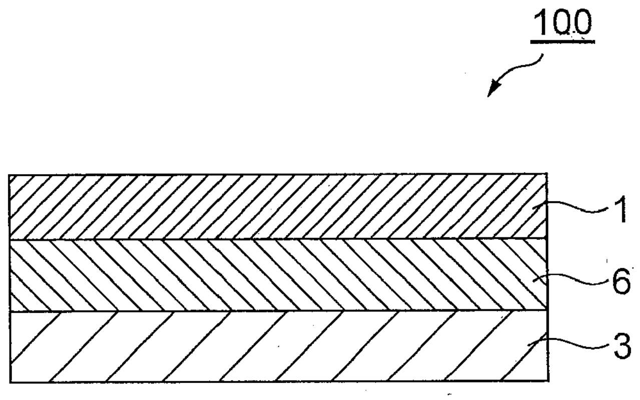

*Fig.5*

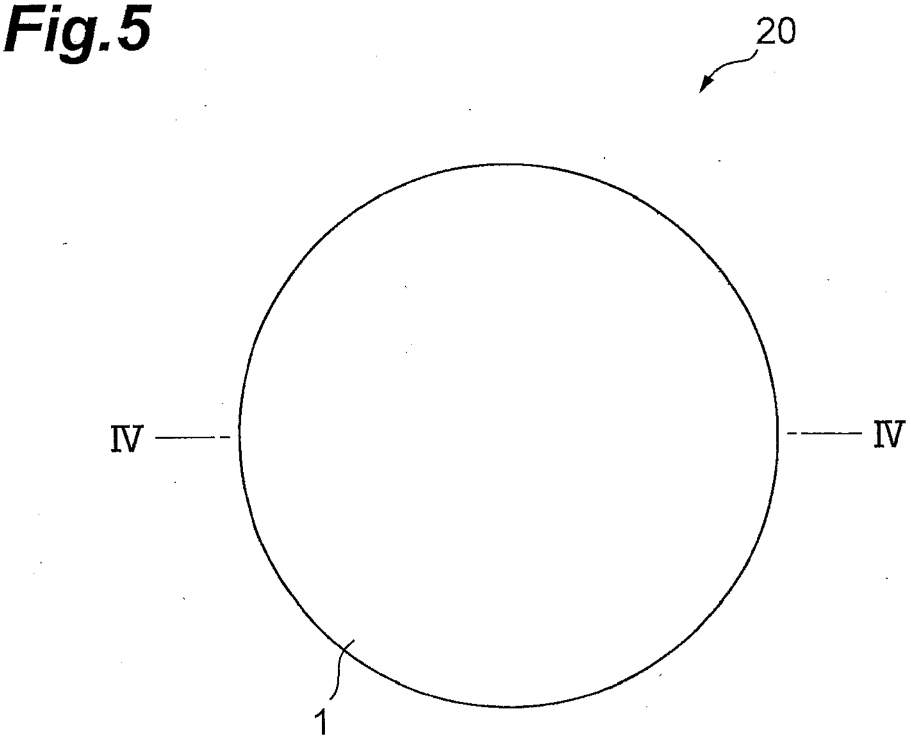

*Fig.6*

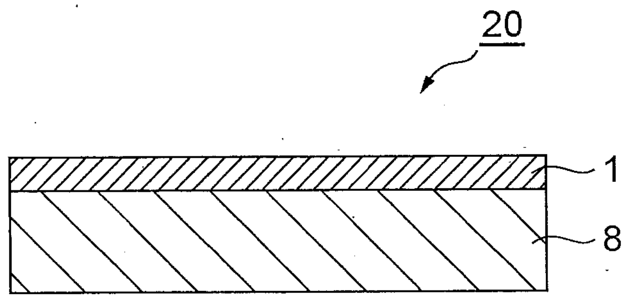

Fig.7

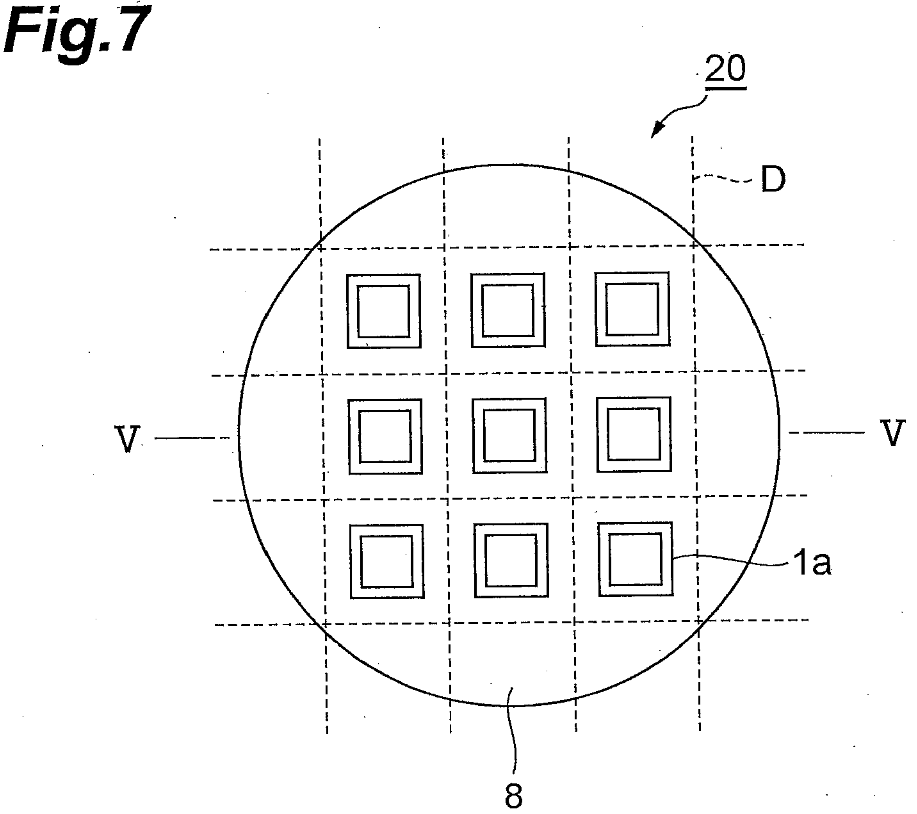

Fig.8

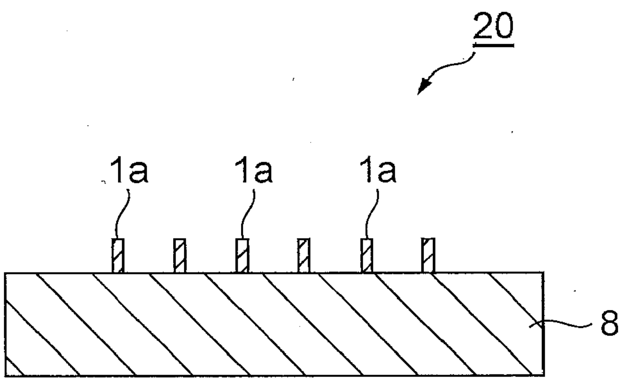

Fig.9

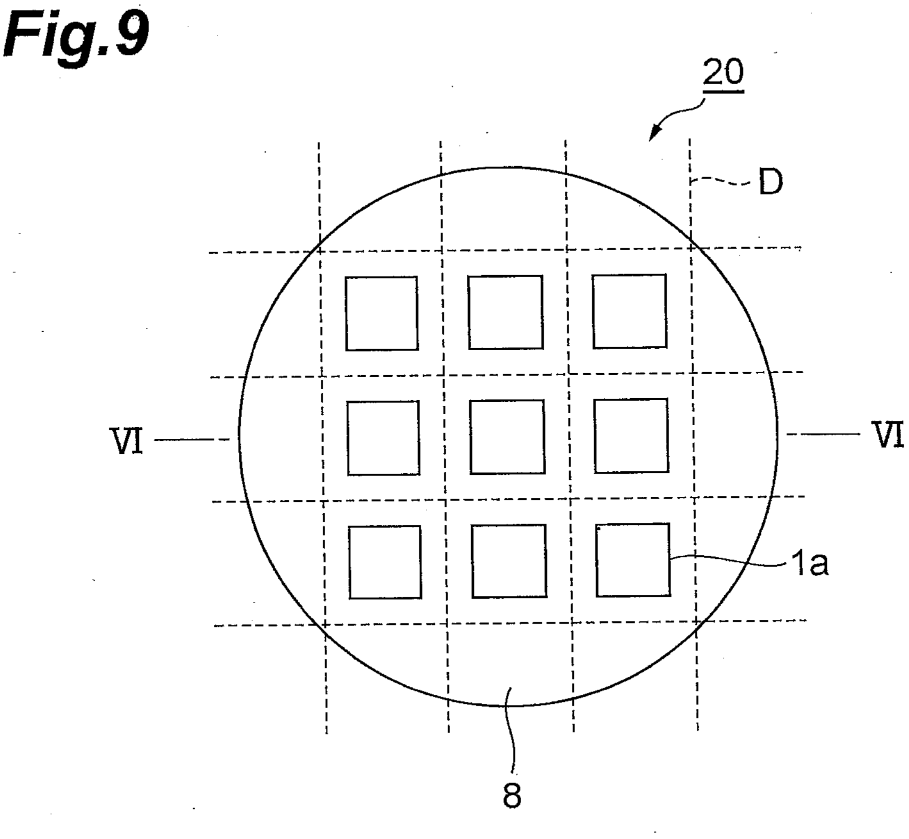

Fig.10

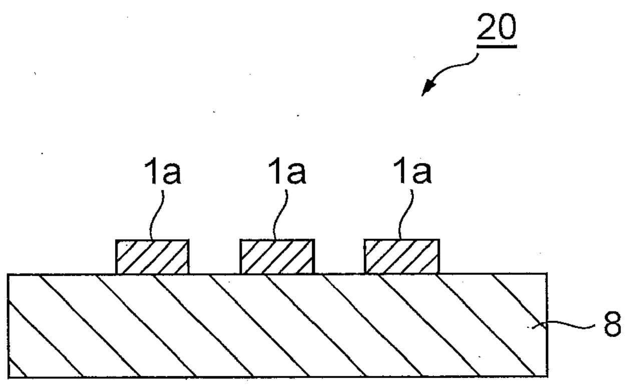

Fig.11

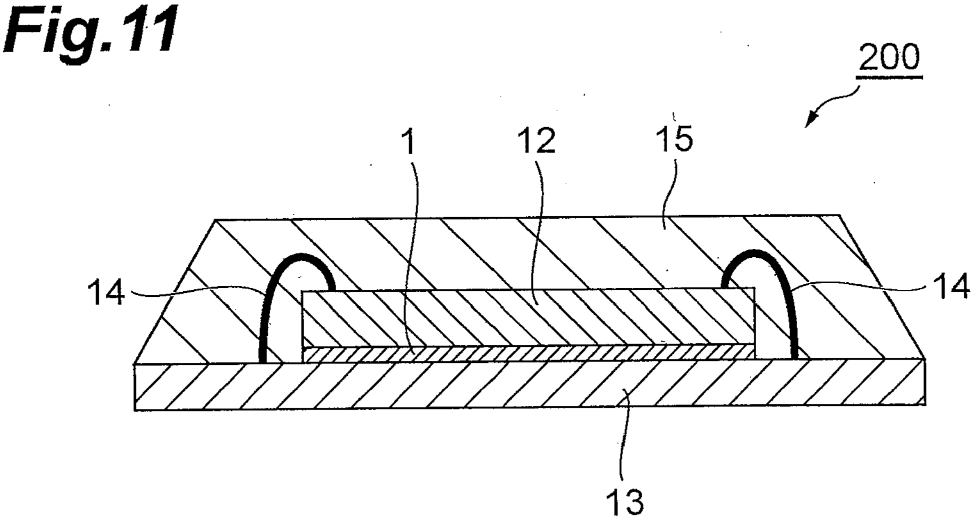

Fig.12

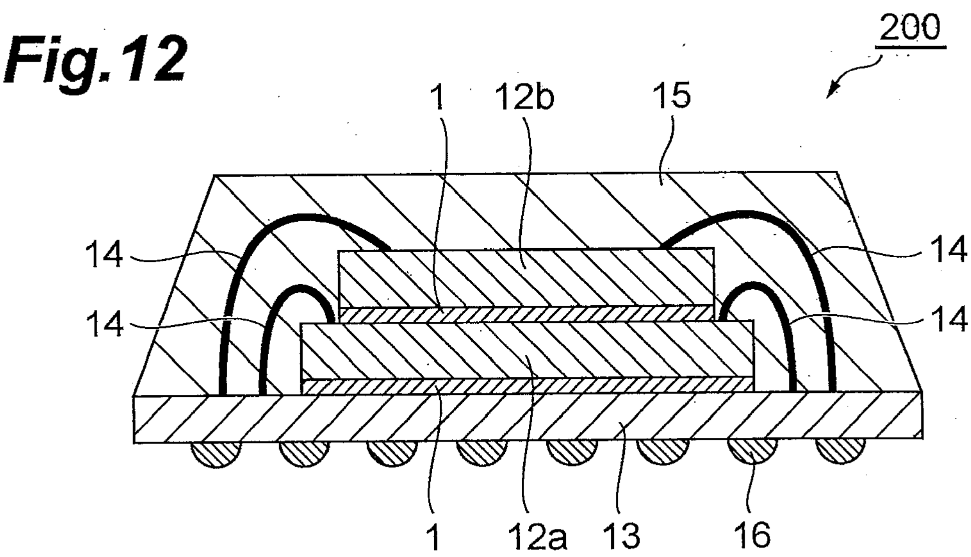

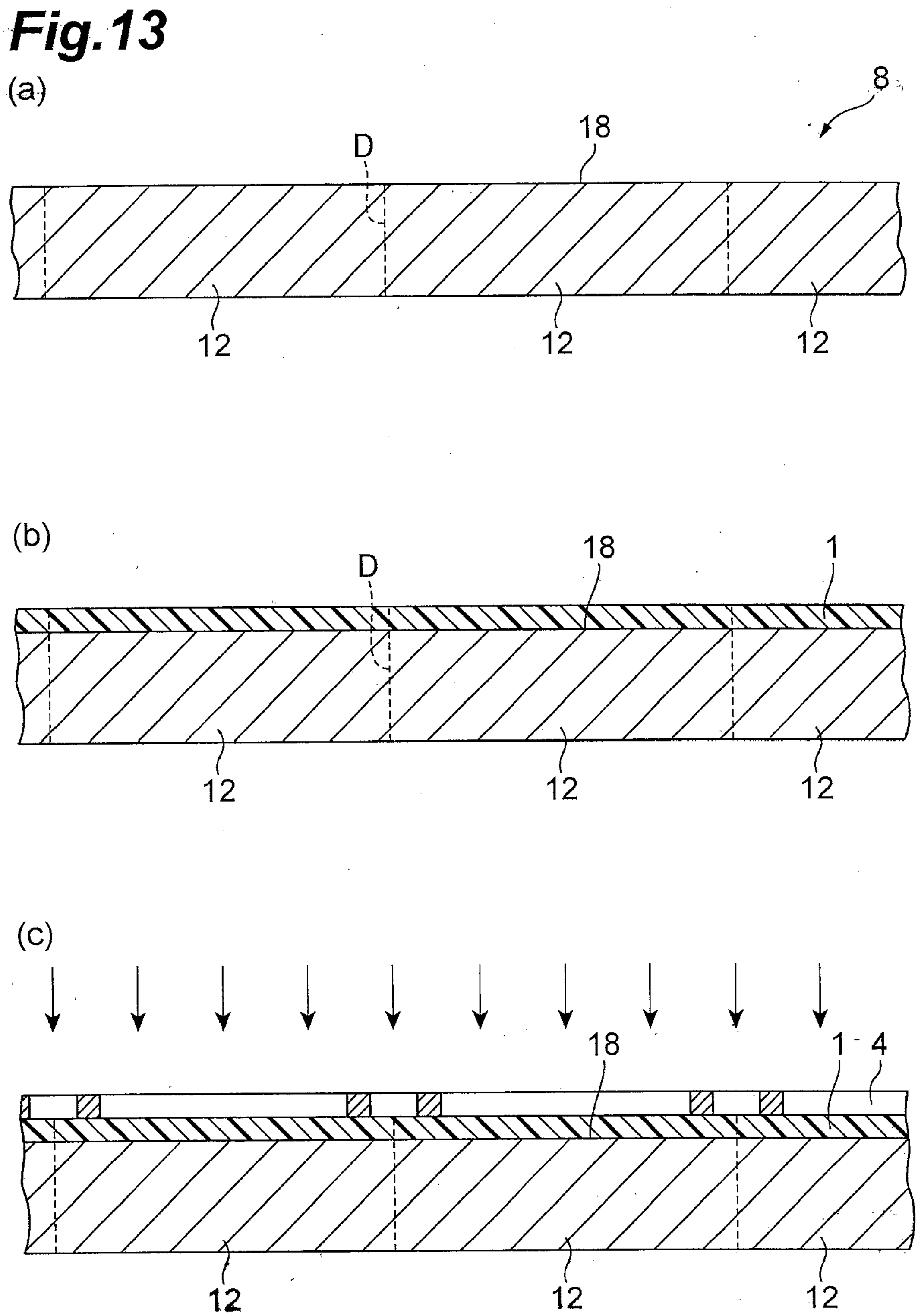
Fig.13
(a)
8
18
D
12
12
12
(b)
D
18
1
12
12
12
(c)
18
1
4
12
12
12

Fig.14

(a)

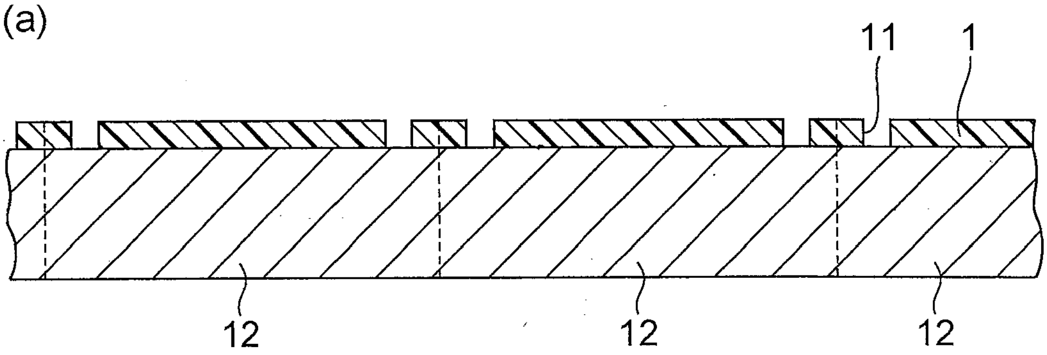


(b)

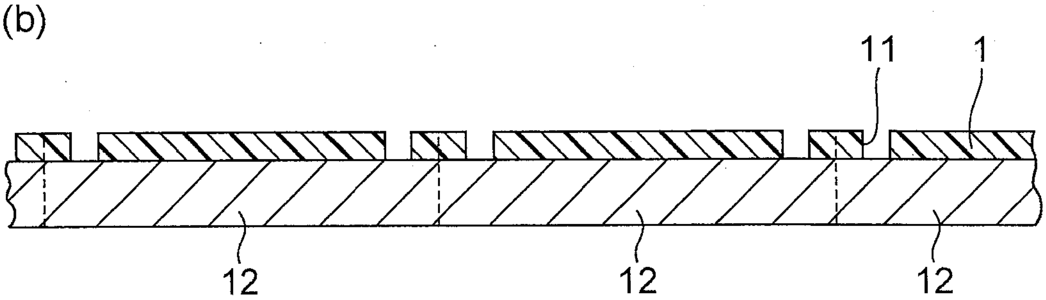


(c)

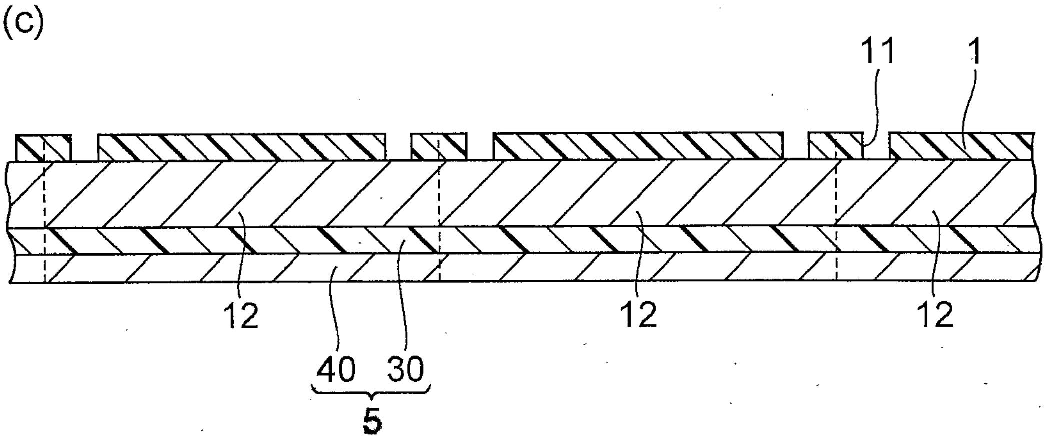

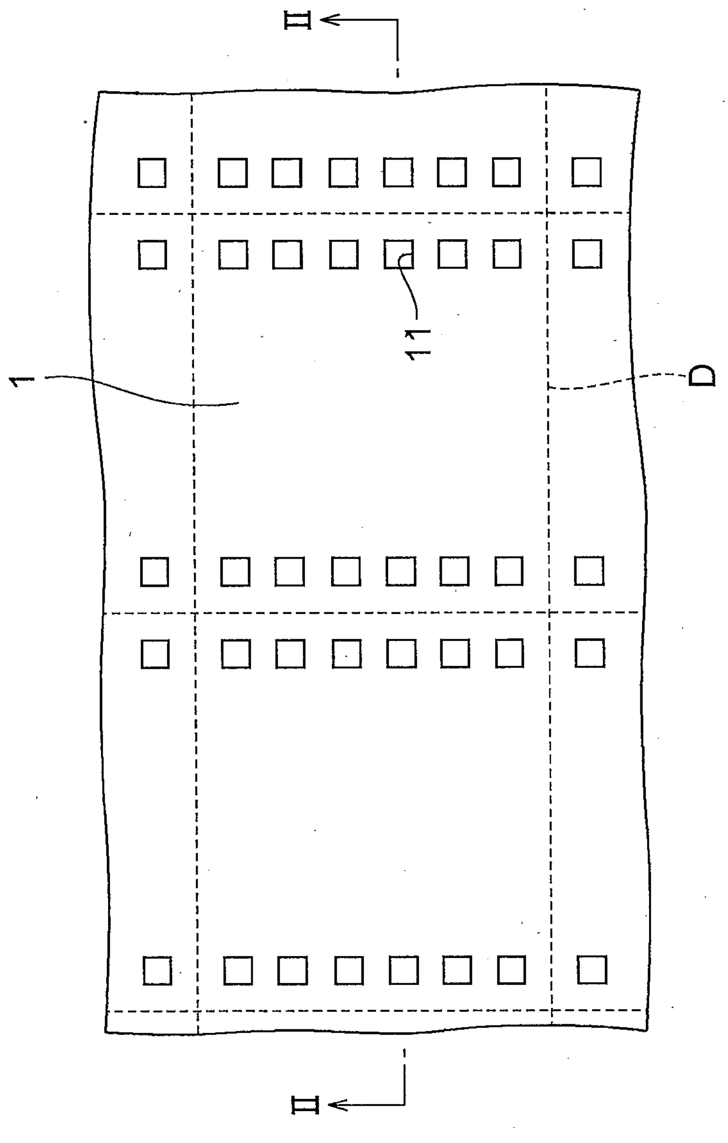


Fig.15

Fig.16

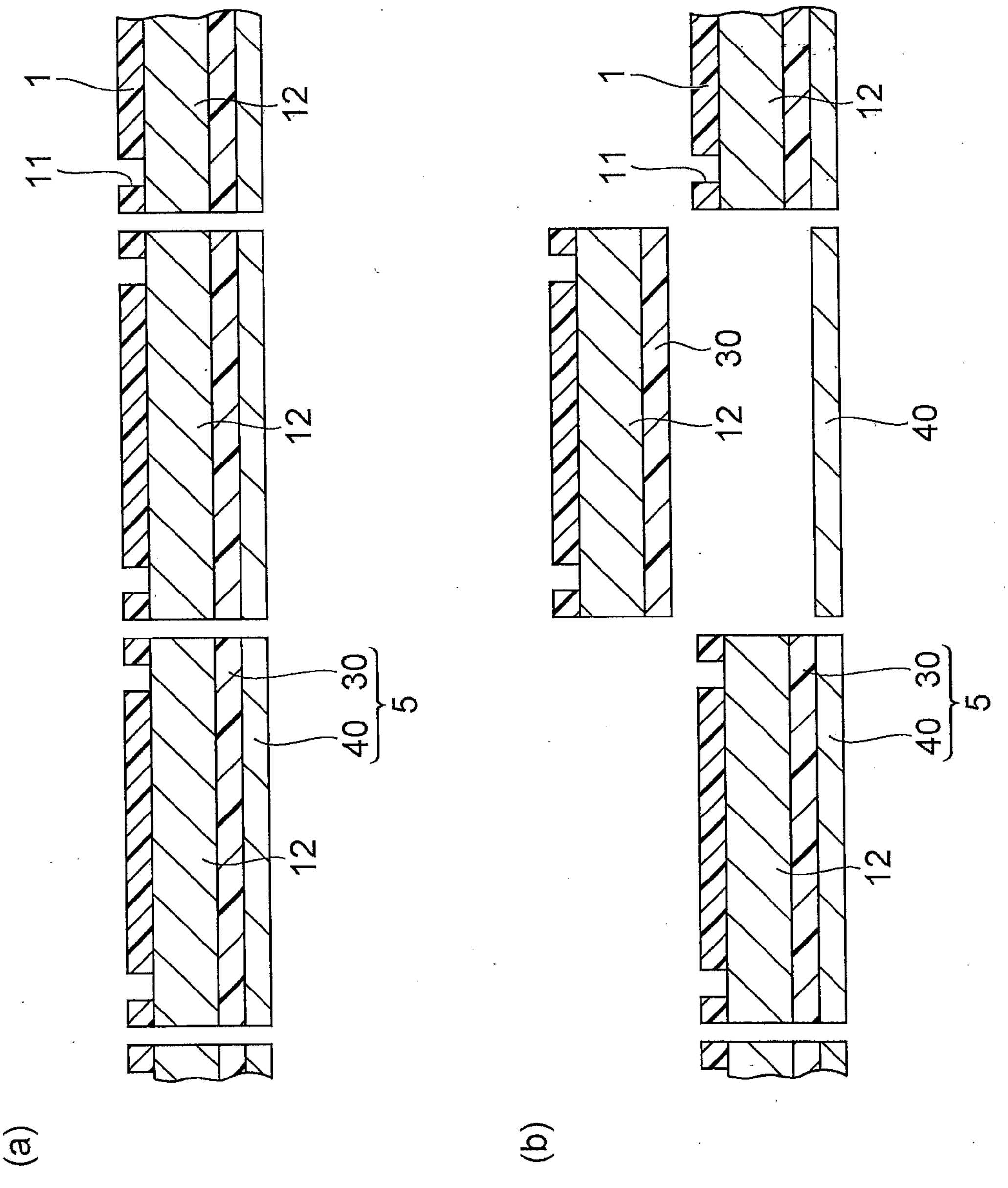

Fig.17

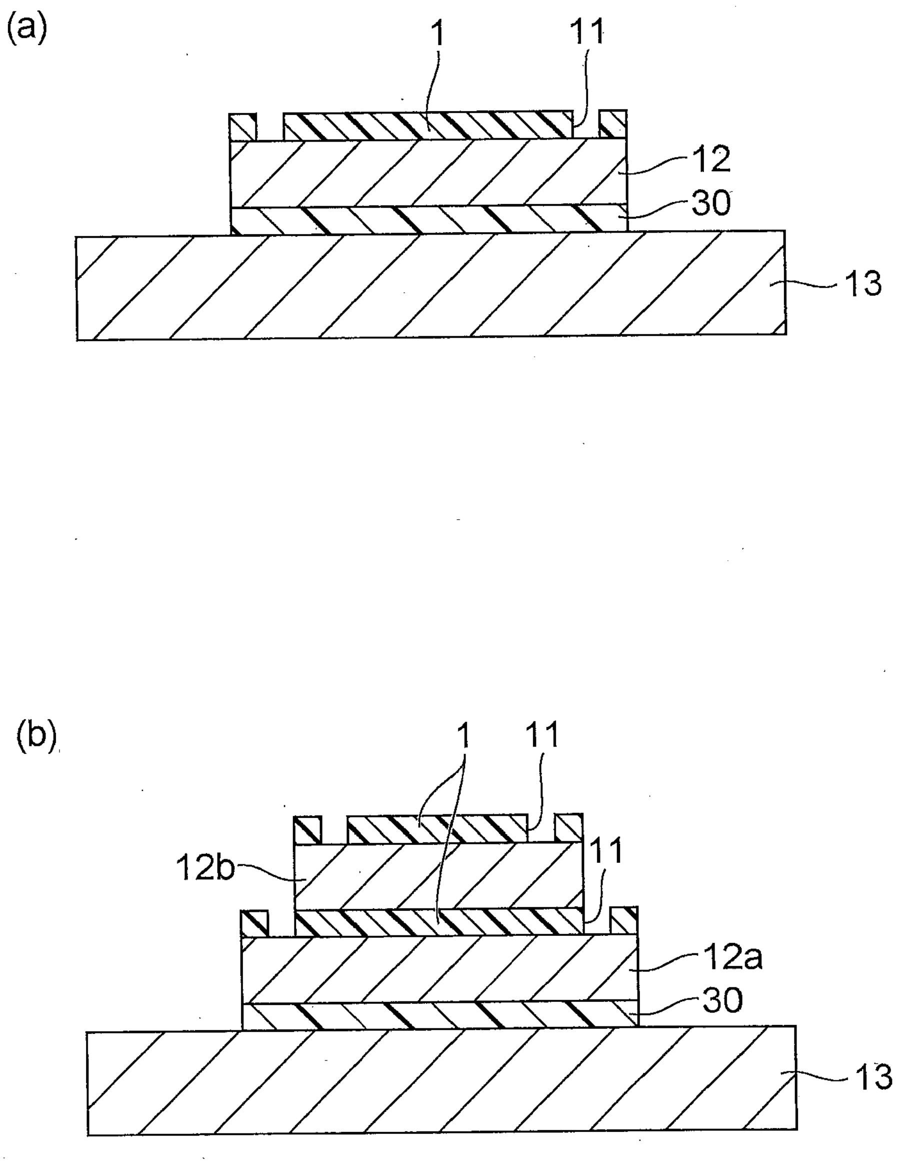

Fig.18

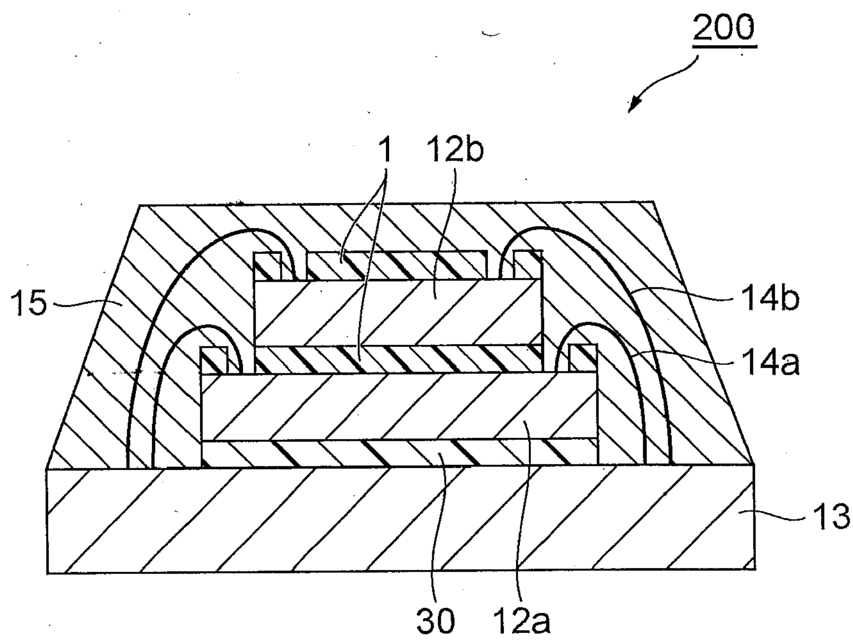

# Fig.19

(a)

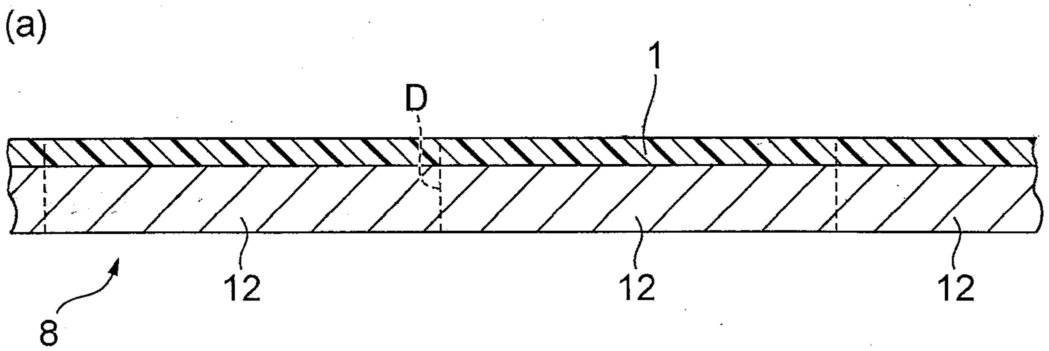


(b)

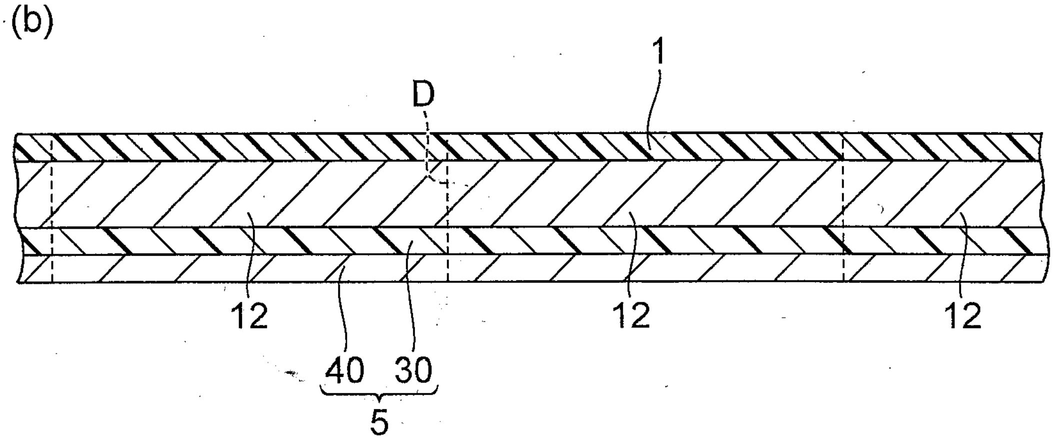


(c)

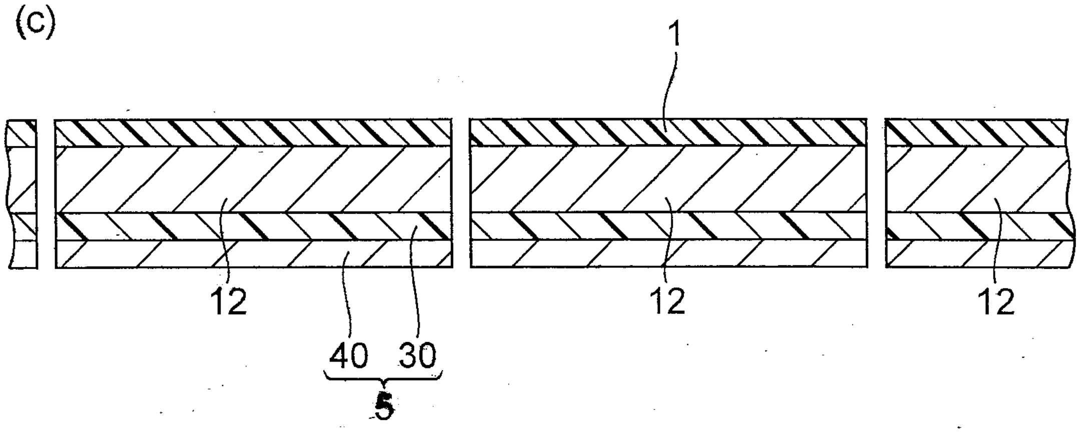

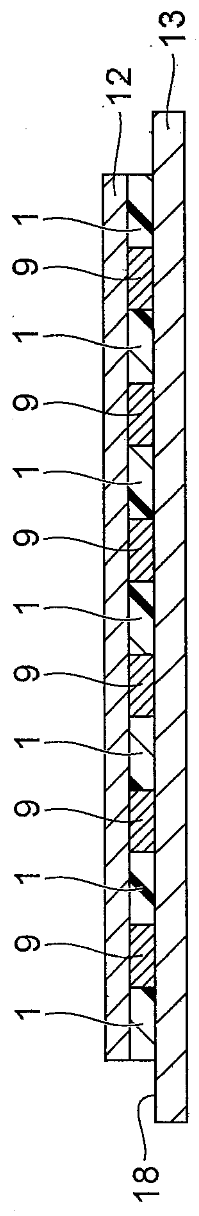


Fig.20

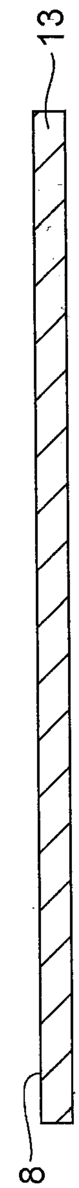


Fig.21

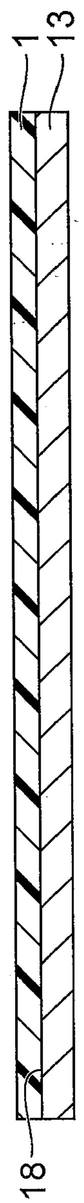


Fig.22

Fig.23

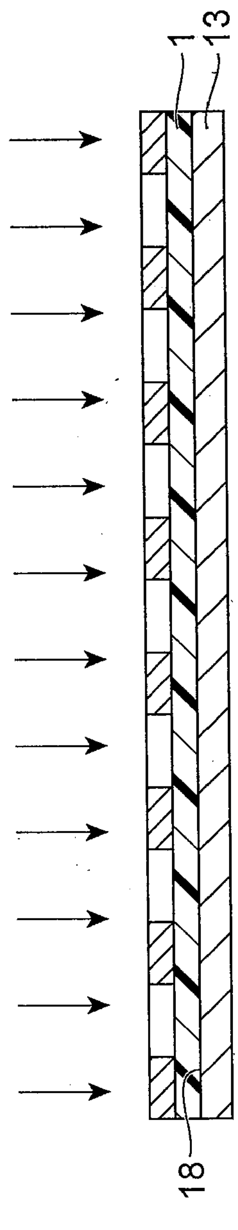

Fig.24

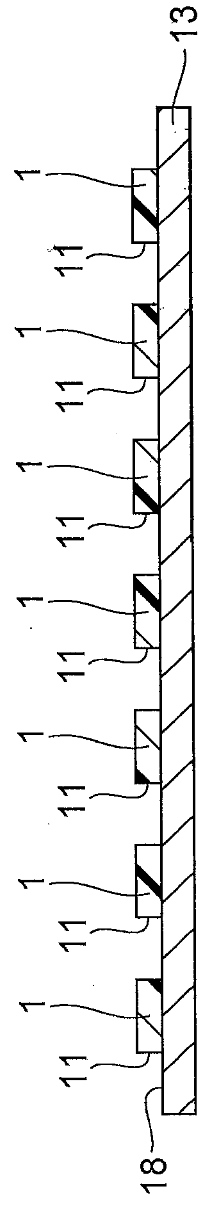

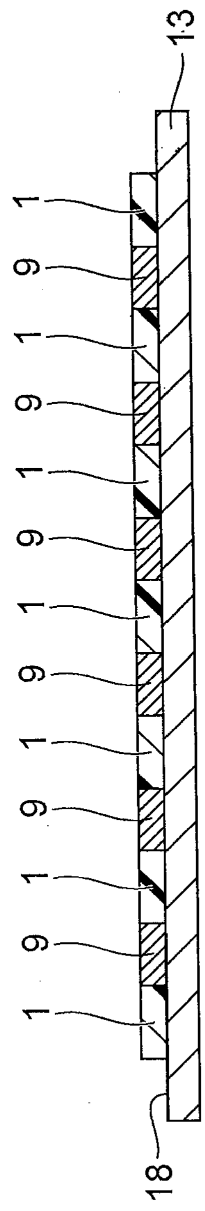


Fig.25

*Fig.26*

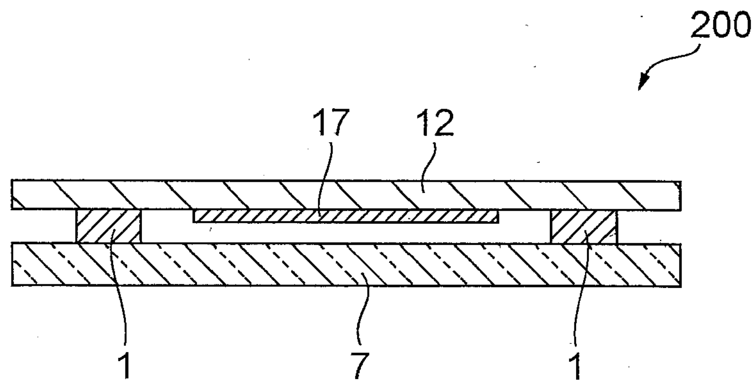

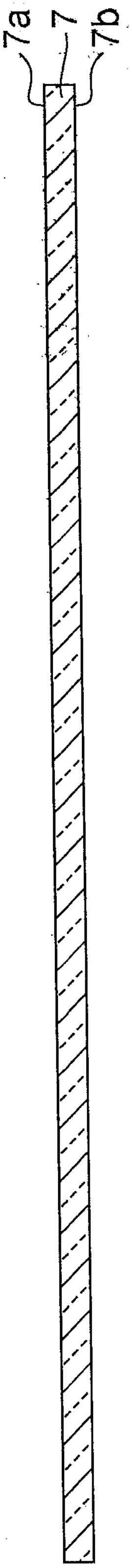


Fig.27

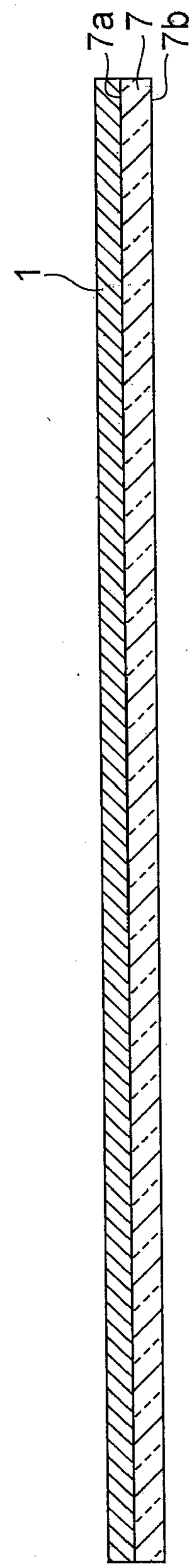


Fig.28

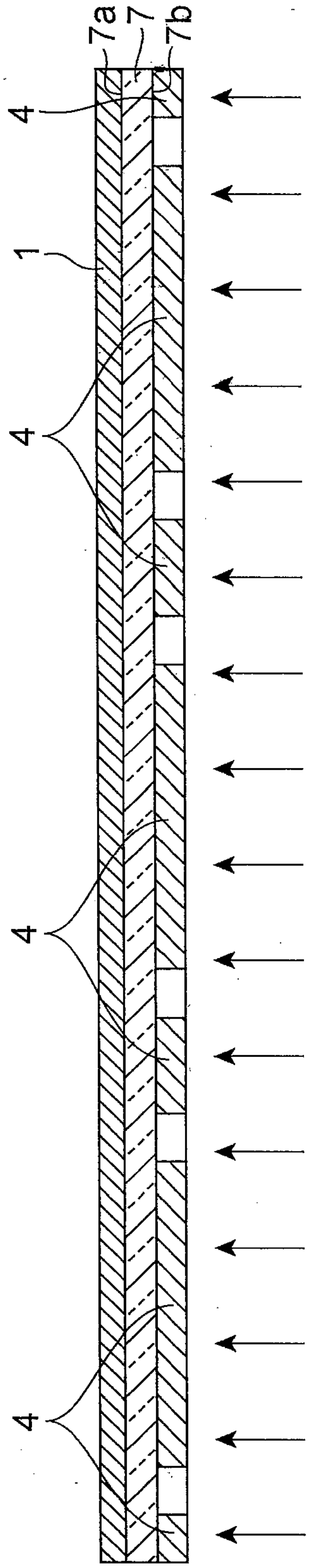


Fig.29

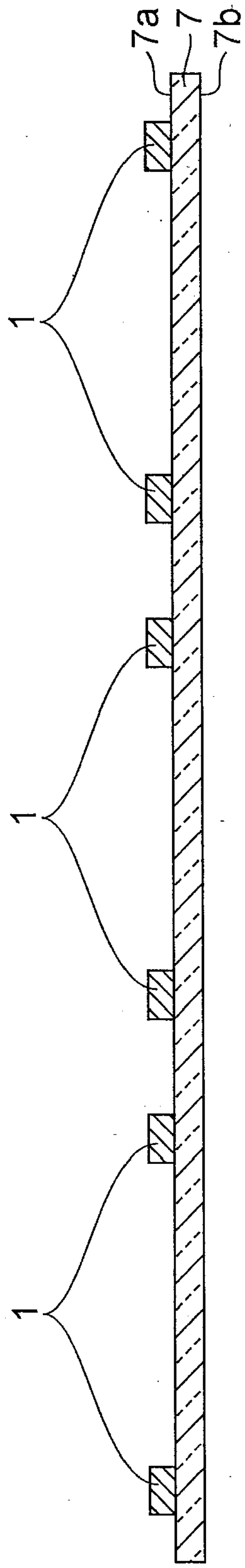


Fig.30

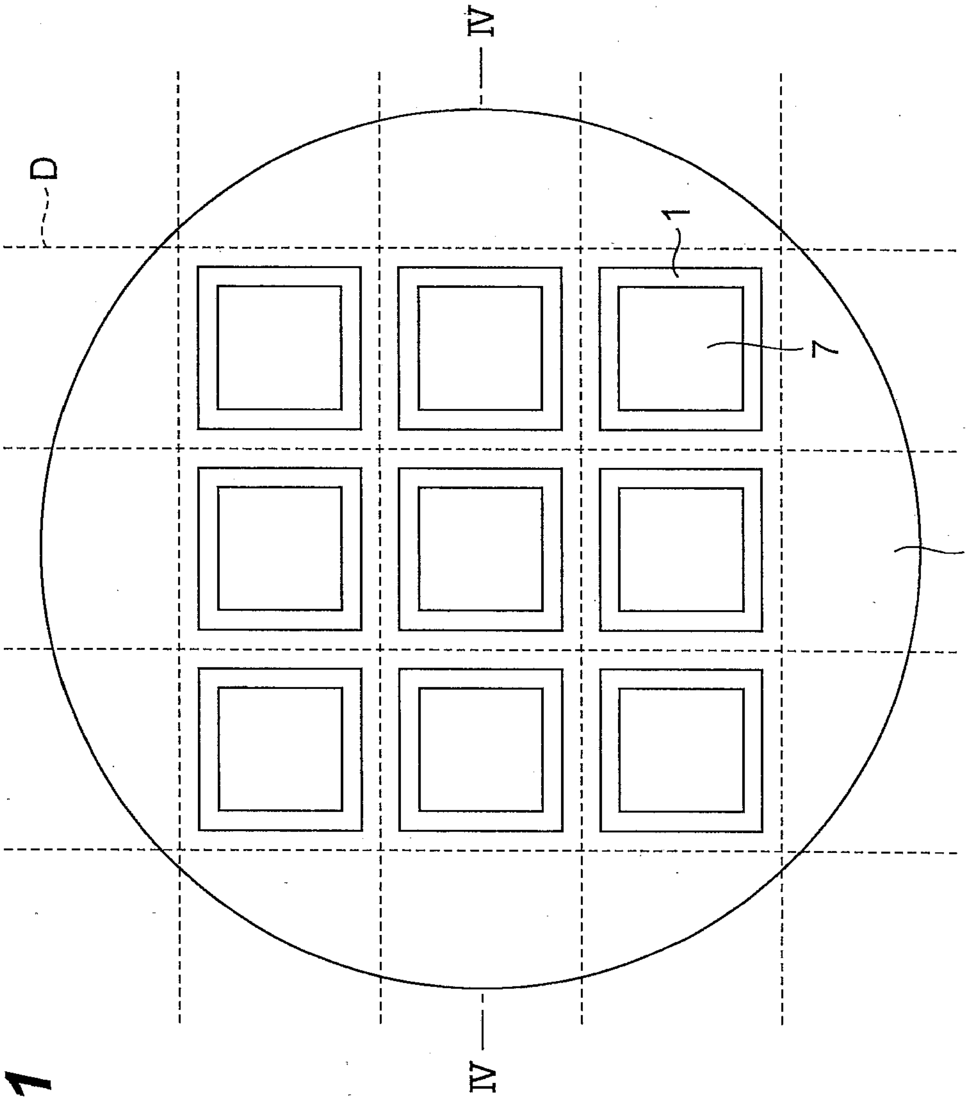


Fig.31

Fig.32

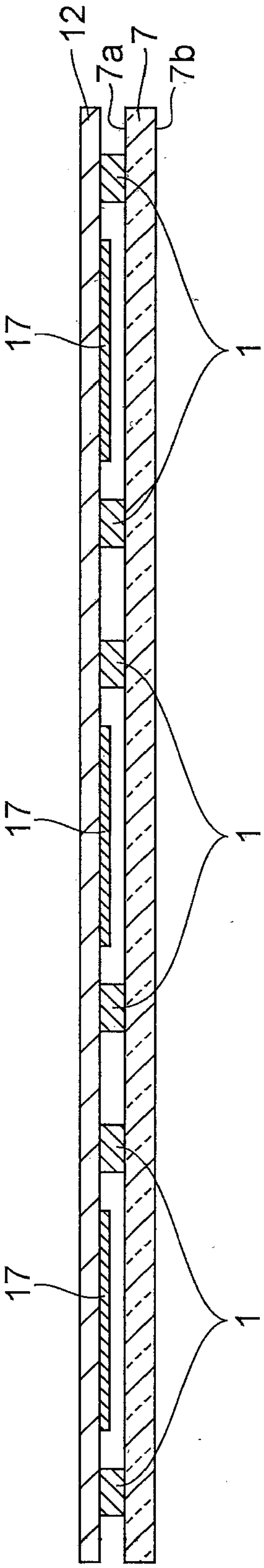

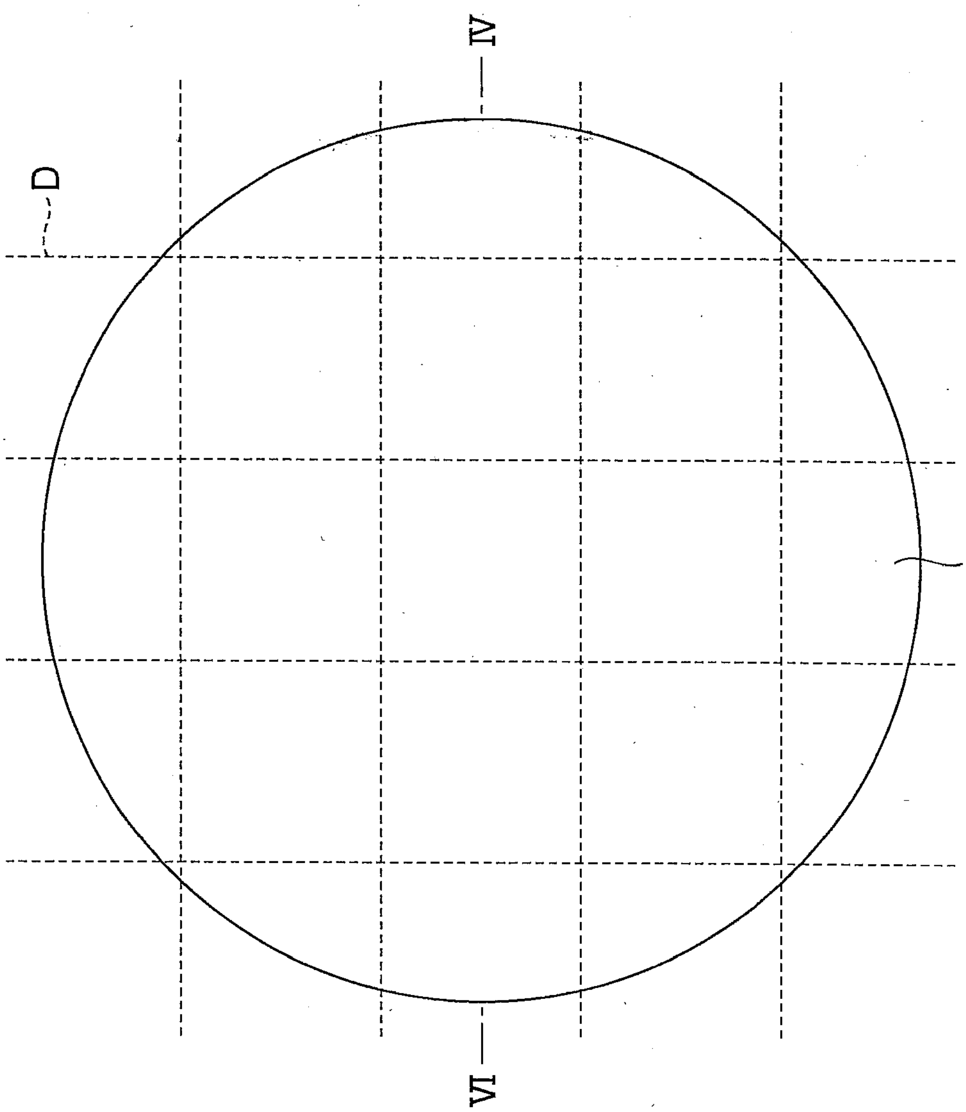


Fig.33

Fig.34

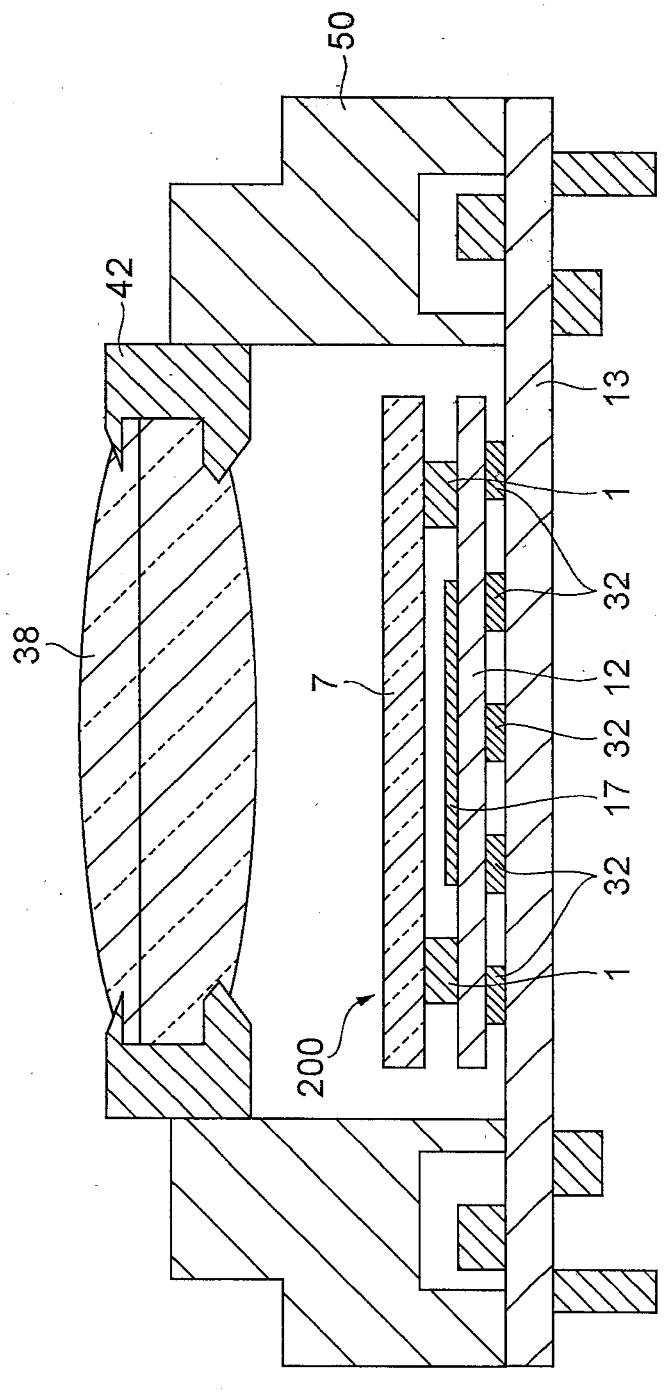

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2000290501 A
- JP 2001329233 A
- JP 11024257 A

### Non-patent literature cited in the description


- *Journal of Photopolymer Science and Technology,* 1999, vol. 12, 313-314
- *Chemistry of Materials,* 1999, vol. 11, 170-176
- *Journal of American Chemical Society,* 1996, vol. 118, 12925
- *Polymer Journal,* 1996, vol. 28, 795